# EUROPÄISCHE PATENTSCHRIFT

(11) **EP 3 152 824 B1**
(45) Veröffentlichungstag und Bekanntmachung des Hinweises auf die Patenterteilung: **03.07.2019**
(21) Anmeldenummer: 15724713.1
(22) Anmeldetag: 28.05.2015
(51) Int. Cl.: H02M 3/158, H02M 1/14, H03K 17/693

(54) **LEISTUNGSELEKTRONISCHE SCHALTUNG, LEISTUNGSELEKTRONISCHER ENERGIEÜBERTRAGER UND LEISTUNGSELEKTRONISCHES ENERGIEÜBERTRAGUNGSSYSTEM**
POWER ELECTRONIC CIRCUIT, POWER ELECTRONIC ENERGY TRANSMITTER AND POWER ELECTRONIC ENERGY TRANSMISSION SYSTEM
CIRCUIT ÉLECTRONIQUE DE PUISSANCE, TRANSMETTEUR D'ÉNERGIE ÉLECTRONIQUE DE PUISSANCE ET SYSTÈME DE TRANSMISSION D'ÉNERGIE ÉLECTRONIQUE DE PUISSANCE

(30) Priorität: 03.06.2014 DE 102014210502
(43) Veröffentlichungstag der Anmeldung: 12.04.2017
(73) Patentinhaber: Fraunhofer Gesellschaft zur Förderung der angewandten Forschung E.V., 80686 München (DE)
(72) Erfinder: ZELTNER, Stefan, 91058 Erlangen (DE)
(74) Vertreter: Zimmermann, Tankred Klaus
(86) Internationale Anmeldenummer: PCT/EP2015/061876
(87) Internationale Veröffentlichungsnummer: WO 2015/185441

(56) Entgegenhaltungen:
- EP-A2- 2 077 609
- WO-A2-2012/178056

## Beschreibung

Die Erfindung bezieht sich auf eine leistungselektronische Schaltung, auf einen leistungselektronischen Energieübertrager, beispielsweise einen Gleich- oder Wechselrichter und auf ein leistungselektronisches Energieübertragungssystem, beispielsweise einen Umrichter.

### Stand der Technik

Effiziente leistungselektronische Schaltungen basieren auf dem Prinzip getakteter Schaltelemente, da ideale Schaltelemente (d.h. unendlich schnell schaltend, ohne Leitendwiderstand, unendlicher Sperrwiderstand) theoretisch verlustfrei arbeiten können. Moderne leistungselektronische Schaltelemente wie z.B. Bipolartransistoren mit isolierter Gate-Elektrode (engl. Insulated-gate bipolar transistors - IGBTs) oder Metall-Oxid Halbleiter Feldeffekttransistoren (Metal Oxide Semiconductor Field Effekt Transistors - MOSFETs) kommen diesem Ideal sehr nahe. Frequenzumrichter, PV-Wechselrichter und andere getaktete leistungselektronische Systeme lassen sich mit Wirkungsgraden von über 99 % realisieren. Mit dem großen Wirkungsgradvorteil der getakteten Systeme ist jedoch auch der Nachteil verbunden, dass aufgrund der Taktung sowohl unerwünschte Gegentakt- als auch Gleichtaktstörungen auftreten. Diese können sowohl das System selbst als auch andere Systeme stören bzw. schädigen. Daher sind in Normen zur elektromagnetischen Verträglichkeit (EMV) maximale Störpegel gesetzlich niedergelegt, welche auch ein getaktetes leistungselektronisches System nicht überschreiten darf. Die Reduzierung von Gleich- und Gegentaktstörungen ist daher ein allgemeines Ziel im Designprozess eines leistungselektronischen Systems (LE-System).

Nach dem Stand der Technik können mindestens fünf unterschiedlichen Prinzipien zur Reduzierung von Gleich- und Gegentaktstörungen genannt werden:
1) Reduzierung von Gleich- und Gegentaktstörungen mittels zusätzlicher, externer Filter (EMV-Filter).
2) Einfügen zusätzlicher Strompfade, etwa durch integrierte Y-Kondensatoren, so dass die durch Gleich- und Gegentaktstörungen hervorgerufenen Störströme innerhalb des leistungselektronischen Systems fließen und keine Wechselwirkung mit der Umgebung hervorrufen.
3) Kompensation durch Überlagerung zusätzlicher gegenphasiger Kompensationsspannungen, etwa mittels eines so genannten "smoothing transformers".
4) Kompensation der Störungen durch Überlagerung entsprechend gegenphasiger Kompensationsströme mittels zusätzlicher Komponenten die nicht zur Leistungs-Prozessierung beitragen. Hierzu gehören aktive EMV-Filter und magnetisch gekoppelte zusätzliche Windungen. Letztere sind z.B. aus der 6,437,999 B1 zur Eliminierung von Gegentaktstörungen bekannt.
5) Realisierung einer inhärent störungsarmen Leistungselektronik, d.h. Kompensation durch entsprechende Anordnung leistungselektronischer Subsysteme, so dass das LE-Gesamtsystem nach außen störungsreduziert erscheint. Hierzu sind bspw. phasenversetzt getaktete Schaltungstopologien (Interleaving), Multi-Level-Schaltungstopologien oder "zero-ripple Cuk-Converter" bekannt.

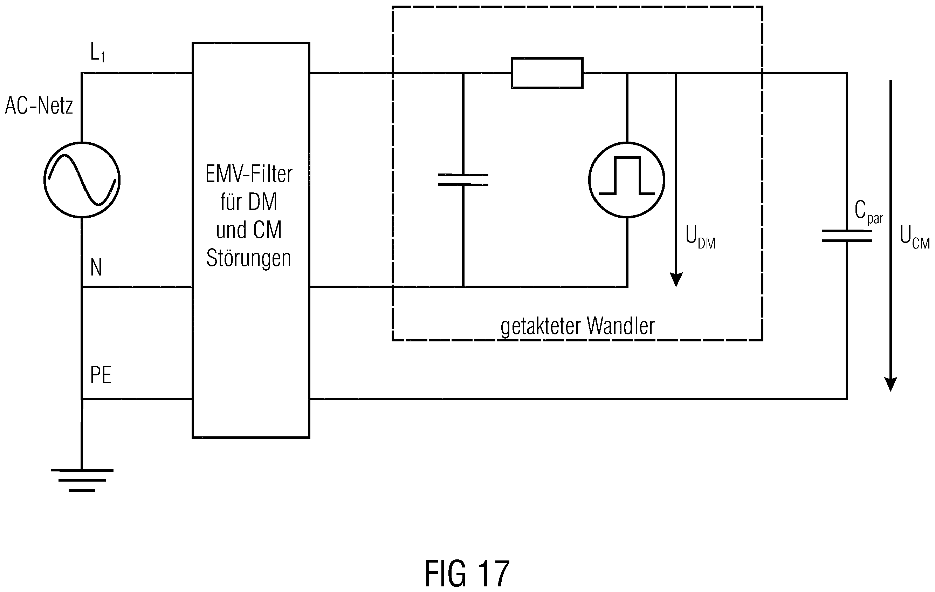

Die mit Abstand häufigste Art und Weise zur Reduzierung unerwünschter Störungen getakteter Schaltungen ist nach Stand der Technik mit Prinzip 1 gegeben. Fig. 17 zeigt Prinzip 1 schematisch und exemplarisch für eine AC-Netz-Anwendung. Während Gegentaktstörungen zwischen den Anschlussklemmen, d.h. Ein- oder Ausgangsklemmen, einer Schaltung (in Fig. 17 L1 und N) auftreten, werden Gleichtaktstörungen aufgrund, meist parasitärer, Koppelkapazitäten (z.B. Kapazität des Leistungsschalters gegenüber dem Kühlkörper) zwischen dem "springenden" Potential und einem Bezugspotential (z.B. dem Gerätegehäuse, welches oftmals geerdet ist) eingeprägt.

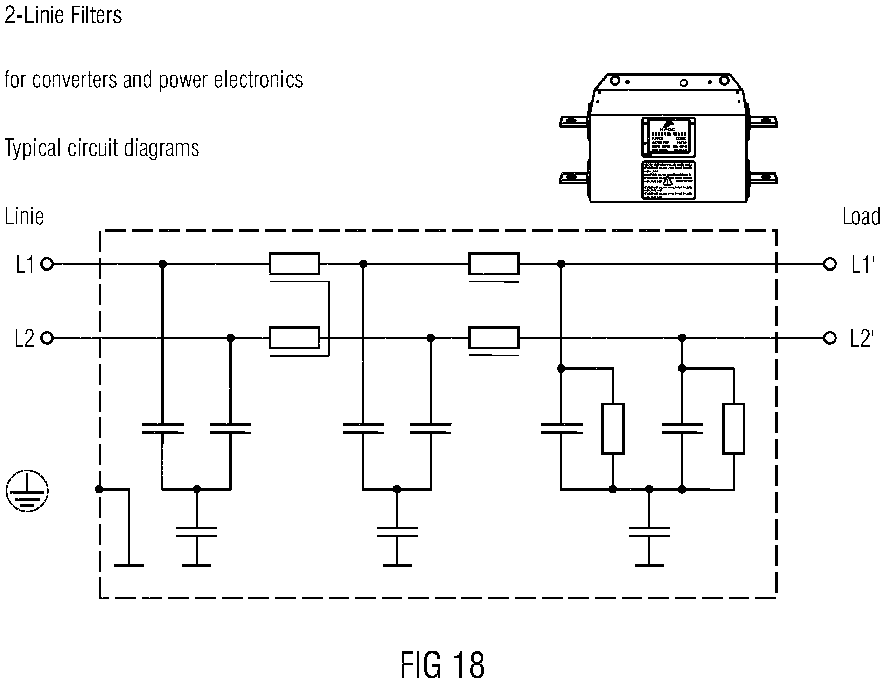

Nach dem Stand der Technik werden zusätzliche externe EMV-Filter verwendet, welche eine in Fig. 18 gezeigte typische Schaltungsstruktur aufweisen [1]. Diese sind zur Erzielung einer hohen dämpfenden Wirkung oftmals aus mehrstufigen L-C-Filter-Strukturen aufgebaut. Zur Reduzierung der Gegentaktstörungen werden sogenannte "Längsdrosseln" (z.B. magnetisch gekoppelte Spulen auf Eisenpulverkernen) und sogenannte X-Kondensatoren (d.h. Kondensatoren welche sich zwischen den Anschlussklemmen befinden) verwendet. Zur Unterdrückung der Gleichtaktstörungen werden sogenannte Y-Kondensatoren eingesetzt, welche einen niederimpedanten Pfad für den Gleichtaktstörstrom zum Gerätegehäuse bilden. Zur Erhöhung der Impedanz bezüglich des speisenden Netzes werden meist sogenannte "Gleichtaktdrosseln" (d.h. gekoppelte, stromkompensierte Spulen auf Ferritkernen) verwendet.

Der Übergang zu Prinzip 2 ist fließend. Es basiert darauf, dass mittels zusätzlicher Schaltungselemente Strompfade geschaffen werden, die verhindern, dass die unerwünschten Störströme das LE-System verlassen (z.B. integrierte Y-Kondensatoren). Prinzip 2 hängt damit im Wesentlichen von der Definition des LE-Systems ab, d.h. wo die Grenzen des eigentlichen leistungselektronischen Systems gesetzt werden und wo das externe, zusätzlich notwendige EMV-Filter beginnt.

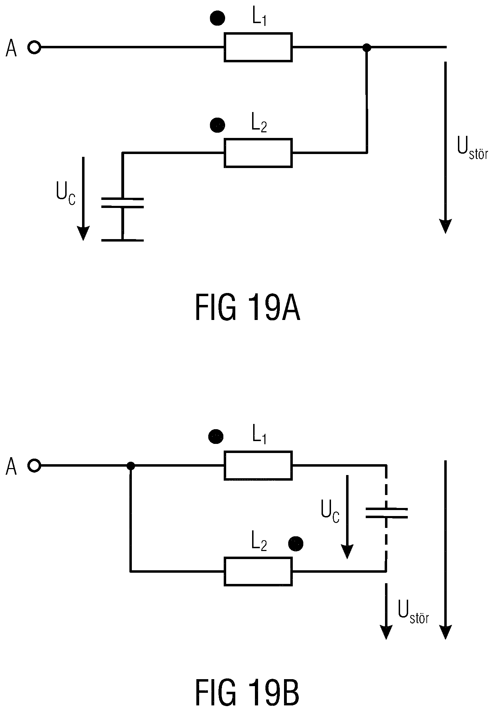

Obgleich das Prinzip 3 ("smoothing transformer") in seiner ursprünglichen Form ebenfalls einen zusätzlichen AC-Pfad benötigt, wie Fig. 19a zeigt, stellt es dennoch eine eigene Methode dar. Der Kompensationseffekt beruht hierbei auf der Überlagerung (in Fig. 19a: Serienschaltung) von Störspannung und Kompensationsspannung. Daher ist es auch möglich diese Methode einzusetzen, um den bekannten "zero-ripple Cuk-Converter", welcher zur Klasse der bidirektionalen isolierenden Wandler zählt, mittels klassischem Cuk-Converter und Ergänzung zweier "smoothing transformer" zu synthetisieren [2]. Da der "zero-ripple Cuk-Converter" jedoch keine zusätzlichen Schaltungselemente benötigt, ist er in diesem Sinn zur inhärent störungsarmen LE (Prinzip 5) zu zählen [3].

Im Gegensatz zu Prinzip 3 basiert Prinzip 4 auf einer kompensierenden Wirkung eines entsprechend gegenphasigen Kompensationsstroms, welcher durch das Einbringen zusätzlicher Schaltungselemente ermöglicht wird [4]. Fig. 19b verdeutlicht ein allgemeines und in [4] beschriebenes Prinzip. Der Unterschied zum "smoothing transformer" gemäß Fig. 19a ist deutlich zu erkennen.

Eine Analyse der Prinzipien 1 bis 4 zeigt, dass diese nicht die durch das LE-System hervorgerufenen Störursachen reduzieren sondern lediglich deren Auswirkungen und das zur Reduzierung der Auswirkungen zusätzliche Schaltungselemente benötigt werden, welche keinen Beitrag zur eigentlichen Leistungs-Prozessierung leisten.

Ein zusätzliches Schaltungselemente kann z.B. auch lediglich eine weitere Windung auf einem bereits vorhandenen magnetischen Kern sein; spezielle Ausführungen mit "smoothing transformer" können eine Ausnahme (z.B. der zero-rippie Cuk-Converter) bilden, wie es im Zusammenhang mit Prinzip 4 beschrieben wurde.

Gänzlich anders verhält es sich mit einer Reduzierung der Störungen mittels Prinzip 5. Hierbei basiert die Reduzierung nicht durch eine Hinzunahme zusätzlicher Schaltungselemente, wie z.B. Kondensatoren, Spulen, Transformatoren oder aktiver Verstärker, welche nicht zum eigentlichen leistungsverarbeitenden Prozess beitragen, sondern durch eine besondere Anordnung leistungselektronischer Subsysteme, die in ihrer Gesamtheit ein störreduziertes Verhalten nach außen aufweisen. In diesem Sinne kann von inhärent störungsarmer Leistungselektronik gesprochen werden. Anmerkung: der "zero-ripple Cuk-Converter" kann auch bezüglich der Definition von Prinzip 5 betrachtet werden, indem man dessen Primärseite bzw. Sekundärseite als Subsysteme auffasst.

### Stand der Technik inhärent störungsarmer LE

Nach dem Stand der Technik sind mindestens folgende fünf Prinzipien zur Erzielung inhärent störungsarmer leistungselektronischer Systeme bekannt:
a) Auslegung der Schaltungselemente, d.h. Erhöhung der Induktivitäts- und Kapazitätswerte zur Reduzierung von Gegentaktstörungen und Verringerung der parasitären Koppelkapazitätswerte zur Reduzierung der Gleichtaktstörungen (siehe auch Fig. 17 mit z.B. L gegen unendlich und Cₚₐᵣ gegen null).
b) Verwendung von Schaltungstopologien mit reduzierter Flankensteilheit. Die auftretenden Störpegel, insbesondere die Gleichtaktstörpegel, einer getakteten Schaltung hängen stark von der verwendeten Schaltungstopologie ab. Der Grund hierfür liegt darin, dass sogenannte hartschaltende Topologien zur Erzielung eines hohen Wirkungsgrades meist steilere Schaltflanken erzeugen als sogenannte weichschaltende Topologien und die Steilheit der Schaltflanken unmittelbaren Einfluss auf den sich einstellenden Gleichtaktstörstrom hat. Beispiele hierfür sind weichschaltende Schaltungstopologien wie z.B. resonant arbeitende Wandler, da diese durch Null-Spannungsschalten bzw. durch Null-Stromschalten reduzierte Schaltflankensteilheiten bei gleichzeitig hohen Wirkungsgraden ermöglichen.
c) Anwendung von Multileveltopologien. Hierdurch verringert sich entsprechend der Stufenanzahl die Störamplitude der die Gegen- und Gleichtaktstörungen hervorrufenden Störspannungsquellen. Allerdings tritt diese entsprechend der Stufenanzahl häufiger auf.
d) Spezielle Ausführungen mit "smoothing transformer", welche ohne zusätzliche Windung (Schaltungselemente) auskommen und lediglich weitere magnetische Kopplungen benötigen, wie etwa der "zero-ripple Cuk-Converter".
e) Anwendung von versetzt getakteten leistungselektronischen Sub-Systemen (Interleaving) zur Reduzierung der Gegentaktstörungen in einem Arbeitspunkt.

### Nachteile zum Stand der Technik inhärent störungsarmer LE

Die nach dem Stand der Technik bekannten Prinzipien a) bis e) haben folgende Nachteile:
Dem Prinzip (a) sind mit dem zur Verfügung stehenden Bauraum als auch mit dem zu erzielenden Wirkungsgrad Grenzen gesetzt. Zudem geht der Trend genau in die entgegengesetzte Richtung, d.h. mit immer höheren Schaltfrequenzen werden die passiven Schaltungselemente immer weiter verkleinert umso immer höhere Leistungsdichten zu erzielen. Bezüglich der Gegentaktstörungen bewirkt dies keinen Nachteil. Höhere Schaltfrequenzen erfordern jedoch auch steilere Schaltflanken, was zu einer Erhöhung der Gleichtaktstörungen führt (bei ansonsten gleichen Bedingungen: z.B. parasitärer Koppelkapazität zum Kühlkörper).

Das Prinzip (b) widerspricht dem Gedanken des idealen Schalters, d.h. es reduziert bei hartschaltenden Schaltungstopologien sehr stark den Wirkungsgrad. Bei weichschaltenden Schaltungstopologien ist der Wirkungsgradnachteil nicht vorhanden bzw. geringer. Weichschaltende Schaltungstopologien welche sowohl keine Ein- als auch Ausschaltverluste zeigen sind jedoch meist stark in ihrem Betriebsbereich eingeschränkt. Zudem erfordern auch weichschaltende Schaltungstopologien mit zunehmender Schaltfrequenz höhere Flankensteilheiten.

Das Prinzip (c) ist mit einem deutlich erhöhten Aufwand verbunden, da eine deutliche Reduzierung der Störungen erst bei vielen Stufen auftritt. Dieses Prinzip wird nach dem Stand der Technik erst bei sehr hohen Leistungen (MW) zur Störungsreduzierung angewendet.

Das Prinzip (d) in Form des "zero-ripple Cuk-Converter" beseitigt lediglich Gegentaktstörungen.

Das Prinzip (e) reduziert lediglich die Gegentaktstörungen in einem einzigen Arbeitspunkt.

Das Prinzip (e) ist von dem in Fig. 19b und US 6,437,999 B1 beschriebenen Konzept verschieden. Das in US 6,437,999 B1 beschriebene allgemeine Verfahren (siehe auch Fig. 19b) ermöglicht eine Kompensation der Stromwelligkeiten an allen Anschlussklemmen in allen Betriebspunkten, d.h. bei beliebigen Tastverhältnissen. Allerdings werden hierzu zusätzliche Schaltungselemente (Transformatoren und Kondensatoren) benötigt die keinen Beitrag zur Leistungs-Prozessierung leisten und nur zur Bereitstellung der entsprechenden Kompensationsströme benötigt werden.

Zusammenfassend kann zum Stand der Technik festgehalten werden, dass keine getaktete leistungselektronische Schaltung bekannt ist, welche für beliebige Arbeitspunkte sowohl eine theoretische Eliminierung der Gegentaktstörungen und gleichzeitig auch der Gleichtaktstörungen sowohl für die Eingangs- als auch die Ausgangsklemmen ermöglicht.

Die Aufgabe der vorliegenden Erfindung besteht darin, eine leistungselektronische Schaltung, einen leistungselektronischen Energieübertrager und ein leistungselektronisches Energieübertragungssystem zu schaffen, die, der bzw. das eine Reduzierung von Gegentaktstörungen und/oder Gleichtaktstörungen in verschiedenen Arbeitspunkten ermöglicht.

Diese Aufgabe wird durch den Gegenstand der unabhängigen Patentansprüche gelöst.

Eine Erkenntnis der vorliegenden Erfindung liegt darin, dass Gleichtaktstörungen und Gegentaktstörungen in einer leistungselektronischen Schaltung, bestehend aus einem elektrischen ersten Tor und einem magnetischen zweiten Tor, am elektrischen ersten Tor dadurch reduziert werden können, dass die leistungselektronische Schaltung bezüglich des ersten Tores und des zweiten Tores funktionell symmetrisch (funktionssymmetrisch) aufgebaut ist. Die leistungselektronische Schaltung umfasst eine Mehrzahl von Schaltern, die zu zwei Parallelästen in Serienschaltungen zusammengeschaltet sind. Die Paralleläste sind mittels Spulen an Knoten miteinander verschaltet, wobei das erste Tor und das zweite Tor der leistungselektronischen Schaltung symmetrisch zu den Spulen und zu den Schaltern angeordnet ist.

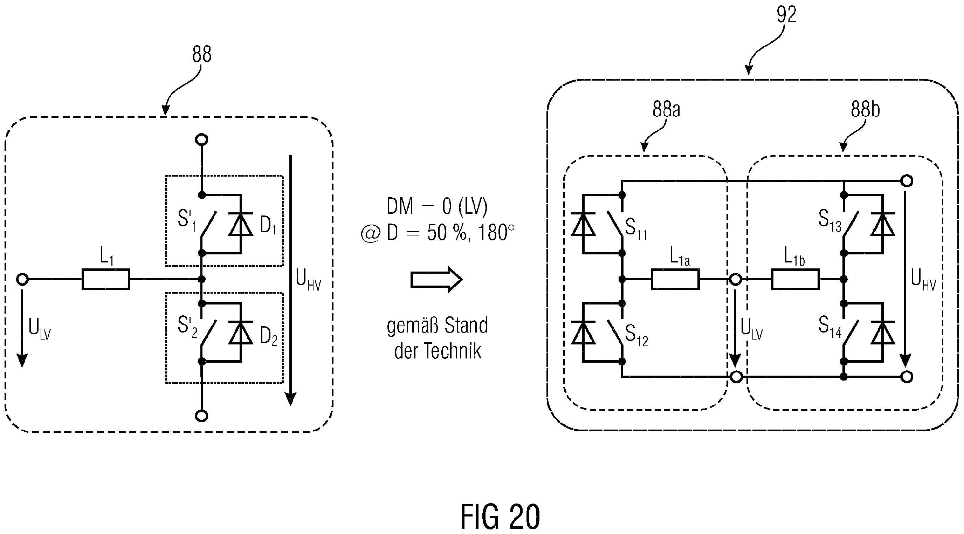

Fig. 20 zeigt eine Erweiterung einer Wechselschalter-Schaltzelle gemäß dem Stand der Technik mit Spulen L₁ₐ und L_{1b} für eine 2-phasige, um 180° versetzt getaktete Ansteuerung eines Hoch/Tiefsetzstellers. Die in der rechten Hälfte der Fig. 20 gezeigte Aufdoppelung einer links dargestellten Halbbrücke 88 hin zu zwei Halbbrücken 88a und 88b, die eine Vollbrücke 92 bilden, ermöglicht eine Eliminierung von Gegentaktstörungen (engl.: Differential Mode - DM) bezüglich der Spannung *U_{LV}* in einem Arbeitspunkt bei einer um 180° und 50% Tastgrad phasenversetzten Ansteuerung der Halbbrücken 88a und 88b.

Die Halbbrücke 88 umfassend die Spule L₁ und die Schalter S'₁ und S'₂ sowie die Dioden D₁ parallel zum Schalter S'₁ und D₂, parallel zum Schalter S'₂, bilden eine Basis fast aller leistungselektronischer Systeme im höheren Leistungsbereich, ab ca. 1 kW. Zwei dieser Schaltzellen mit zwei Spulen und 180° versetzter Taktung bilden die beschriebene Anordnung eines 2-phasigen versetzt getakteten Hoch/Tiefsetzstellers mit den bekannten Nachteilen.

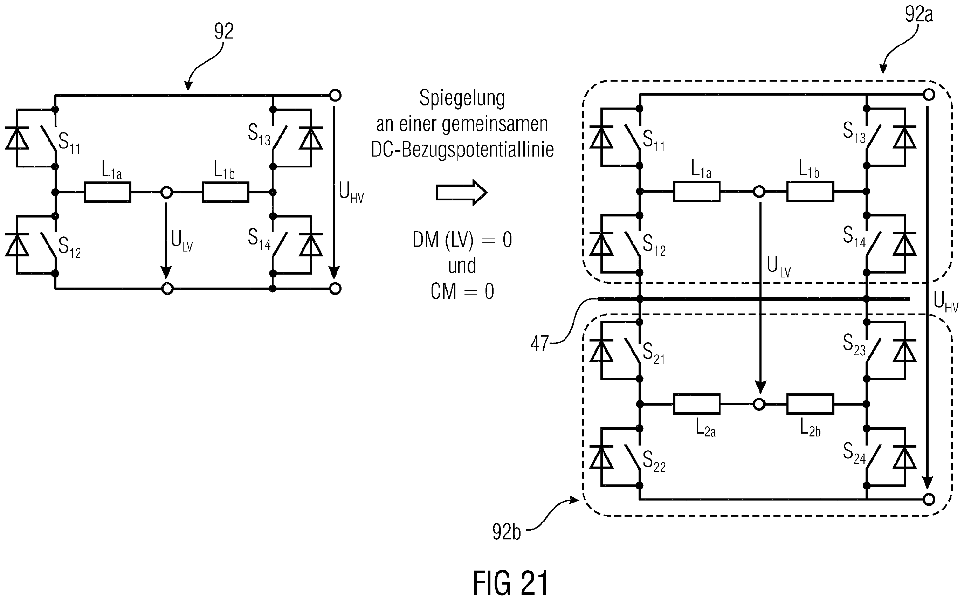

Fig. 21 zeigt eine Spiegelung der Vollbrücke 92 aus Fig. 20 an einer gemeinsamen DC-Bezugspotentiallinie, etwa der Bezugsverbindung 47. Dies ermöglicht, für einen Arbeitspunkt, eine Eliminierung von Gegentakt- und Gleichtaktstörungen. In anderen Worten wird, zur Beseitigung des Nachteils der Fig. 20, dass lediglich Gegentaktstörungen hierdurch reduziert werden können, eine Erweiterung der Spiegelung der Schaltungstopologie an einer gemeinsamen DC-Bezugspotentiallinie ermöglicht. Somit können theoretisch nicht nur Gegentaktstörungen an Klemmen LV bezüglich einer daran anlegbaren Spannung U_{LV}, sondern auch Gleichtaktstörungen bezüglich der Klemmen LV in einem Arbeitspunkt komplett eliminiert werden.

Die Schaltung kann in diesem Zustand jedoch lediglich als Hoch- oder Tiefsetzsteller mit einem Spannungsübersetzungsverhältnis von 2 (bzw. 1/2) entsprechend dem zur Eliminierung der Gegentaktstörung notwendigen Tastgrades von 50% bezüglich ihrer Spannungen *U_{LV}* und *U_{HV}* zwischen zwei parallel verschalteten Parallelästen mit Schaltern S₁₁, S₁₂, S₂₁ und S₂₂ bzw. S₁₃, S₁₄, S₂₃ und S₂₄ verwendet werden. Zudem erfolgt eine Eliminierung der Gegentaktstörungen nur bezüglich der Spannung *U_{LV}*.

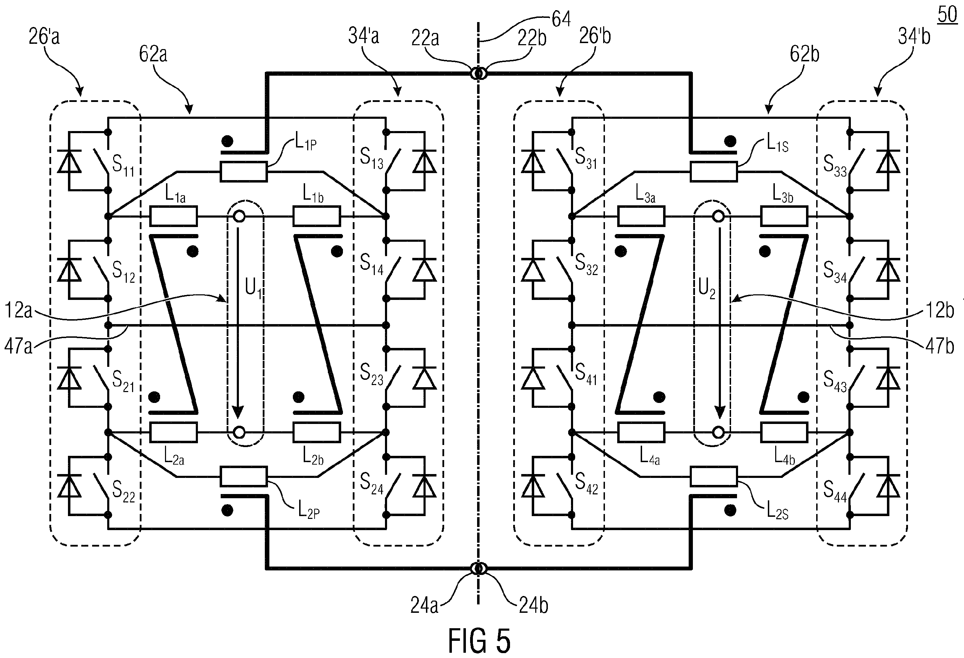

Dieser Nachteil wird durch einen erfindungsgemäßen leistungselektronischen Energieübertrager behoben, welche einen Steuerungsmechanismus erlaubt, welcher weder vom Tastgrad der einzelnen Halbbrücken noch von deren Phasenbeziehung abhängt. Hierzu erfolgt bspw. eine erfindungsgemäße Anordnung/Verschaltung von zwei primärseitigen Wicklungen zweier Transformatoren und eine Spiegelung der Topologie an der Isolationsbarriere der beiden eingeführten Transformatoren, wie Fig. 5 verdeutlicht.

Ein leistungselektronischer Energieübertrager wird durch eine Verschaltung zweier solcher leistungselektronischer Schaltungen geschaffen, so dass der leistungselektronische Energieübertrager eine Primärseite und eine Sekundärseite aufweist und Gleichtaktstörungen und/oder Gegentaktstörungen an einem primärseitigen Anschlusstor und einem sekundärseitigen Anschlusstor reduziert sind.

Ein leistungselektronisches Energieübertragungssystem wird durch eine Verkopplung einer oder mehrerer Primärseiten mit einer oder mehreren Sekundärseiten ermöglicht.

Der symmetrische Aufbau ermöglicht eine Reduzierung von Gleichtakt- und Gegentaktstörungen bis hin zu einer völligen Eliminierung.

Ausführungsbeispiele der vorliegenden Erfindung schaffen eine leistungselektronische Schaltung mit einem ersten elektrischen Tor, mit einem ersten und einem zweiten Anschluss und einem zweiten magnetischen Tor mit einem ersten und einem zweiten Anschluss. Die leistungselektronische Schaltung weist ferner einen ersten Parallelast mit einer ersten Serienschaltung und einen zweiten Parallelast mit einer zweiten Serienschaltung auf. Jede Serienschaltung weist zumindest einen ersten Schalter, einen zweiten Schalter und einen dritten Schalter auf, wobei die beiden Paralleläste parallel miteinander verschaltet sind. Der erste Anschluss des ersten Tores ist jeweils über eine Spule mit einem ersten Knoten zwischen dem ersten und dem zweiten Schalter in dem ersten und dem zweiten Parallelast verbunden. Der zweite Anschluss des ersten Tores ist jeweils über eine Spule mit einem zweiten Knoten zwischen dem zweiten und dem dritten Schalter in dem ersten und dem zweiten Parallelast verbunden. Die ersten Knoten sind mit dem ersten Anschluss des zweiten Tores magnetisch gekoppelt. Die zweiten Knoten sind mit dem zweiten Anschluss des zweiten Tores magnetisch gekoppelt. Die Kopplung erfolgt mittels Spulen welche mit den ersten und zweiten Knoten verschaltet sind und somit ein entsprechendes Magnetfeld erzeugen, welches durch einen geeigneten magnetischen Leiter (z.B. Spulenkern) zum ersten und zweiten Anschluss des magnetischen zweiten Tores geleitet wird.

Vorteilhaft an diesen Ausführungsbeispielen ist, dass die beschriebene leistungselektronische Schaltung als Basiszelle verwendet werden kann, die in der Anordnung eines leistungselektronischen Energieübertragers bzw. eines leistungselektronischen Energieübertragungssystems Gegentakt- und Gleichtaktstörungen für beliebige Arbeitspunkte, etwa bezüglich ihrer ersten (elektrischen) Tore reduziert. Arbeitspunkte sind bspw. unterschiedliche Spannungswerte bzw. Ströme an den ersten (elektrischen) Toren.

Die leistungselektronische Schaltung ist dabei eine inhärent störungsarme leistungselektronische Schaltung, das bedeutet, dass die leistungselektronische Schaltung so ausführbar ist, dass jedes der Bauelemente an einer Leistungsübertragung, beispielsweise von dem ersten (elektrischen) Tor zu dem zweiten (magnetischen) Tor, beteiligt ist.

Ein weiteres Ausführungsbeispiel der vorliegenden Erfindung schafft eine leistungselektronische Schaltung, bei der parallel zu den Parallelästen ein Kondensator verschaltet ist. Vorteilhaft an diesem Ausführungsbeispiel ist, dass der Kondensator als Überspannungs- oder Unterspannungspuffer bezüglich der Schalter der Paralleläste wirksam ist und so Gegentakt- und Gleichtaktstörungen weiter reduziert werden können.

Ein weiteres Ausführungsbeispiel der vorliegenden Erfindung schafft eine leistungselektronische Schaltung, bei der die Spulen zwischen dem ersten Anschluss des ersten Tores und dem ersten Parallelast und zwischen dem zweiten Anschluss des ersten Tores und dem ersten Parallelast einen gemeinsamen Spulenkern aufweisen und bei der die Spule zwischen dem ersten Anschluss des ersten Tores und dem zweiten Parallelast und zwischen dem zweiten Anschluss des ersten Tores und dem zweiten Parallelast einen gemeinsamen Spulenkern aufweisen. Vorteilhaft an diesem Ausführungsbeispiel ist, dass zwei Spulen, die einen gemeinsamen Spulenkern aufweisen, platzsparend mit geringem Bauraumbedarf und kostengünstig realisiert werden können.

Ein weiteres Ausführungsbeispiel der vorliegenden Erfindung schafft eine leistungselektronische Schaltung, bei der die erste Serienschaltung des ersten Parallelastes und die zweite Serienschaltung des zweiten Parallelastes jeweils einen weiteren Schalter zwischen dem ersten Knoten und dem zweiten Schalter und jeweils einen weiteren Knoten zwischen dem jeweiligen weiteren Schalter und dem jeweiligen zweiten Schalter aufweisen und bei der die beiden weiteren Knoten miteinander verschaltet sind.

Vorteilhaft an diesem Ausführungsbeispiel ist, dass durch die Verschaltung der beiden weiteren Knoten ein Bezugspotential für jeweils zwei Abschnitte der ersten bzw. zweiten Serienschaltung der Paralleläste nutzbar ist und ein Abschnitt des ersten Parallelastes und ein Abschnitt des zweiten Parallelastes jeweils als Brückenschaltung betrieben werden kann.

Ein weiteres Ausführungsbeispiel der vorliegenden Erfindung schafft einen leistungselektronischen Energieübertrager mit einer ersten (bspw. primärseitigen) leistungselektronischen Schaltung und einer zweiten (bspw. sekundärseitigen) leistungselektronischen Schaltung, bei dem die beiden ersten Anschlüsse des jeweiligen zweiten Tores und die beiden zweiten Anschlüsse des jeweiligen zweiten Tores magnetisch miteinander verschaltet, d.h. die entsprechenden die Magnetfelder erzeugenden Spulen miteinander verkoppelt sind.

Vorteilhaft an diesem Ausführungsbeispiel ist, dass eine Energieübertragung von dem ersten Tor der ersten leistungselektronischen Schaltung zu dem ersten Tor der zweiten leistungselektronischen Schaltung oder von dem ersten Tor der zweiten leistungselektronischen Schaltung zu dem ersten Tor der ersten leistungselektronischen Schaltung ermöglicht ist, wobei sowohl die Gleichtaktstörungen als auch die Gegentaktstörungen der Energieübertragung an den beiden ersten Toren verringert sind.

Ein weiteres Ausführungsbeispiel der vorliegenden Erfindung schafft einen leistungselektronischen Energieübertrager mit zumindest einer dritten leistungselektronischen Schaltung. Die erste leistungselektronische Schaltung weist zumindest ein weiteres (magnetisches) Tor mit einem ersten und einem zweiten Anschluss auf. Die ersten Knoten der Paralleläste der ersten leistungselektronischen Schaltung sind magnetisch mit dem ersten Anschluss des weiteren Tores gekoppelt. Die zweiten Knoten der Paralleläste der ersten leistungselektronischen Schaltung sind magnetisch mit dem zweiten Anschluss des weiteren Tores gekoppelt. Die Anschlüsse des weiteren (magnetischen) Tores sind mit dem zweiten (magnetischen) Tor der dritten leistungselektronischen Schaltung magnetisch verschaltet, d. h. gekoppelt.

Vorteilhaft an diesem Ausführungsbeispiel ist, dass eine Energieübertragung von dem ersten Tor der ersten leistungselektronischen Schaltung zu den beiden oder mehreren ersten Toren der zumindest zweiten und dritten leistungselektronischen Schaltungen und/oder von den beiden oder mehreren ersten Toren der zumindest zweiten und dritten leistungselektronischen Schaltungen zu dem ersten Tor der ersten leistungselektronischen Schaltung ermöglicht wird.

Ein weiteres Ausführungsbeispiel der vorliegenden Erfindung schafft ein leistungselektronisches Energieübertragungssystem mit zumindest zwei leistungselektronischen Energieübertragern, bei dem die zweiten Anschlüsse des ersten Tores der zumindest zwei ersten leistungselektronischen Schaltungen miteinander verschaltet sind und bei dem die zweiten Anschlüsse des ersten Tores der zumindest zwei zweiten leistungselektronischen Schaltungen miteinander verschaltet sind. Die zweiten Anschlüsse des ersten Tores der zumindest zwei zweiten leistungselektronischen Schaltungen sind mit einander verschaltet.

Vorteilhaft an diesem Ausführungsbeispiel ist, dass durch eine Verschaltung von leistungselektronischen Energieübertragern zu einem leistungselektronischen Energieübertragungssystem ein sogenannter Multiport DC/DC-Wandler (d.h. ein leistungselektronischer Wandler mit mehreren Ein- und oder Ausgängen "Ports") mit galvanischer Trennung realisierbar ist.

Weitere vorteilhafte Ausführungsbeispiele sind der Gegenstand der abhängigen Ansprüche.

Bevorzugte Ausführungsbeispiele der vorliegenden Erfindung werden nachfolgend Bezug nehmend auf die beiliegenden Zeichnungen erläutert. Es zeigen:
- Fig. 1: ein schematisches Schaltbild einer leistungselektronischen Schaltung, gemäß einem Ausführungsbeispiel der vorliegenden Erfindung;
- Fig. 2: ein schematisches Schaltbild einer leistungselektronischen Schaltung, die einen Kondensator aufweist, der zwischen eine Spule und einen ersten Knoten eines ersten Parallelastes verschaltet ist, gemäß einem Ausführungsbeispiel der vorliegenden Erfindung;
- Fig. 3: ein schematisches Schaltbild einer leistungselektronischen Schaltung, bei der zwischen dem ersten Anschluss und dem zweiten Anschluss des ersten (elektrischen) Tores eine Gleich- bzw. Wechseirichterschaltung verschalten ist und mittels der Gleich- bzw. Wechselrichterschaltung über das erste (elektrische) Tor Energie in eine Wechselspannungsquelle, die mit der leistungselektronischen Schaltung verschalten ist, eingespeist werden kann, bzw. Energie aus einer Wechselspannungsquelle entnommen werden kann, gemäß einem Ausführungsbeispiel der vorliegenden Erfindung;
- Fig. 4: ein schematisches Schaltbild einer leistungselektronischen Schaltung, die zwei weitere Kondensatoren aufweist, gemäß einem Ausführungsbeispiel der vorliegenden Erfindung;
- Fig. 5: ein schematisches Schaltbild eines leistungselektronischen Energieübertragers mit einer primärseitigen leistungselektronischen Schaltung und einer sekundärseitigen leistungselektronischen Schaltung, gemäß einem Ausführungsbeispiel der vorliegenden Erfindung;
- Fig. 6: ein schematisches Schaltbild eines leistungselektronischen Energieübertragers, bei dem die Primärseite und die Sekundärseite durch Verschalten der zweiten Anschlüsse der ersten (elektrischen) Tore, ein gemeinsames Bezugspotential aufweisen, gemäß einem Ausführungsbeispiel der vorliegenden Erfindung;
- Fig. 7: ein schematisches Schaltbild eines leistungselektronischen Energieübertragers, der drei sekundärseitige leistungselektronische Schaltungen aufweist, gemäß einem Ausführungsbeispiel der vorliegenden Erfindung;
- Fig. 8: ein schematisches Schaltbild eines leistungselektronischen Energieübertragers, der als Frequenzumrichter betrieben werden kann, gemäß einem Ausführungsbeispiel der vorliegenden Erfindung;
- Fig. 9: ein schematisches Schaltbild eines leistungselektronischen Energieübertragers, bei dem die Primärseite und die Sekundärseite aus von einander verschiedenen leistungselektronischen Schaltungen gebildet sind, gemäß einem Ausführungsbeispiel der vorliegenden Erfindung;
- Fig. 10: ein schematisches Schaltbild eines leistungselektronischen Energieübertragungssystems, das drei leistungselektronische Energieübertrager mit primärseitigen lestungselektronischen Schaltungen und sekundärseitigen leistungselektronischen Schaltungen aufweist, gemäß einem Ausführungsbeispiel der vorliegenden Erfindung;
- Fig. 11: ein schematisches Schaltbild eines leistungselektronischen Energieübertragers umfassend leistungselektronische Schaltungen welche Serienschaltungen eines Kondensators mit der die zweiten Tore magnetisch speisenden Spulen beinhalten, gemäß einem Ausführungsbeispiel der vorliegenden Erfindung;
- Fig. 12: ein schematisches Schaltbild eines leistungselektronischen Energieübertragers mit einer leistungselektronischen Schaltung auf der Primärseite und einer leistungselektronischen Schaltung auf der Sekundärseite, bei der eine Speisung der magnetischen zweiten Tore über Spulen an den elektrischen ersten Toren erfolgt, gemäß einem Ausführungsbeispiel der vorliegenden Erfindung;
- Fig. 13: ein schematisches Schaltbild eines leistungselektronischen Energieübertragers mit einer primärseitigen leistungselektronischen Schaltung und einer sekundärseitigen leistungselektronischen Schaltung, die als 1-Kern-Lösung realisiert ist, gemäß einem Ausführungsbeispiel der vorliegenden Erfindung;
- Fig. 14: ein beispielhaftes Diagramm eines Ansteuerverhaltens einer leistungselektronischen Schaltung oder eines leistungselektronischen Energieübertragers, gemäß einem Ausführungsbeispiel der vorliegenden Erfindung;
- Fig. 15: ein schematisches Ergebnis einer exemplarischen Schaltungssimulation;
- Fig. 16: ein schematische Schaltbild der leistungselektronischen Energieübertragerschaltung, wie sie nutzbar ist, um die in der Fig. 15 dargestellten Simulationsergebnisse zu erhalten, gemäß einem Ausführungsbeispiel der vorliegenden Erfindung;
- Fig. 17: ein schematisches Blockschaltbild einer Schaltung zur Reduzierung von Gleichund Gegentaktstörungen mittels zusätzlicher, externer EMV-Filter, gemäß dem Stand der Technik;
- Fig. 18: ein schematisches Schaltbild eines externen EMV-Filters nach dem Stand der Technik;
- Fig. 19a: das Wirkprinzip des "smoothing transformers", gemäß dem Stand der Technik;
- Fig. 19b: ein allgemeines Verfahren zur Kompensation der Stromwelligkeit an einem Anschluss einer getakteten Schaltung mit drei Klemmen, gemäß dem Stand der Technik;
- Fig. 20: eine Erweiterung einer Wechselschalter-Schaltzelle gemäß dem Stand der Technik mit Spulen hin zu einer Vollbrücke; und
- Fig. 21: eine Spiegelung der Vollbrücke aus Fig. 20 an einer gemeinsamen DC-Bezugspotentiallinie.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Schaltungstopologien von Ausführungsbeispielen werden nachfolgend unter Anderem mit dem Begriff "verschaltet" beschrieben, der eine Verschaltung zweier Schaltungsteile, Komponenten oder Elemente einer elektrischen Schaltung bezeichnet. Der Begriff "verschaltet" ist dabei in diesem Zusammenhang so zu verstehen, dass die beschriebenen Schaltungsteile, Komponenten oder Elemente auch bei einer Hinzufügung eines weiteren Schaltungsteils, einer weiteren Komponente oder eines weiteren Elements zwischen die Schaltungsteile, Komponenten oder Elemente verschaltet sind.

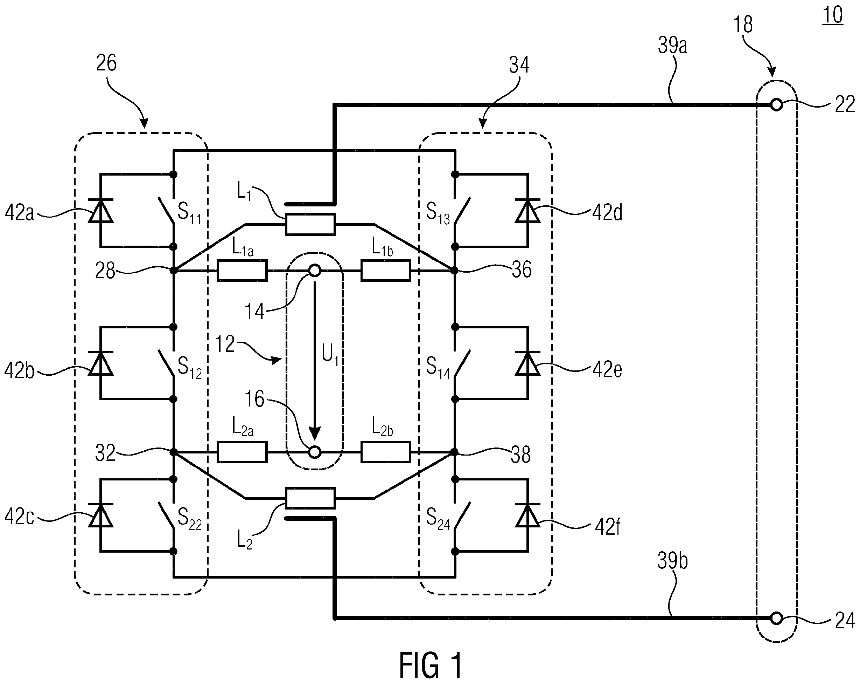

Fig. 1 zeigt ein schematisches Schaltbild einer leistungselektronischen Schaltung 10 mit einem ersten (elektrischen) Tor 12, das einen ersten Anschluss 14 und einen zweiten Anschluss 16 aufweist. Die leistungselektronische Schaltung 10 weist ein zweites (magnetisches) Tor 18 auf, das einen ersten Anschluss 22 und einen zweiten Anschluss 24 umfasst. Die leistungselektronische Schaltung 10 umfasst ferner einen ersten Parallelast 26, der eine Serienschaltung aus einem ersten Schalter S₁₁, einem zweiten Schalter S₁₂ und einem dritten Schalter S₂₂ aufweist. Zwischen dem ersten Schalter S₁₁ und dem zweiten Schalter S₁₂ ist ein erster Knoten 28 angeordnet. Zwischen dem zweiten Schalter S₁₂ und dem dritten Schalter S₂₂ ist ein zweiter Knoten 32 angeordnet.

Die leistungselektronische Schaltung 10 umfasst ferner einen zweiten Parallelast 34, der elektrisch symmetrisch zu dem ersten Parallelast 26 ausgeführt ist und eine Serienschaltung aus einem ersten Schalter S₁₃, einem zweiten Schalter S₁₄ und einem dritten Schalter S₂₄ aufweist. Zwischen dem ersten Schalter S₁₃ und dem zweiten Schalter S₁₄ ist ein erster Knoten 36 angeordnet. Zwischen dem zweiten Schalter S₁₄ und dem dritten Schalter S₂₄ ist ein zweiter Knoten 38 angeordnet. Elektrisch symmetrisch bedeutet, dass Schaltungsteile, bspw. die Paralleläste 26 und 34 unterschiedlich, etwa eine von einander verschiedene Anzahl von Schaltern oder anderen Elementen aufweisend, gebildet sein können aber dennoch gleiche elektrische Eigenschaften aufweisen (z.B. ein Parallelast mit vier Schaltern, ein Parallelast mit drei Schaltern, welche aber z.B. hinsichtlich ihrer parasitären Koppelkapazität zum Kühlkörper so ausgeführt sind, dass sich ein identisches elektrisches Verhalten der beiden Paralleläste zeigt).

Die beiden Paralleläste 26 und 34 sind zu einer Parallelschaltung verschaltet, das bedeutet, die dem jeweiligen ersten Knoten 28 bzw. 36 abgewandten Anschlüsse der Schalter S₁₁ bzw. S₁₃ sind miteinander verschaltet und den jeweiligen zweiten Knoten 32 bzw. 38 abgewandte Anschlüsse der Schalter S₂₂ bzw. S₂₄ sind ebenfalls miteinander verschaltet.

Der erste Anschluss 14 des ersten Tores 12 ist über jeweils eine Spule L₁ₐ bzw. L_{1b} mit dem ersten Knoten 28 bzw. dem ersten Knoten 36 verbunden. Der zweite Anschluss 16 des ersten Tores 12 ist über jeweils eine Spule L₂ₐ bzw. L_{2b} mit den zweiten Knoten 32 und 38 verbunden. In anderen Worten stellen die Spulen L₁ₐ und L_{1b} einen Induktivitätspfad zwischen den beiden ersten Knoten 28 und 36 des ersten Parallelastes 26 und des zweiten Parallelastes 34 dar. Der erste Anschluss 14 des ersten Tores 12 kann als Mittenabgriff des Induktivitätspfades zwischen den beiden ersten Knoten 28 und 36 bezeichnet werden. Zwischen den beiden zweiten Knoten 32 und 38 des ersten Parallelastes 26 und des zweiten Parallelastes 34 bilden die beiden Spulen L₂ₐ und L_{2b} einen zweiten Induktivitätspfad, wobei der zweite Anschluss 16 des ersten Tores 12 als Mittenabgriff des zweiten Induktivitätspfades bezeichnet werden kann.

Parallel zu dem ersten Induktivitätspfad, d.h. parallel zu den Spulen L₁ₐ und L_{1b} ist eine Spule L₁ zwischen die beiden ersten Knoten 28 und 36 verschaltet. Parallel zu dem zweiten induktivitätspfad, d.h. zu den Spulen L₂ₐ und L_{2b}, weist die leistungselektronische Schaltung 10 eine Spule L₂ auf, die zwischen die zweiten Knoten 32 und 38 verschaltet ist. Mittels der, durch die Spulen L₁ und L₂, hervorgerufenen, d. h. während eines Stromfluss durch selbige erzeugte Magnetfelder, sind die Anschlüsse 22 und 24 des zweiten Tores 18 magnetisch mit den ersten Knoten 28 und 36 sowie den zweiten Knoten 32 und 38 gekoppelt, wie es durch die zu den Spulen L₁ und L₂ benachbart angeordnete Linien 39a und 39b angedeutet ist, welche eine magnetische Flussführung (z.B. mittels eines magnetisch leitenden Kernmaterials) symbolisiert, wie sie zur magnetischen Kopplung von Spulen üblich ist. Das bedeutet, dass die Anschlüsse 22 und 24 zwei von einander unabhängige magnetische Kopplungen (magnetische Kreise) sind. Die Linien 39a und 39b können also bspw. Leiter sein, die ausgebildet sind, um einen magnetischen Fluss zu leiten.

Die Spulen L₁ und L₂ sind ausgebildet, um elektrische Energie mittels der magnetischen Kopplung von oder zu den magnetischen Anschlüssen 22 und 24 des zweiten (magnetischen) Tores 18 zu übertragen. Daher können diese auch als Übertragerspulen oder Transformatorspulen bezeichnet werden.

In anderen Worten ist zwischen den Knoten 28 und 26 eine erste Wicklung L₁ eines Transformators mit magnetischem Kernanschluss 22 geschaltet und zwischen den Knoten 32 und 38 eine zweite Wicklung L₂ mit magnetischem Kernanschluss 24. Die beiden Zugänge (Anschlüsse) 22 und 24 zu den, durch die Spulen L₁ und L₂ hervorgerufenen magnetischen Flüsse werden in ihrer Gesamtheit hier als zweites (magnetisches) Tor bezeichnet.

Die leistungselektronische Schaltung 10 stellt eine Basisschaltung dar mit welcher leistungselektronische Energieübertrager und leistungselektronische Energieübertragersysteme realisiert werden können, welche sowohl reduzierte Gegentakt- als auch Gleichtaktstörungen an den jeweiligen ersten (elektrischen) Toren aufweisen.

Die leistungselektronische Schaltung 10 ist eine inhärent störungsarme leistungselektronische Schaltung, das bedeutet, dass die leistungselektronische Schaltung 10 sowohl störungsarm ist und gleichzeitig sämtliche schaltungstechnische Komponenten an der Leistungsübertragung von dem ersten (elektrischen) bzw. zweiten (magnetischen) Tor zu dem zweiten (magnetischen) bzw. ersten (elektrischen) Tor beteiligt sind. Dabei weisen Gegentakt- und Gleichtaktstörungen, bei entsprechender Ansteuerung der Schalter S₁₁, S₁₂, S₂₂, S₁₃, S₁₄ und S₂₄, ein geringes Ausmaß auf.

Die Induktivitäten L₁ₐ, L_{1b}, L₂ₐ und L_{2b} weisen bevorzugt gleiche Induktivitätswerte auf. Die Induktivitätswerte der Induktivitäten L₁ₐ, L_{1b}, L₂ₐ und L_{2b} können beispielsweise in einem Bereich zwischen 10 µH und 100 µH liegen, etwa wenn die Schaltfrequenz im Bereich von ca. 20 kHz und 200 kHz liegt. Alternativ können die Induktivitätswerte, basierend auf der Schaltfrequenz auch andere Werte aufweisen, bspw. in einem Bereich zwischen 1 µH und 1 mH, zwischen 100 nH und 10 mH oder in einem anderen Bereich.

Die beiden Paralleläste 26 und 34 sind bezüglich ihrer elektrischen Eigenschaften symmetrisch um das erste Tor 14 angeordnet. Die Paralleläste 26 und 34 sind bezüglich ihrer elektrischen Eigenschaftenebenfalls symmetrisch zu dem zweiten Tor 18 angeordnet. Ferner weist die leistungselektronische Schaltung 10 eine funktionale Symmetrie zwischen dem ersten Anschluss 22 und dem zweiten Anschluss 24 des zweiten Tores 18 sowie zwischen dem ersten Anschluss 14 und dem zweiten Anschluss 16 des ersten Tores 12 auf.

Die Reduzierung der Gleichtaktstörungen und der Gegentaktstörungen wird zumindest teilweise durch die Symmetrie der elektrischen Eigenschaften und der funktionellen Symmetrie ermöglicht.

Parallel zu den Schaltern S₁₁, S₁₂ und S₂₂ des ersten Parallelastes 26 und den Schalter S₁₃, S₁₄ und S₂₄ des zweiten Parallelastes 34 ist jeweils eine Diode 42a-f verschaltet, die jeweils eine Durchlassrichtung und eine Sperrrichtung aufweist. Das bedeutet, dass, wenn einer der Schalter S₁₁, S₁₂, S₂₂, S₁₃, S₁₄ oder S₂₄ geöffnet ist, ein Stromfluss an dem jeweiligen Schalter vorbei (Bypass) entlang der Durchlassrichtung der jeweiligen Diode 42a-f ermöglicht und entlang der Sperrrichtung reduziert oder verhindert ist. Insbesondere können die Schalter S₁₁, S₁₂, S₂₂, S₁₃, S₁₄ und/oder S₂₄ in Halbleitertechnologie ausgeführt sein, beispielsweise als Transistoren, MOSFETs, IGBTs oder Thyristoren. Insbesondere eine Ausführung der Schalter als MOSFET ermöglicht eine platzsparende gleichzeitige Realisierung des Schalters und der parallel dazu verschalteten Dioden. In einem geschlossen Zustand des jeweiligen Schalters S₁₁, S₁₂, S₂₂, S₁₃, S₁₄ und/oder S₂₄ ist die jeweilige Diode 42a-f kurzgeschlossen, das bedeutet ein Stromfluss ist entlang beider Richtungen möglich.

In anderen Worten vermeidet die leistungselektronische Schaltung 10 die mit dem Stand der Technik einhergehenden Nachteile. Insbesondere wird eine Lösung geschaffen, welche für beliebige Arbeitspunkte, d.h. für Spannungen und Ströme am ersten (elektrischen) Tor der leistungselektronischen Schaltung 10 sowohl eine Eliminierung der Gegentaktstörungen als auch der Gleichtaktstörungen (bezüglich des ersten Tores) erlaubt, ohne das Einbringen zusätzlicher, d.h. nicht am leistungsverarbeitenden Prozess beteiligter Schaltungselemente. Dies wird dann ermöglicht, indem der magnetische Fluss an den Anschlüssen 22 und 24 des magnetischen Tores ermöglicht wird. Nach der Einteilung der Prinzipien zur Reduzierung von Gegen- und Gleichtaktstörungen, wie sie weiter oben beschrieben ist, kann die leistungselektronische Schaltung 10 der Kategorie 5 zugeordnet werden, d.h. der inhärent störungsarmen Leistungselektronik. In dieser Kategorie kann sie zur Unterkategorie e) gezählt werden, d.h. einer Anordnung getakteter leistungselektronischer Sub-Systeme, welche in ihrer Gesamtwirkung nach außen reduzierte Gegen- und Gleichtaktstörungen aufweist, d.h. keine zusätzlichen, nicht am leistungsverarbeitenden Prozess beteiligten Schaltungselemente benötigt und auf dem Prinzip des versetzten Taktens der beiden Paralleläste (Engl.: Interleaving) als auch des gleichzeitigen Taktens der bezüglich der DC-Potentiallinie symmetrisch liegenden Schalter beruht.

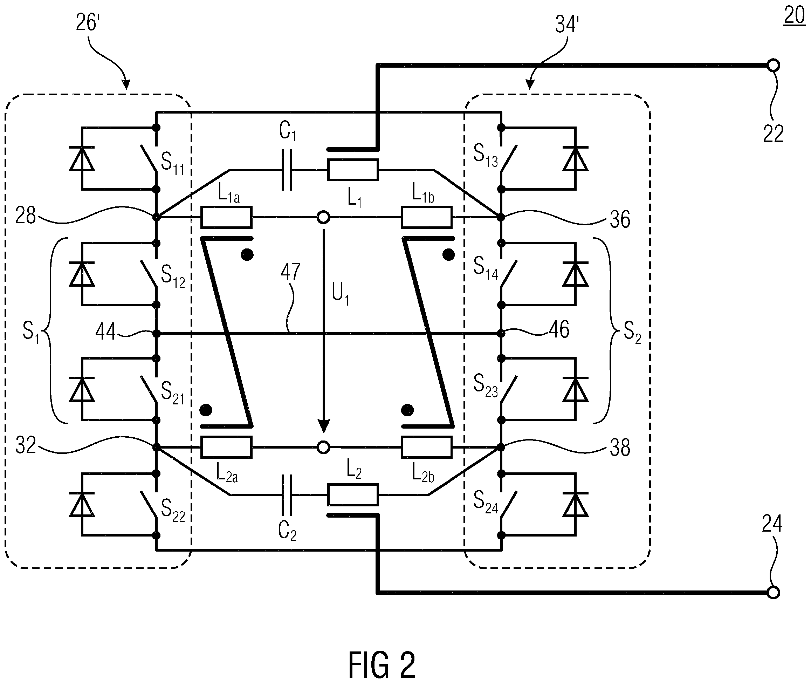

Fig. 2 zeigt ein schematisches Schaltbild einer leistungselektronischen Schaltung 20, die einen Kondensator C₁ aufweist, welcher zwischen der magnetisch gekoppelten Spule L₁ und dem ersten Knoten 28 eines ersten Parallelastes 26' verschaltet ist. Alternativ kann der Kondensator C₁ auch zwischen die magnetisch gekoppelte Spule L₁ und den ersten Knoten 36 des zweiten Parallelastes 36' verschaltet sein. Das bedeutet das die Spule L₁ und der Kondensator C₁ zu einer Serienschaltung zwischen den beiden ersten Knoten verschaltet ist. Ein zweiter Kondensator C₂ ist zwischen der magnetisch gekoppelten Spule L₂ und dem zweiten Knoten 32 zu einer Serienschaltung verschaltet. Alternativ kann der Kondensator C₂ zwischen die magnetisch gekoppelte Spule L₂ und dem zweiten Knoten 38 verschaltet sein.

Der Kondensator C₁ bildet mit der magnetisch gekoppelten Spule L₁ einen elektrischen Schwingkreis, der eine Resonanzfrequenz aufweist, die von einem Kapazitätswert des Kondensators C₁ und dem Induktivitätswert der magnetisch gekoppelten Spule L₁ zumindest teilweise bestimmt wird. Der zweite Kondensator C₂ bildet ebenfalls einen Schwingkreis mit der magnetisch gekoppelten Spule L₂, der eine von einem Kapazitätswert des Kondensators C₂ und dem Induktivitätswert der magnetisch gekoppelten Spule L₂ beeinflusste Resonanzfrequenz aufweist. Die Kapazitätswerte können Werte in einem Bereich zwischen 100 pF und 1 mF, zwischen 1 nF und 500 µF oder zwischen 10 nF und 100 µF aufweisen. Die Kapazitätswerte der Kondensatoren C₁ und C₂ können gleich sein, um eine elektrische Symmetrie der leistungselektronischen Schaltung 20 auch bezüglich der Kondensatoren C₁ und C₂ zu erhalten. Sind ferner die Induktivitätswerte der jeweils magnetisch gekoppelten Spulen L₁ und L₂ gleich, können die Resonanzfrequenzen ebenfalls gleich sein. Basierend auf dem Verlauf der Resonanzfrequenz kann die Frequenz des Schaltungszyklus der leistungselektronischen Schaltung 20 beeinflusst oder bestimmt werden. Ferner kann mittels der Kondensatoren C₁ und C₂ eine Gleichstromfreiheit an den Übertragespulen L₁ und/oder L₂ erreicht werden.

Alternativ kann der Kondensator C₁ und/oder der Kondensator C₂ benachbart zu dem ersten oder zweiten Knoten des zweiten Parallelastes 34' angeordnet sein.

Der erste Parallelast 26' unterscheidet sich von dem ersten Parallelast 26 der leistungselektronischen Schaltung 10 dadurch, dass ein weiterer Schalter S₂₁ zwischen dem zweiten Schalter S₁₂ angeordnet ist und der erste Parallelast 26' mithin vier Schalter S₁₁, S₁₂, S₂₁ und S₂₂ aufweist. Ein zweiter Parallelast 34' weist gegenüber dem zweiten Parallelast 34 der leistungselektronischen Schaltung 10 einen weiteren Schalter S₂₃ auf, der zwischen dem zweiten Schalter S₁₄ und dem dritten Schalter S₂₄ angeordnet ist. Der zweite Parallelast 34' weist somit ebenfalls vier Schalter S₁₃, S₁₄, S₂₃ und S₂₄ auf. Der erste Parallelast 26' umfasst einen Knoten 44, der zwischen dem zweiten Schalter S₁₂ und dem weiteren Schalter S₂₁ angeordnet ist. Der zweite Parallelast 34' weist einen weiteren Knoten 46 auf, der zwischen dem zweiten Schalter S₁₄ und dem weiteren Schalter S₂₃ angeordnet ist. Die beiden Knoten 44 und 46 können miteinander über eine Bezugsverbindung 47 verschaltet sein, so dass sich an den Knoten 44 und 46 ein für die beiden Paralleläste 26' und 34' gemeinsames Bezugspotential zwischen dem jeweiligen zweiten Schalter S₁₂ und dem jeweiligen weiteren Schalter S₂₁ bzw. S₁₄ und S₂₃ einstellt.

Vorteilhaft an dem gemeinsamen Bezugspotential an den Knoten 44 und 46 ist, dass die beiden Paralleläste 26' und 34' jeweils zwei Abschnitte (Schalter S₁₁/S₁₂ und S₂₁/S₂₂ bzw. S₁₃/S₁₄ und S₂₃/S₂₄) aufweisen. Der zweite Schalter S₁₂ bzw. S₁₄ und der jeweilige weitere Schalter S₂₁ bzw. S₂₃ eines Parallelastes 26' oder 34' können von einer Steuerung zu einem ersten Zeitpunkt gemeinsam angesteuert werden und ausgebildet sein, um den gleichen Zustand zwischen geöffnet und geschlossen gleichzeitig zu wechseln.

Die Spulen L_{1b} und L_{2b} weisen, wie es durch das Kreissymbol an der jeweiligen Spule L_{1b} und L_{2b} sowie der Verbindungslinie zwischen den Kreissymbolen angedeutet ist, einen gemeinsamen Spulenkern auf und sind gegenphasig an diesem angeordnet. Ebenso weisen die Spulen L₁ₐ und L₂ₐ einen gemeinsamen Spulenkern auf, an dem die Spulen L₁ₐ und L₂ₐ gegenphasig angeordnet sind. Das bedeutet, die Spulen L₁ₐ und L₂ₐ bzw. die Spulen L_{1b} und L_{2b} sind jeweils paarweise gegenphasig miteinander gekoppelt. Die Anordnung zweier elektrischer Spulen auf einem Spulenkern ermöglicht, dass ein Bauraumbedarf der leistungselektronischen Schaltung 20 sowie Gewicht und/oder Kosten der Schaltungsrealisierung gering sein können.

Das bedeutet, dass die leistungselektronische Schaltung 20 eine mögliche Weiterbildung der leistungselektronischen Schaltung 10, wie sie in der Fig. 1 dargestellt ist, darstellt. In anderen Worten ist die leistungselektronische Schaltung 10 der Fig. 1 mit nur einem Schalter im mittleren Schaltungsteil ausgeführt. Eine Erweiterung besteht darin, die entsprechend der Bezugslinie zwischen den Knoten 44 und 46 gegenüberstehenden Spulen gegensinnig zu koppeln. Somit können jeweils zwei Spulen mit nur einem magnetischen Kern realisiert werden, was die Anzahl der benötigten Schaltungselemente reduziert.

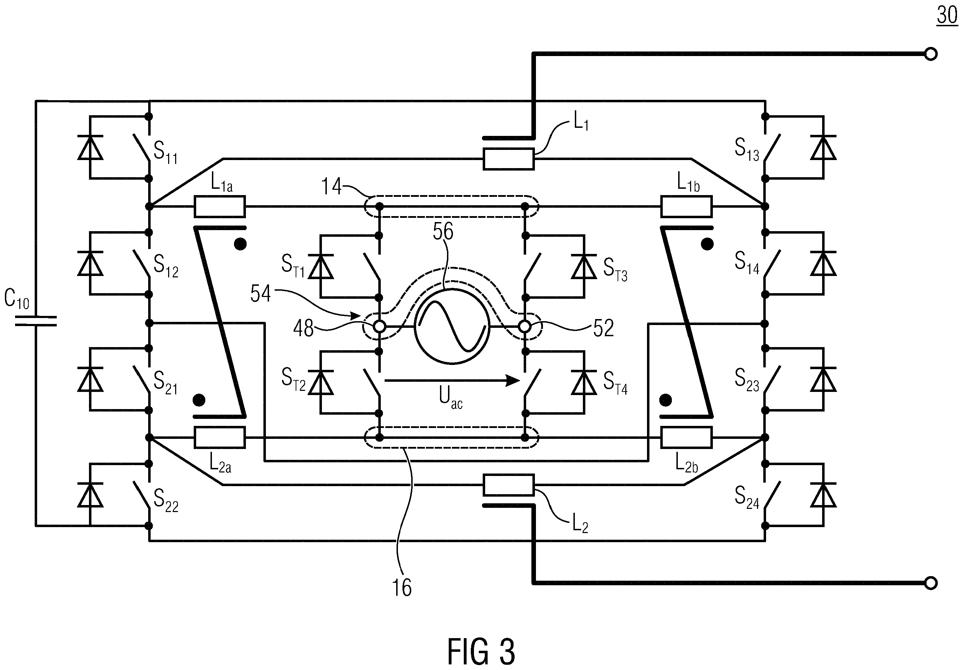

Fig. 3 zeigt ein schematisches Schaltbild einer leistungselektronischen Schaltung 30, bei der der erste Anschluss 14 und der zweite Anschluss 16 des ersten (elektrischen) Tores 12 mit einer Gleich- bzw. Wechselrichterschaltung verschalten sind und somit mittels der zusätzlichen Gleich- bzw. Wechselrichterschaltung über das erste (elektrische) Tor 12 auch Energie in eine Wechselspannungsquelle 56 eingespeist werden kann, bzw. Energie aus der Wechselspannungsquelle 56 entnommen werden kann. Eine Gleich- bzw. Wechselrichterschaltung umfasst bspw. als Brückenschaltung angeordnete Schalter S_{T1}, S_{T2}, S_{T3} und S_{T4}. Die Brückenschaltung kann mit der leistungselektronischen Schaltung fest verdrahtet (Teil der Schaltung), eine zusätzliche Komponente oder Teil der Wechselspannungsquelle sein.

Zwischen dem Schalter S_{T1} und dem Schalter S_{T2} ist ein erster Anschluss 48 in der Brückenschaltung angeordnet. Zwischen den Schaltern S_{T3} und S_{T4} ist ein zweiter Anschluss 52 verschaltet, wobei der erste Anschluss 48 und der zweite Anschluss 52 ein drittes (elektrisches) Tor 54 bilden. Die leistungselektronische Schaltung 30 ist ausgebildet, um an dem dritten Tor 54, d.h. an dem ersten Anschluss 48 und dem zweiten Anschluss 52 mit der Wechselspannungsquelle 56 verbunden zu werden. Das dritte Tor ist mit dem ersten Tor bzw. dem ersten Anschluss 14 und dem zweiten Anschluss 16 verschaltet, so dass die Spannungsquelle 56, wenn sie mit dem dritten Tor 54 verschaltet ist, auch mit dem ersten Tor verschaltet ist. Alternativ kann es sich bei der Wechselspannungsquelle 56 auch um eine Gleichspannungsquelle handeln. In anderen Worten kann die Wechselspannungsquelle 56 eine beliebige Spannungsquelle sein.

Die leistungselektronische Schaltung 30 umfasst ferner einen parallel zu den beiden Parallelästen verschalteten Kondensator C₁₀. Der Kondensator C₁₀, ist ausgebildet, um als Energiespeicher bzw. als ein Puffer zu wirken, etwa wenn eine Menge an elektrischer Energie, die über das magnetische zweite Tor (als magnetischer Fluss) übertragen wird, kurzzeitig geringer oder größer ist, als eine Menge an elektrischer Energie, die der Wechselspannungsquelle 56 entnommen wird. Alternativ kann der Kondensator C₁₀ auch als Energiespeicher oder Puffer wirken, wenn eine Menge an elektrischer Energie, die mittels des magnetischen Flusses empfangen wird, größer oder geringer ist, als eine Menge elektrischer Energie, die an die Wechselspannungsquelle 56 abgegeben wird.

Dies ermöglicht eine weitere Reduzierung der Gegentaktstörungen und eine Vermeidung von Überspannung, insbesondere an den Schaltern S₁₁, S₁₂, S₂₁, S₂₂, S₁₃, S₁₄, S₂₃ und/oder S₂₄. Alternativ kann ein Kapazitätswert des Kondensators C10 auch in Form einer Ausgangskapazität eines oder mehrerer der Schalter S₁₁, S₁₂, S₂₁, S₂₂, S₁₃, S₁₄, S₂₃ und/oder S₂₄ implementiert sein. Alternativ oder zusätzlich können ein oder mehrerer der Schalter S₁₁, S₁₂, S₂₁, S₂₂, S₁₃, S₁₄, S₂₃ und/oder S₂₄ mit einem oder mehreren Kondensatoren C₁₀ verschaltet sein, d. h., Kondensatoren können in die Schalter S₁₁, S₁₂, S₂₁, S₂₂, S₁₃, S₁₄, S₂₃ und/oder S₂₄ integriert sein.

Vorteilhaft an diesem Ausführungsbeispiel ist, dass die leistungselektronische Schaltung 30 mittels der Schalter S_{T1}, S_{T2}, S_{T3} und S_{T4} als Basisschaltung zur Realisierung von AC/DC, DC/AC oder auch AC/AC-Wandlern verwendet werden kann.

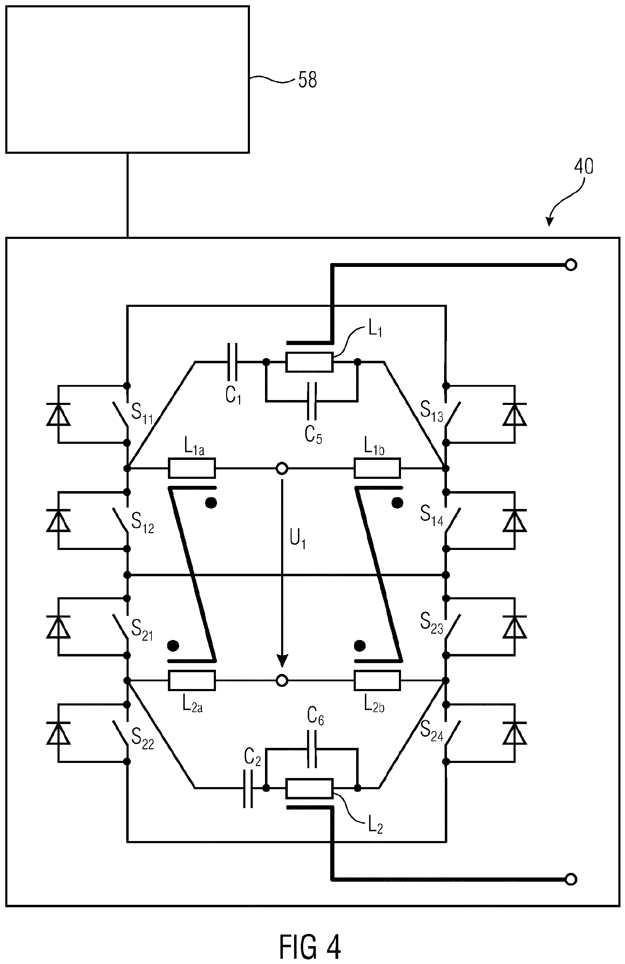

Fig. 4 zeigt ein schematisches Schaltbild einer leistungselektronischen Schaltung 40, die gegenüber der leistungselektronischen Schaltung 20 zwei weitere Kondensatoren C₅ und C₆ aufweist. Der Kondensator C₅ ist parallel zur magnetisch gekoppelten Spule L₁ verschaltet. Der Kondensator C₆ ist parallel zur magnetisch gekoppelte Spule L₂ verschaltet. Alternativ kann auch lediglich einer der Kondensatoren C₅ oder C₆ verschaltet sein.

Eine Verschaltung der Kondensatoren C₅ und/oder C₆ parallel zu der jeweiligen Übertragerspule L₁ bzw. L₂ ermöglicht eine Beeinflussung der Resonanzeigenschaften der jeweiligen Serienschaltung, zu der der jeweilige Kondensator parallel verschaltet ist. Beispielsweise kann eine Parallelresonanz bzw. eine weitere Resonanzfrequenz erzeugt oder eingestellt werden. Alternativ kann der Kondensator C₅ den Kondensator C₁ ersetzen, das bedeutet, dass der Kondensator C₅ alternativ zu dem Kondensator C₁ angeordnet werden kann. Der Kondensator C₆ kann alternativ zu dem Kondensator C₂ angeordnet werden. In anderen Worten können zusätzlich oder ausschließlich oder in Kombination zu den Kondensatoren C₁ und C₂ auch noch Kondensatoren (C₅ und C₆) parallel zu den Übertragerspulen (L₁ und L₂) verschaltet werden, um andere Resonanzeigenschaften zu erzeugen, etwa eine Parallelresonanz.

Die leistungselektronische Schaltung ist mit einer Steuerung 58 verbunden, die ausgebildet ist, um die Schalter S₁₁, S₁₂, S₂₁, S₂₂, S₁₃, S₁₄, S₂₃ und S₂₄ zu steuern, das bedeutet, die Beibehaltung eines Zustandes oder einen Zustandswechsel eines jeweiligen Schalters zu initiieren. Alternativ kann die Steuerung 58 ausgebildet sein, um nur einen oder einige der Schalter der leistungselektronischen Schaltung 40 zu steuern.

Fig. 5 zeigt ein schematisches Schaltbild eines leistungselektronischen Energieübertragers 50 mit einer primärseitigen leistungselektronischen Schaltung 62a und einer sekundärseitigen leistungselektronischen Schaltung 62b. Die primärseitige leistungselektronische Schaltung 62a ist mit der sekundärseitigen leistungselektronischen Schaltung 62b mittels des zweiten Tores magnetisch gekoppelt (verschaltet). Das bedeutet, dass ein primärseitiger erster Anschluss 22a des zweiten Tores mit einem ersten Anschluss 22b des zweiten Tores der sekundärseitigen leistungselektronischen Schaltung 62b magnetisch gekoppelt (verschaltet) ist. Ferner ist ein primärseitiger zweiter Anschluss 24a des zweiten Tores mit einem sekundärseitigen zweiten Anschluss 24b des zweiten Tores magnetisch verkoppelt (verschaltet). Alternativ ist ebenfalls vorstellbar, dass der erste Anschluss des zweiten Tores der primärseitigen leistungselektronischen Schaltung 62a mit dem zweiten Anschluss des zweiten Tores der sekundärseitigen leistungselektronischen Schaltung 62b verschaltet ist (Vertauschung). Bei einer funktionellen Symmetrie der beiden Anschlüsse des zweiten Tores bezüglich der Paralleläste und/oder bezüglich des ersten Tores kann eine Funktion bei einer Vertauschung gleich bleiben.

Die primärseitige leistungselektronische Schaltung 62a und die leistungselektronische Schaltung 62b der Sekundärseite sind funktionsmäßig gleich aufgebaut. Das bedeutet, dass bspw. ein erster Parallelast 26'a der primärseitigen leistungselektronischen Schaltung 62a gleich aufgebaut ist, wie ein erster Parallelast 26'b der sekundärseitigen leistungselektronischen Schaltung 62b. Ferner ist ein zweiter Parallelast 34'a funktionsmäßig gleich aufgebaut wie ein sekundärseitiger zweiter Parallelast 34'b. Funktionsmäßig gleich kann auch bedeuten, dass ein oder mehrere Paralleläste 26'a, 26'b, 34'a und/oder 34'b einer oder beider leistungselektronischer Schaltungen 62a und/oder 62b drei oder eine andere Anzahl von Schaltern aufweist. Prinzipiell wird als funktionsmäßig oder elektrisch gleich oder symmetrisch ein Aufbau verstanden, bei dem eine Schaltungsvariation zwischen zwei Baugruppen (etwa Paralleläste), bspw. eine Vertauschung einer Reihenfolge von Elementen einer Serienschaltung, keinen oder lediglich einen vernachlässigbaren Einfluss auf die Funktion (insbesondere auf die Reduzierung der Gleich- und Gegentaktstörungen) der Schaltung hat.

Basierend auf der magnetischen Kopplung zwischen der primärseitigen und der sekundärseitigen leistungselektronischen Schaltung 62a und 62b bildet sich eine Isolationslinie bzw. Isolationsbarriere 64, da die leistungselektronischen Schaltungen 62a und 62b ohne eine galvanische Verbindung/Kopplung mit einander aufweisen ausgeführt sein können.

Die ersten Paralleläste 26'a und 26'b können beispielsweise gleich aufgebaut sein, wie der erste Parallelast 26' der leistungselektronischen Schaltung 20. Die zweiten Paralleläste 34'a und 34'b können gleich aufgebaut sein, wie der zweite Parallelast 34' der leistungselektronischen Schaltung 20. Alternativ können die primärseitige leistungselektronische Schaltung 62a und die sekundärseitige leistungselektronische Schaltung 62b voneinander verschieden implementiert werden. Das bedeutet, dass die leistungselektronischen Schaltungen 62a und 62b unabhängig voneinander jeweils als leistungselektronische Schaltung 10, 20, 30 oder 40 ausführbar sind.

Eine primärseitige Übertragerspule L_{1P}, beispielsweise die Übertragespule L₁ der leistungselektronischen Schaltung 10 kann einen gleichen oder verschiedenen induktivitätswert aufweisen, wie ein Induktivitätswert einer sekundärseitigen Übertragerspule L_{1S}. Die beiden magnetisch miteinander gekoppelten Übertragerspulen L_{1P} und L_{1S} weisen einen gemeinsamen Spulenkern auf, wie es durch die Kreissymbole benachbart zu den Spulensymbolen angedeutet ist. Ferner weisen die magnetisch miteinander gekoppelten Spulen L_{2P} und L_{2S} einen gemeinsamen Spulenkern auf. Zwei einen gemeinsamen Spulenkern aufweisenden Induktivitäten L_{1P} und L_{1S} bzw. L_{2P} und L_{2S} sind dabei gegenphasig an dem jeweiligen gemeinsamen Spulenkern angeordnet. Alternativ können die Spulen auch gleichphasig an dem Spulenkern angeordnet sein oder von einander verschiedene Spulenkerne aufweisen.

Eine an einem ersten Tor 12a der primärseitigen leistungselektronischen Schaltung 62a angelegte Spannung *U*₁ kann eine Spannung *U*₂ an einem ersten Tor 12b der sekundärseitigen leistungselektronischen Schaltung 62b bewirken. Ferner kann, wenn die Spannung *U*₂ an dem Tor 12b angelegt wird, die Spannung *U*₁ an dem Tor 12a abgreifbar sein (bidirektionale Übertragung). Das bedeutet, dass zwischen den beiden Toren 12a und 12b Energie in Form einer elektrischen Spannung und/oder eines elektrischen Stroms, der fließt, wenn die Spannung *U*₁ oder *U*₂ abgegriffen wird, übertragbar ist.

In anderen Worten ist die in Fig. 5 dargestellte Schaltungstopologie sowohl bezüglich einer DC-Potential-Bezugsverbindung 47a bzw. 47b als auch bezüglich ihrer Isolationsbarriere 64 symmetrisch und kann daher bevorzugt mittels eines Phasenversatzes zwischen primärseitigen und sekundärseitigen Halbbrücken gesteuert werden. Ein Prinzip eines derartigen Steuerverfahrens ist beispielsweise aus [5] zur Steuerung der bekannten *Dual Active Bridge* Topologie bekannt.

Aufgrund der Symmetrie des leistungselektronischen Energieübertragers 50 erfolgt auch auf der Sekundärseite (Spannung *U*₂) eine theoretisch völlige Eliminierung der Gegentaktals auch der Gleichtaktstörungen. Fig. 5 zeigt somit eine Spiegelung der primärseitigen leistungselektronischen Schaltung 62a an der Isolationsbarriere 64 zur Übertragung der Eigenschaften der Primärseite auf die Sekundärseite und zur Realisierung der Steuerbarkeit beliebiger Arbeitspunkte des leistungselektronischen Energieübertragers 50 bezüglich der Spannungen und Ströme der beiden ersten (elektrischen) Tore 12a und 12b.

Ist alternativ die primäre leistungselektronische Schaltung 62a oder die sekundärseitige leistungselektronische Schaltung 62b bspw. als leistungselektronische Schaltung 10 ausgeführt, so können die Schalter S₁₂ und S₂₁, die Schalter S₁₄ und S₂₃, die Schalter S₃₂ und S₄₁ und/oder die Schalter S₃₄ und S₄₃ als ein gemeinsamer Schalter ausgeführt sein. Der gemeinsame Schalter kann eine höhere Sperrspannung aufweisen, als die einzelnen Schalter. Die Sperrspannung kann in einem Bereich von ca. 100 V bis 1700 V liegen.

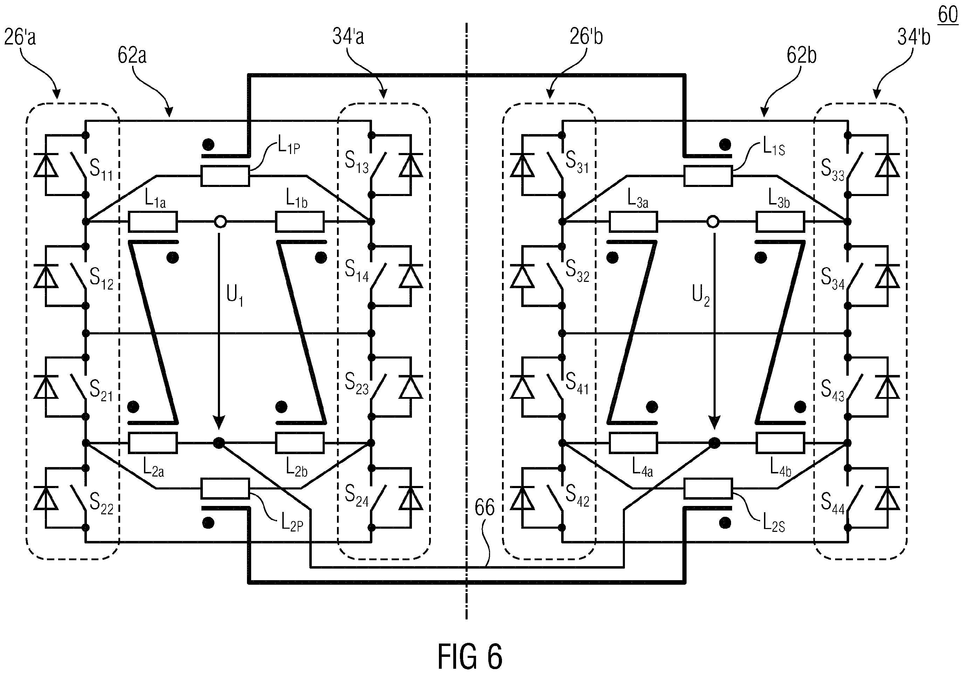

In anderen Worten ist die primärseitige Anordnung dupliziert und stellt einen sekundärseitigen Schaltungsteil dar. Die jeweiligen primärseitigen Übertragerwicklungen L_{1P} und L_{2P} sind mit den sekundärseitigen Übertragerwicklungen L_{1S} und L_{2S} magnetisch gekoppelt. Fig. 6 zeigt ein schematisches Schaltbild eines leistungselektronischen Energieübertragers 60, der die primärseitige leistungselektronische Schaltung 62a und die sekundärseitige leistungselektronische Schaltung 62b aufweist, die miteinander verschaltet sind, wie es für den leistungselektronischen Energieübertrager 50 beschrieben ist. Die Anschlüsse der zweiten Tore der leistungselektronischen Schaltungen 62a und 62b sind der Einfachheit halber nicht dargestellt. Die zweiten Anschlüsse der jeweiligen ersten (elektrischen) Tore weisen ein gemeinsames Bezugspotential auf. Das gemeinsame Bezugspotential wird über eine elektrische Verbindung 66 erhalten, die die zweiten Anschlüsse der jeweiligen ersten Tore galvanisch mit einander verbindet. Alternativ kann die elektrische (galvanische) Verbindung 66 auch an einer anderen Stellt mittels einer Verschaltung der primärseitigen leistungselektronischen Schaltung 62a und der sekundärseitigen leistungselektronischen Schaltung 62b erhalten werden, etwa über eine Verbindung (Verschaltung) der weiteren Knoten der Paralleläste oder durch eine Verbindung (Verschaltung) der Paralleläste 26'a, 26'b, 34'a und 34'b an den jeweils den ersten Knoten der Paralleläste 26'a, 26'b, 34'a und 34'b abgewandten Anschlüssen der Schalter S₁₁, S₁₃, S₃₁ und S₃₃ erhalten werden.

Die elektrische Verbindung 66 ermöglicht die Verwendung des leistungselektronischen Energieübertragers 60 als nicht isolierenden Wandler bezüglich der jeweiligen ersten (elektrischen) Tore mit den Klemmenspannungen U₁ bzw. U₂ In anderen Worten wird ein Einsatz als nicht isolierender Wandler durch Verbindung der Bezugspotentiale von Primärseite 62a und Sekundärseite 62b ermöglicht.

In anderen Worten können als Eingangs- und Ausgangsklemmen des leistungselektronischen Energieübertragers 60 die jeweiligen elektrischen -Anschlüsse (ersten Tore 12a und 12b) verwendet werden.

Ferner kann parallel zu den Parallelästen 26'a und 34'a und/oder parallel zu den Parallelästen 26'b und 34'b ein Kondensator verschaltet sein, etwa der Kondensator C₁₀.

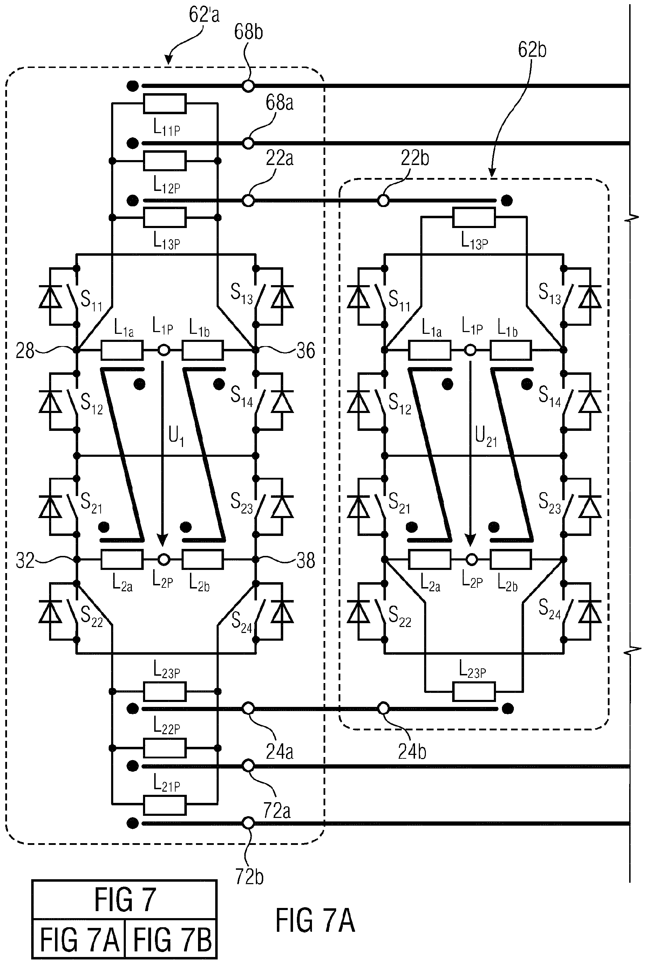

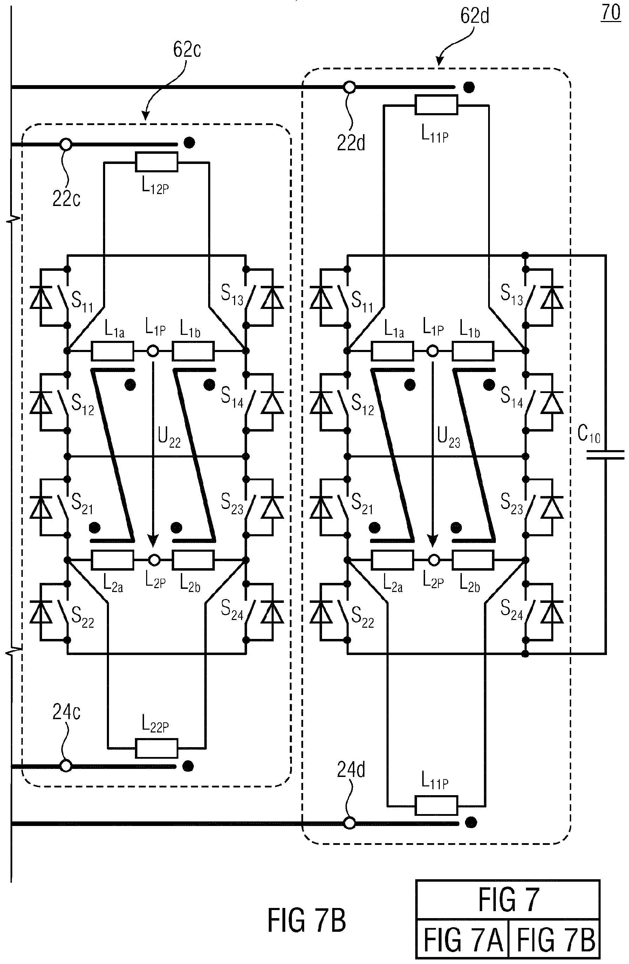

Fig. 7 zeigt ein schematisches Schaltbild eines leistungselektronischen Energieübertragers 70, der gegenüber dem leistungselektronischen Energieübertrager 60 drei sekundärseitige leistungselektronische Schaltungen 62b, 62c und 62d aufweist. Eine primärseitige leistungselektronische Schaltung 62'a entspricht der primärseitigen leistungselektronischen Schaltung 62a des leistungselektronischen Energieübertragers 50 und weist ferner zwei weitere Tore auf. An jedem der weiteren Tore ist eine weitere sekundärseitige leistungselektronische Schaltung 62c bzw. 62d mit der leistungselektronischen Schaltung 62'a verschaltet. Eine Übertragerspule L_{12P} ist zwischen den ersten Knoten 28 und den ersten Knoten 36 verschaltet und magnetisch mit einem ersten Anschluss 68a gekoppelt. Eine Übertragerspule L_{22P} ist zwischen die zweiten Knoten 32 und 38 verschaltet und magnetisch mit einem zweiten Anschluss 72a gekoppelt. Der erste Anschluss 68a und der zweite Anschluss 72a bilden ein erstes weiteres magnetisches Tor, das mit dem zweiten magnetischen Tor der leistungselektronischen Schaltung 62c magnetisch gekoppelt (verbunden) ist. Das bedeutet, ein erster Anschluss 22c des zweiten Tores der sekundärseitigen leistungselektronischen Schaltung 62c ist mit dem Anschluss 68a verbunden und ein zweiter Anschluss 24c des zweiten Tores der sekundärseitigen leistungselektronischen Schaltung 62c ist mit dem Anschluss 72a verbunden.

Eine Übertragerspule L_{11P} ist parallel zu der Übertragerspule L_{13P} und parallel zu der Übertragerspule L_{12P} mit den ersten Knoten 28 und 36 verschaltet. Die Übertragerspule L_{11P} ist magnetisch mit einem ersten Anschluss 68b eines zweiten weiteren Tores gekoppelt. Eine Übertragerspule L_{21P} ist parallel zu den Übertragerspulen L_{23P} und L_{22P} mit den zweiten Knoten 32 und 38 verschaltet und magnetisch mit einem zweiten Anschluss 72b des zweiten weiteren Tores gekoppelt. Die dritte sekundärseitige leistungselektronische Schaltung 62d ist an einem ersten magnetischen Anschluss 22d und einem zweiten magnetischen Anschluss 24d des zweiten magnetischen Tores mit dem zweiten weiteren magnetischen Tor der primärseitigen leistungselektronischen Schaltung 62'a magnetisch gekoppelt (verbunden). Das bedeutet, der erste Anschluss 22d des zweiten Tores ist mit dem ersten Anschluss 68b magnetisch gekoppelt (verschaltet). Ferner ist der zweite Anschluss 24d des zweiten Tores mit dem zweiten Anschluss 72b magnetisch verkoppelt (verschaltet).

In anderen Worten sind die sekundärseitigen leistungselektronischen Schaltungen 62b, 62c und 62d parallel zueinander mit der primärseitigen leistungselektronischen Schaltung 62'a magnetisch verkoppelt (verschaltet). Alternativ können auch mehrere primärseitige leistungselektronische Schaltungen mit einem oder mehreren sekundärseitigen leistungselektronischen Schaltungen verschaltet werden.

Dies ermöglicht eine Realisierung eines mehrphasigen leistungselektronischen Energieübertragers (etwa eines galvanisch trennenden Multiport DC/DC-Wandlers) durch Parallelschaltung und Verschaltung mehrerer sekundärseitiger Schaltungsteile mit nur einem primärseitigen Schaltungsteil. Das bedeutet, dass bei einem Anlegen der Spannung *U*₁ eine Spannung *U*₂₁ an dem ersten Tor der leistungselektronischen Schaltung 62b, eine Spannung *U*₂₂ an dem ersten Tor der leistungselektronischen Schaltung 62c und/oder eine Spannung *U*₂₃ an dem ersten Tor der leistungselektronischen Schaltung 62d abgreifbar ist. Ferner kann eine angelegte Spannung *U*₂₁, *U*₂₂ und/oder *U*₂₃ zu einer resultierenden Spannung *U*₁ führen. Die Spannungen *U*₂₁, *U*₂₂ und *U*₂₃ können, bei einer angelegten Spannung *U*₁, gleiche oder voneinander verschiedene Werte aufweisen, wobei dies auch dadurch beeinflusst sein kann, ob die Übertragespulen L_{11P}, L_{12P}, L_{13P}, L_{21P}, L_{22P}, L_{23P} der Primärseite und/oder der Sekundärseite gleiche oder voneinander verschiedene Werte aufweisen. Ferner können die Übertragerspulen L1a, L2a, L3a, L4a, L1b, L2b, L3b und/oder L4b gleiche oder von einander verschiedene Induktivitätswerte aufweisen. Ferner können die Übertragerspulen L3a, L3b, L4a und/oder L4b der sekundärseitigen Leistungselektronischen Schaltungen 62b, 62c und/oder 62d von einander verschiedene oder alternativ gleiche Induktivitätswerte aufweisen.

Parallel zu den Parallelästen der leistungselektronischen Schaltung 62d ist der Kondensator C₁₀ verschaltet. Alternativ oder zusätzlich kann ein Kondensator auch parallel zu den Parallelästen der leistungselektronischen Schaltungen 62'a, 62b und/oder 62c verschaltet sein.

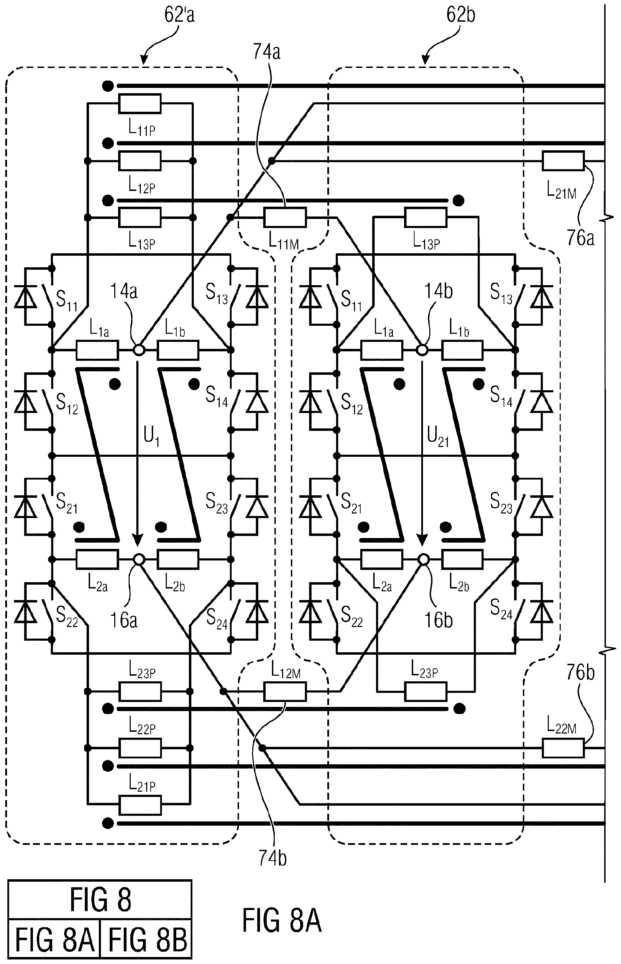

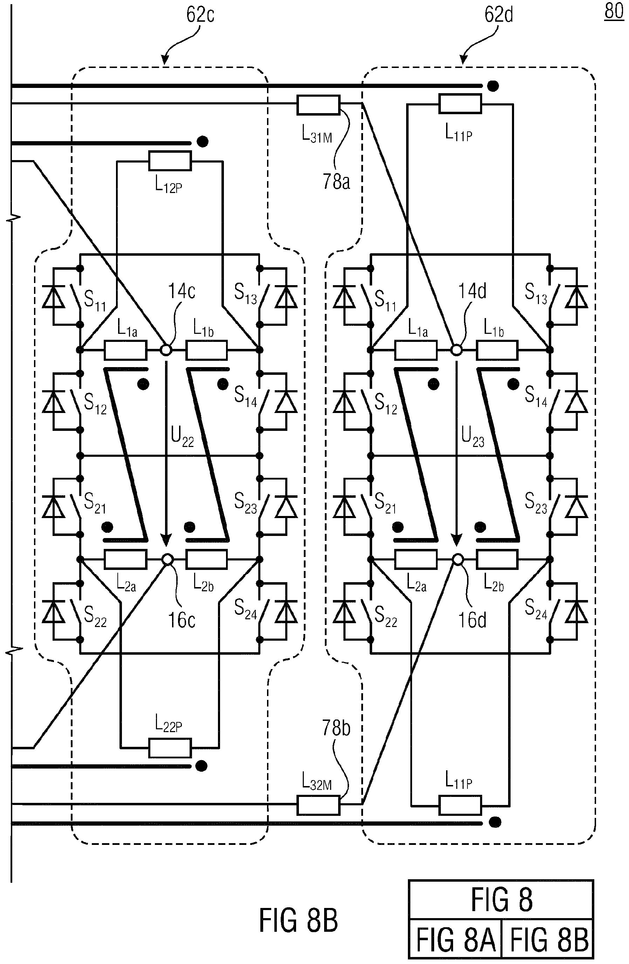

Fig. 8 zeigt ein schematisches Schaltbild eines leistungselektronischen Energieübertragers 80, der als Frequenzumrichter betrieben werden kann.

Die primärseitige leistungselektronische Schaltung 62'a ist mit den sekundärseitigen leistungselektronischen Schaltungen 62b, 62c und 62d verschaltet, wie es für den leistungselektronischen Energieübertrager 70 beschrieben ist. Alternativ kann auch eine andere Anzahl von leistungselektronischen Schaltungen angeordnet sein.

Zwischen den ersten Anschluss 14a des primärseitigen ersten Tores und einen ersten Anschluss 14b des ersten Tores der leistungselektronischen Schaltung 62b ist eine Koppelspule 74a, gekennzeichnet durch die Beschriftung L_{11M} verschaltet. Zwischen den zweiten Anschluss 16a des ersten Tores der primärseitigen leistungselektronischen Schaltung 62'a und einen zweiten Anschluss 16b des ersten Tores der leistungselektronischen Schaltung 62b ist eine Koppelspule 74b, gekennzeichnet durch die Bezeichnung L_{12M}, verschaltet. Das erste Tor der weiteren sekundärseitigen leistungselektronischen Schaltung 72c weist einen ersten Anschluss 14c und einen zweiten Anschluss 16c auf. Ferner weist das erste Tor der zweiten weiteren leistungselektronischen Schaltung 62d einen ersten Anschluss 14d und einen zweiten Anschluss 16d auf. Zwischen den ersten Anschluss 14a (Primärseite) und den ersten Anschluss 14c (weitere Sekundärseite) ist eine Koppelspule 76a, gekennzeichnet durch L_{21M}, verschaltet. Zwischen den zweiten Anschluss 16a (Primärseite) und den zweiten Anschluss 16c (weitere Sekundärseite) ist eine Koppelspule 76b, gekennzeichnet durch die Bezeichnung L_{22M}, verschaltet. Ferner ist zwischen den ersten Anschluss 14a (Primärseite) und den ersten Anschluss 14d (zweite weitere Sekundärseite) eine Koppelspule 78a, gekennzeichnet durch die Bezeichnung L_{31M}, und zwischen den zweiten Anschluss 16a (Primärseite) und den zweiten Anschluss 16d (zweite weitere Sekundärseite) eine Koppelspule 78b, gekennzeichnet durch die Bezeichnung L_{32M}, verschaltet. Der leistungselektronische Energieübertrager 80 kann vorteilhaft mittels einer Spannung U₁ am elektrischen ersten Tor der Schaltung 62'a gespeist werden.

Bspw. sind die Koppelspulen 74a, 74b eine Wicklungen einer ersten Phase einer elektrischen Maschine. Bspw. sind die Koppelspulen 76a und 76b eine Wicklungen einer zweiten Phase einer elektrischen Maschine. Bspw. sind die Koppelspulen 78a und 78b Wicklungeneiner dritten Phase einer elektrischen Maschine. Die elektrische Maschine kann beispielsweise ein Elektromotor sein. Das bedeutet, dass die Koppelspulen 74a und 74b eine erste Motorwicklung, die Koppelinduktivität 76a und 76b eine zweite Motorwicklung und die Koppelinduktivität 78a und 78b eine dritte Motorwicklung sein können. Alternativ kann eine an den leistungselektronischen Energieübertrager 80 angeschlossene elektrische Maschine auch eine, zwei vier oder mehr Phasen aufweisen. Eine Anzahl von sekundärseitigen leistungselektronischen Schaltungen kann der Anzahl der Phasen der elektrischen Maschine entsprechen.

In anderen Worten zeigt Fig. 8 eine Realisierung eines leistungselektronischen Energieübertragers als Umrichter bzw. als einen Motor-Umrichter, in dem mehrere sekundäre Schaltungsteile mit nur einem primärseitigen Schaltungsteil über die Motorwicklung verbunden werden. Bei dieser Ausgestaltung eines Umrichters ist vorteilhaft, dass die an den jeweiligen ersten (elektrischen) Toren angeschlossenen Motorwicklungen mit Spannungen und Strömen gespeist werden, welche reduzierte oder eliminierte Gleich- und Gegentaktstörungen aufweisen.

Parallel zu den Parallelästen einer oder mehrere leistungselektronischer Schaltungen 62'a, 62b, 62c und/oder 62d kann ein Kondensator, etwa der Kondensator C₁₀ verschaltet sein.

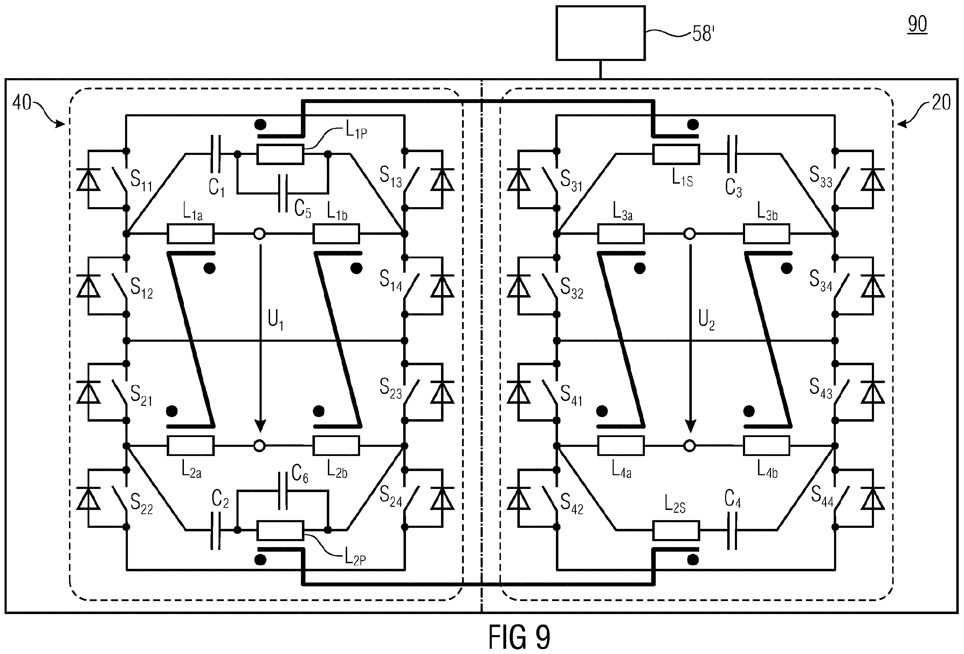

Fig. 9 zeigt ein schematisches Schaltbild eines leistungselektronischen Energieübertragers 90, bei dem die Primärseite aus der leistungselektronischen Schaltung 40 und die Sekundärseite aus der leistungselektronischen Schaltung 20 gebildet ist.

Der leistungselektronische Energieübertrager 90 weist ferner eine Steuerung 58' auf, die mit der leistungselektronischen Schaltung 20 und der leistungselektronischen Schaltung 40 verbunden und ausgebildet ist, um ein Schaltverhalten der Schalter der leistungselektronischen Schaltungen 20 und 40 zu steuern, so dass ein Verhältnis zwischen einer angelegten Spannung U₁ und einer abgreifbaren Spannung U₂ bzw. einer angelegten Spannung U₂ und einer abgreifbaren Spannung U₁ steuerbar ist.

Wird die Eliminierung der Gegentakt- und Gleichtaktstörungen nur auf einer Schaltungsseite benötigt (Primärseite oder Sekundärseite), so kann alternativ oder zusätzlich der sich bildende Resonanzkreis aus Kondensator (C₅ bzw. C₆) und Übertragerinduktivität L_{1P} bzw. L_{2P} einschließlich interner und/oder externer Streuinduktivität zur Beeinflussung der Steuerbarkeit auch mittels Variation der Schaltfrequenz verwendet werden. Die Schalter der Sekundärseite können dabei auch lediglich als passive oder aktive Gleichrichter verwendet werden.

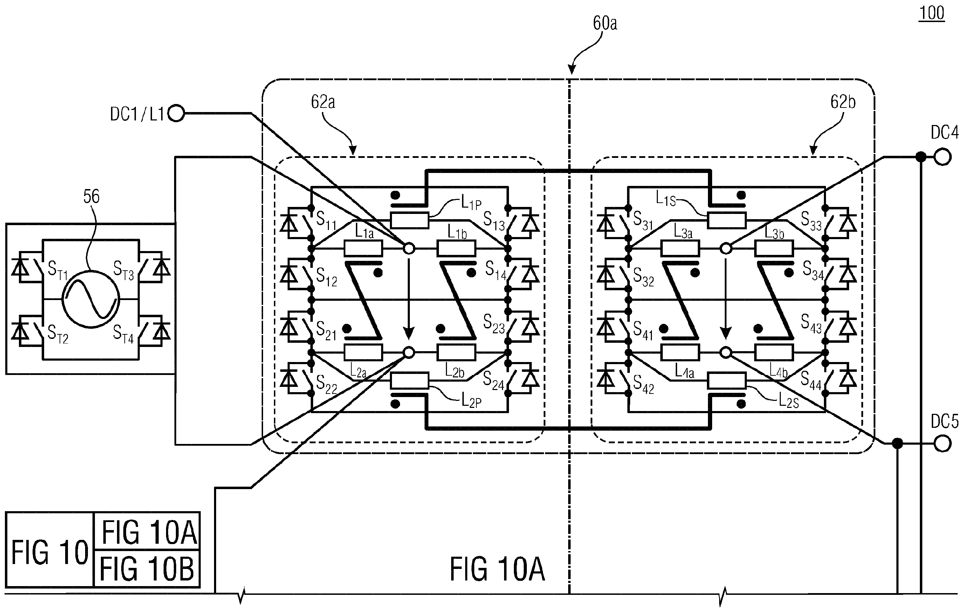

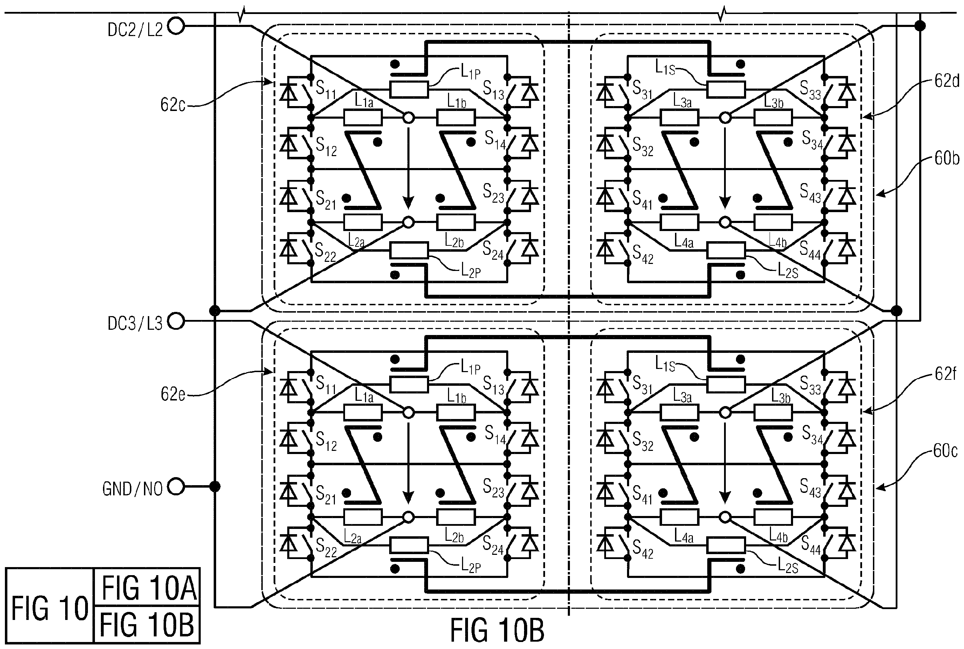

Fig. 10 zeigt ein schematisches Schaltbild eines leistungselektronischen Energieübertragungssystems 100, das drei leistungselektronische Energieübertrager 60a, 60b und 60c mit primärseitigen leistungselektronischen Schaltungen 62a, 62c und 62e und sekundärseitigen leistungselektronischen Schaltungen 62b, 62d und 62f aufweist. Die primärseitige leistungselektronische Schaltung 62a ist mit der sekundärseitigen leistungselektronischen Schaltung 62b magnetisch gekoppelt (verschaltet) und bildet den leistungselektronischen Energieübertrager 60a. Die primärseitige leistungselektronische Schaltung 62c ist mit der sekundärseitigen leistungselektronischen Schaltung 62d verschaltet und bildet den leistungselektronischen Energieübertrager 60b. Die primärseitige leistungselektronische Schaltung 62e ist mit der sekundärseitige leistungselektronischen Schaltung 62f verschaltet und bildet den leistungselektronischen Energieübertrager 60c. Die jeweils zweiten Anschlüsse des ersten Tores der primärseitigen leistungselektronischen Schaltungen 62a, 62c und 62e sind miteinander verbunden, d.h. miteinander verschaltet und weisen ein gemeinsames Potential, etwa ein Bezugspotential (Masse, bzw. engl.: Ground-GND oder N) auf.

Die ersten Anschlüsse der ersten Tore der sekundärseitigen leistungselektronischen Schaltungen 62b, 62d und 62f sind miteinander verschaltet und weisen ein gemeinsames Potential (DC4) auf. Die zweiten Anschlüsse der sekundärseitigen leistungselektronischen Schaltungen 62b, 62d und 62f sind ebenfalls miteinander verschaltet und weisen ein gemeinsames Potential (DC5) auf.

Wird beispielsweise die Wechselspannungsquelle 56 über die Schalter S_{T1}, S_{T2}, S_{T3} und S_{T4}, wie es in Fig. 3 beschrieben ist, mit dem ersten Tor der primärseitigen leistungselektronischen Schaltung 62a verschaltet, so kann basierend auf einer Ansteuerung der Schalter der leistungselektronischen Energieübertrager 60a an den ersten Anschlüssen des ersten Tores der sekundärseitigen leistungselektronischen Schaltung 62b eine Gleichspannung DC4 abgreifbar sein. Alternativ oder zusätzlich kann an dem ersten Tor der leistungselektronischen Schaltung 62c eine Wechselspannung L2 und/oder eine Gleichspannung DC2 anlegbar sein und/oder an der leistungselektronischen Schaltung 62e eine Wechselspannung L3 und/oder eine Gleichspannung DC3 anlegbar sein. Basierend auf einer Verschaltung der ersten Tore der leistungselektronischen Schaltungen 62b, 62d und/oder 62f kann alternativ oder zusätzlich zu der Gleichspannung DC4 eine Gleichspannung DC5 und/oder DC6 an den entsprechenden ersten Toren abgreifbar sein. In anderen Worten zeigt Fig. 10 mit der zusätzlichen Gleich- bzw. Wechselrichterschaltung am ersten Tor der Schaltung 62a einen AC/DC bzw. DC/AC-Wandler zwischen der Wechselspannungsquelle 56 und dem elektrischen Ein- bzw. Ausgang des ersten Tores des sekundären Schaltungsteils 62b. Ferner kann das Energieübertragungssystem 100 durch Hinzunahme weiterer Gleich- bzw. Wechselrichterschaltungen (analog zur exemplarischen Darstellung für Schaltung 62a) für die Schaltungen 62c und 62e zu einem dreiphasigen AC/DC bzw. DC/AC Wandler erweitert werden. Derartige Energieübertragungssysteme können z.B. für uni- bzw. bidirektional arbeitende Ladegeräte für Elektrofahrzeuge im Leistungsbereich von ca. 11k W bis 22 kW einsetzbar sein..

Alternativ oder zusätzlich können auch eine oder mehrere leistungselektronische Schaltungen an den ersten Toren mit einander verschaltet sein und ausgebildet sein, um eine elektrische Spannung an den zweiten Toren bereitzustellen oder mit einer oder mehreren Spannungs- oder Stromquellen verschaltet zu werden.

Mittels einer beliebigen Verschaltung mehrerer leistungselektronischer Systeme für AC/DC oder DC/AC-Anwendungen, ggf. mit zusätzlichen Gleich- bzw. Wechselrichterschaltungen, der Verschaltung der Wechselspannungsquelle 56 mit den Schaltern S_{T1}, S_{T2}, S_{T3} und S_{T4}, können beliebige, d.h. mit unterschiedlich parallel oder in Reihe verschalteten leistungselektronischen Schaltungen 10, 20, 30, 40, leistungselektronischen Energieübertragungssysteme 100 realisiert werden.

Obwohl das leistungselektronische Energieübertragungssystem 100 so beschrieben wurde, dass die Wechselspannungsquelle 56 mittels der Brückenschaltung umfassend die Schalter S_{T1}, S_{T2}, S_{T3} und S_{T4} mit dem elektrischen ersten Tor der ersten leistungselektronischen Schaltung 62a des leistungselektronischen Energieübertragers 60a verschaltet ist, kann alternativ auch eine Wechselspannungsquelle direkt, d. h. ohne eine Brückenschaltung mit dem jeweils elektrischen ersten Tor der leistungselektronischen Schaltungen 62a, 62c und/oder 62e verschaltet werden. Beispielsweise kann eine erste Phase (L1) eines dreiphasigen Wechsel- bzw. Drehspannungsnetzes mit einem der Anschlüsse des elektrischen ersten Tores der leistungselektronischen Schaltung 62a verbunden werden. Eine zweite Phase (L2) kann mit einem Anschluss des ersten Tores der leistungselektronischen Schaltung 62c verbunden werden. Eine dritte Phase (L3) kann mit einem Anschluss des ersten Tores der leistungselektronischen Schaltung 62e verbunden werden. Die jeweils anderen Anschlüsse der elektrischen ersten Tore der leistungselektronischen Schaltungen 62a, 62c und/oder 62e können mit einander verschaltet werden und mit einem Potential N bzw. GND (Masse) des Wechselspannungsnetzes verbunden werden. Alternativ oder zusätzlich kann die Sekundärseite (leistungselektronische Schaltungen 62b, 62d und/oder 62f) in gleicher Weise verschaltet werden. Alternativ können die zweiten leistungselektronischen Schaltungen 62e bzw. 62b, 62d und/oder 62f parallel zu einander verschaltet werden und, wie es für die Potentiale DC4 und DC5 gezeigt ist, einen gemeinsamen Potentialabgriff bereitstellen. Alternativ können die jeweils anderen Anschlüsse der elektrischen ersten Tore der leistungselektronischen Schaltungen 62a, 62c und/oder 62e können mit einander verschaltet und ein beliebiges anderes Potential aufweisen, d. h. eine Kopplung mit dem Potential N bzw. GND kann entfallen.

Ein derart verschaltetes leistungselektronisches Energieübertragungssystem kann, basierend auf einer Ansteuerung der leistungselektronischen Schaltungen 62a-f direkt als AC/DC, DC/AC oder als AC/AC-Wandler betrieben werden, etwa als Wechselrichter oder Umrichter für elektrische Motoren.

In anderen Worten zeigt Fig. 10 eine Verschaltung mehrerer leistungselektronischer Systeme für eine AC/DC oder eine DC/AC-Umsetzung. Das leistungselektronische System kann zusätzlich auf der Primärseite oder einer Sekundärseite mit zusätzlichen Gleich- bzw. Wechselrichterschaltungen (aktiv/passiv, Einweg/Vollweg) ausgestattet oder verschaltet werden, um einen AC/DC, einen DC/AC oder einen AC/AC-Wandler zu realisieren. Das leistungselektronische Energieübertragungssystem 100 zeigt ein mehrphasiges AC/DC, DC/AC-System. Die ersten und/oder zweiten leistungselektronischen Schaltungen 62a, 62c und/oder 62e bzw. 62b, 62d und/oder 62f können jeweils parallel zu einander verschaltet werden.

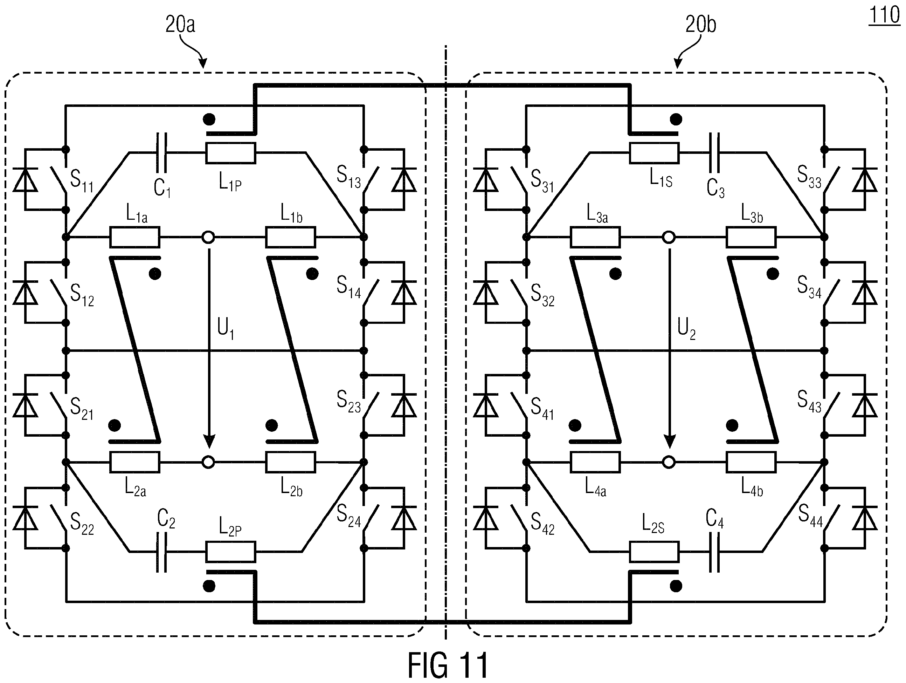

Fig. 11 zeigt ein schematisches Schaltbild eines leistungselektronischen Energieübertragers 110, dessen Primärseite mit einer leistungselektronischen Schaltung 20a und dessen Sekundärseite mit einer leistungselektronischen Schaltung 20b ausgeführt ist. Die leistungselektronischen Schaltungen 20a und 20b entsprechen der leistungselektronischen Schaltung 20.

In anderen Worten zeigt Fig. 11 eine Serienschaltung von primärseitiger und sekundärseitiger Übertragerspulen mit Kondensatoren. Alternativ kann auch lediglich die Primärseite oder die Sekundärseite Kondensatoren aufweisen und/oder lediglich zwischen den ersten Knoten oder zwischen den zweiten Knoten verschaltet sein. Vorteilhaft an der in Fig. 11 dargestellten Ausgestaltung ist, dass durch die Kondensatoren C1 bis C4 die Ströme in den Übertragerspulen stets Gleichstromfrei sind, d.h. eventuell notwendige zusätzliche Maßnahmen zur Sicherstellung der Gleichstromfreiheit entfallen können. Zudem können die Eigenschaften der sich bildenden Resonanzkreise für eine Steuerung der Arbeitspunkte (Spannungen und Ströme an den jeweiligen ersten elektrischen Toren) mittels einer Variation der Schaltfrequenz der für die Schalter anzulegenden Pulsmuster genutzt werden. Alternativ kann bezüglich der Paralleläste der leistungselektronischen Schaltungen 26a und/oder 20b ein Kondensator verschaltet sein, etwa der Kondensator C₁₀.

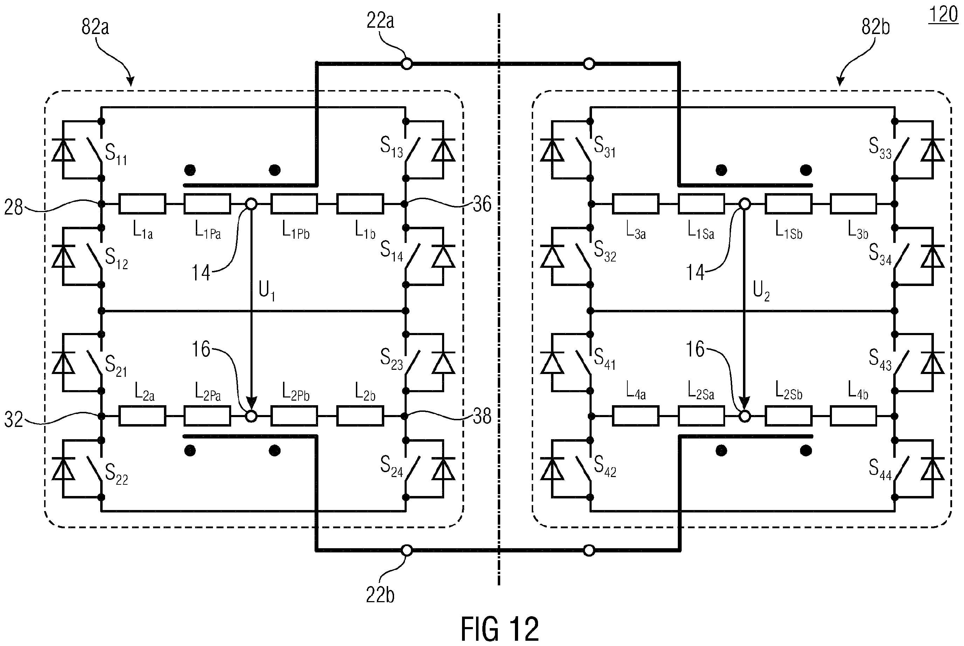

Fig. 12 zeigt ein schematisches Schaltbild eines leistungselektronischen Energieübertragers 120 mit einer leistungselektronischen Schaltung 82a auf der Primärseite und einer leistungselektronischen Schaltung 82b auf der Sekundärseite. Die leistungselektronischen Schaltungen 82a und 82b sind funktionsmäßig gleich aufgebaut. Die Paralleläste der leistungselektronischen Schaltungen 82a und 82b weisen je vier Schalter auf, wie es für die leistungselektronische Schaltung 20 beschrieben ist.

Zwischen den ersten Knoten 28 und 36 sind symmetrisch um den ersten Anschluss 14 des ersten Tores die Spulen L₁ₐ und L_{1b} verschaltet. Zwischen der Spule L₁ₐ und dem ersten Anschluss 14 ist eine magnetisch gekoppelte Spule L_{1Pa} verschaltet und zwischen dem ersten Anschluss 14 und der Spule L_{1b} ist eine magnetisch gekoppelte Spule L_{1Pb} verschaltet. Zwischen die Spule L₂ₐ und dem zweiten Anschluss 16 des ersten Tores ist eine magnetisch gekoppelte Spule L_{2Pa} verschaltet. Ferner ist zwischen dem zweiten Anschluss 16 und dem zweiten Knoten 38 eine magnetisch gekoppelte Spule L_{2Pb} in Serie zu der Spule L_{2b} verschaltet. Im Gegensatz zu der Verschaltung der magnetisch gekoppelten Spulen L₁ bzw. L₂ parallel zu den Induktivitäten L₁ₐ und L_{1b} bzw. L₂ₐ und L_{2b}, wie es bspw. für die leistungselektronische Schaltungen 10, 20, 30 oder 40 beschrieben ist, erfolgt die magnetische Kopplung des ersten Anschlusses 22a bzw. des zweiten Anschlusses 22b des zweiten (magnetischen) Tores über die beiden magnetisch gekoppelten Spulen L_{1Pa} und L_{1Pb} bzw. L_{2Pa} und L_{2Pb}.

Die sekundärseitige leistungselektronische Schaltung 82b weist funktionsmäßig einen gleichen Aufbau auf, so dass zwischen die Anschlüsse 14 bzw. 16 und die ersten bzw. zweiten Knoten der Paralleläste magnetisch gekoppelte Spulen L_{1Sa} und L_{1Sb} bzw. L_{2Sa} und L_{2Sb} verschaltet sind. Die magnetisch gekoppelten Spulen L_{1Pa}, L_{1Pb}, L_{1Sa} und L_{1Sb} sowie die magnetisch gekoppelten Spulen L_{2Pa}, L_{2Pb}, L_{2Sa} und L_{2Sb} weisen jeweils einen gemeinsamen Kern auf und sind jeweils gegenphasig an dem gemeinsamen Kern angeordnet.

Der leistungselektronische Energieübertrager ist ausgebildet, um Gleich- und Gegentaktstörungen zwischen den beiden ersten Toren zu reduzieren.

Vorteilhaft an diesem Ausführungsbeispiel ist, dass, falls lediglich eine Reduzierung der Gleichtaktstörungen ausreichend ist, die zusätzlichen primärseitigen und sekundärseitigen Übertragerwicklungen auch in Serie zu den primärseitigen und sekundärseitigen Spulen verschaltet werden können. Zudem können die Spulen L₁ₐ, L_{1b}, L₂ₐ, L_{2b}, L₃ₐ, L_{3b}, L₄ₐ, L_{4b} bei entsprechend ausgelegter Kopplung der magnetisch gekoppelten Spulen L_{1Pa}, L_{1Pb}, L_{1Sa}, L_{1Sb} bzw. L_{2Pa}, L_{2Pb}, L_{2Sa}, L_{2Sb} durch deren Streuinduktivitäten ausgebildet (d.h. integriert) sein. Hierdurch ist es möglich, alle Spulen mit zwei oder sogar nur einem magnetischen Kern auszuführen. Dies ermöglicht eine weitere Einsparung bezüglich Gewicht, Kosten und Bauraum.

In anderen Worten zeigt Fig. 12 eine Realisierung eines leistungselektronischen Energieübertragers mit in Serie verschalteten Übertragerwicklungen als 2-Kern-Lösung bei reduzierten Gegentakt- (engl. differential mode - DM) Störungen und in ersten Näherung eliminierten Gleichtaktstörungen. Für die magnetischen Speisung der magnetischen zweiten Tore der leistungselektronischen Schaltung auf der Primärseite und der leistungselektronischen Schaltung auf der Sekundärseite werden keine zusätzlichen Spulen benötigt. Anstatt dessen werden die Spulen an den ersten und zweiten Anschlüssen der jeweils elektrischen ersten Tore entsprechend magnetisch miteinander gekoppelt.

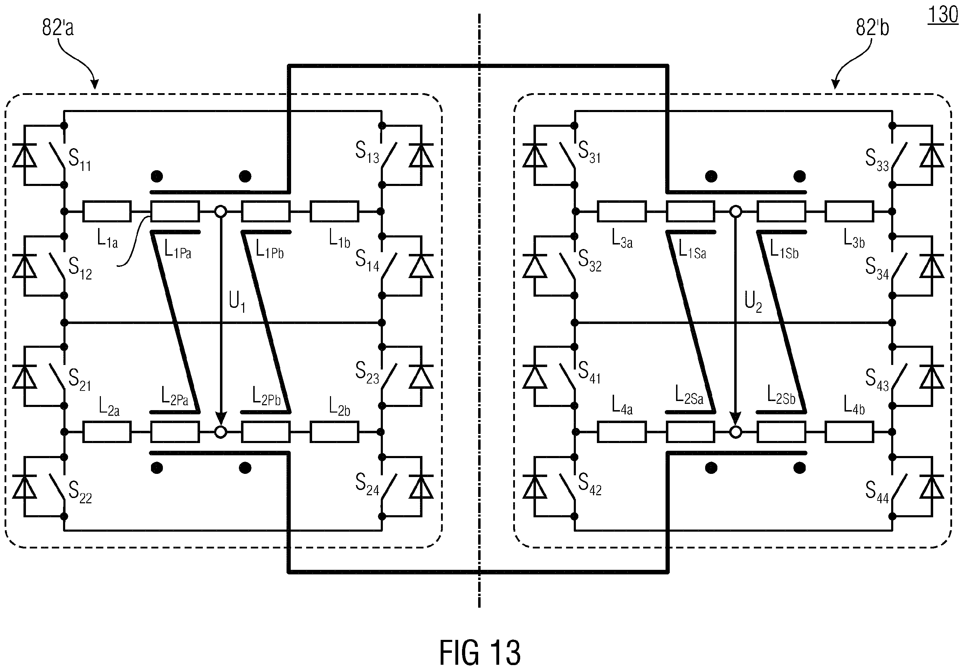

Fig. 13 zeigt ein schematisches Schaltbild eines leistungselektronischen Energieübertragers 130 mit einer primärseitigen leistungselektronischen Schaltung 82'a und einer sekundärseitigen leistungselektronischen Schaltung 82'b. Die leistungselektronischen Schaltungen 82'a und 82'b sind funktionsmäßig gleich aufgebaut und weisen gegenüber den leistungselektronischen Schaltungen 82a und 82b einen gemeinsamen Kern für die Spulen L_{1Pa}, L_{1Pb}, L₂ₚₐ, L_{2Pb}, L_{1Sa}, L_{1Sb}, L_{2Sa} und L_{2Sb} auf. Der leistungselektronische Energieübertrager 130 kann als 1-Kern-Lösung bei reduzierten Gegentaktstörungen und in erster Näherung eliminierten Gleichtaktstörungen bezeichnet werden.

Eine Reihenfolge der Spulenelemente entlang einer Serienschaltung ist in vorangegangenen Ausführungsbeispielen lediglich beispielhaft dargestellt. Es versteht sich, dass eine Reihenfolge von induktiven bzw. kapazitiven Elementen entlang einer Serienschaltung variierbar bzw. veränderlich ist und eine Funktion der jeweiligen Schaltung dabei beibehalten werden kann.

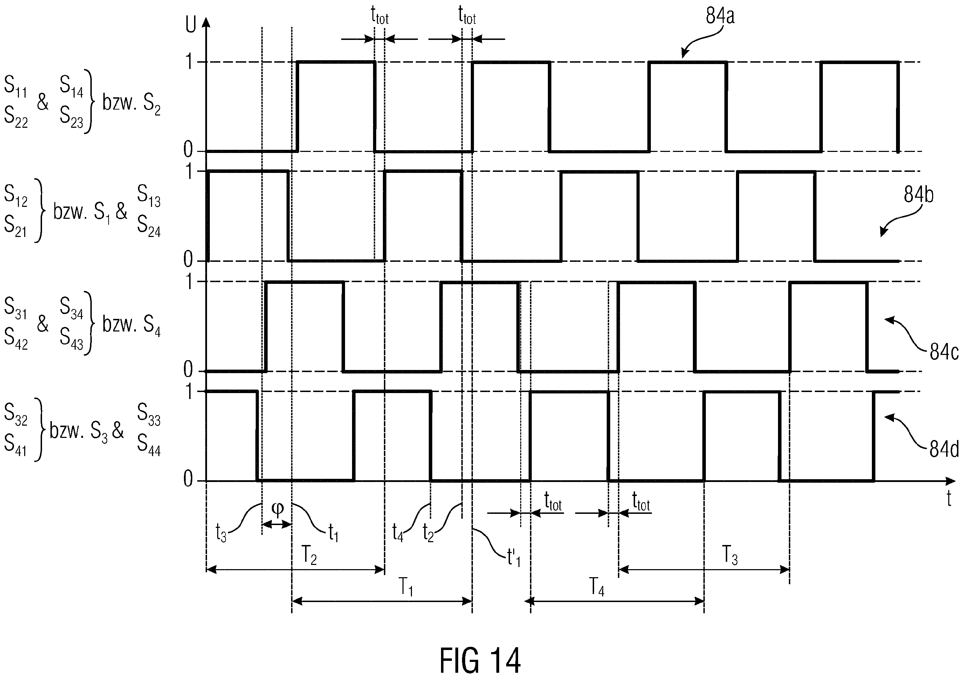

Fig. 14 zeigt ein beispielhaftes Diagramm eines Ansteuerverhaltens einer leistungselektronischen Schaltung oder eines leistungselektronischen Energieübertragers, beispielsweise des leistungselektronische Energieübertragers 50. Der leistungselektronische Energieübertrager 50 kann beispielsweise mit der Steuerung 58 oder der Steuerung 58' gekoppelt sein, so dass die Steuerung 58 oder 58' ausgebildet ist, um die Schalter des leistungselektronischen Energieübertragers 50 zu steuern. Wie bereits erläutert, können, wenn die Paralleläste der leistungselektronischen Schaltungen vier Schalter aufweisen, die Schalter S₁₂ und S₂₁ gleichzeitig geschaltet werden. Ferner können die Schalter S₁₄ und S₂₃ gleichzeitig geschaltet werden. Die Schalter S₃₂ und S₄₁ sowie die Schalter S₃₄ und S₄₃ können ebenso gleichzeitig geschaltet werden. Dies ist beispielsweise in Fig. 2 für die leistungselektronische Schaltung 20 als Zusammenfassung der Schalter S₁₂ und S₂₁ zu einem Schalter S₁ bzw. der Schalter S₁₄ und S₂₃ zu einem Schalter S₂ dargestellt. Gleichermaßen können die Schalter S₃₂ und S₄₁ zu einem Schalter S₃ und die Schalter S₃₄ und S₄₃ zu einem Schalter S₄ zusammengefasst werden.

Weisen die Paralleläste drei Schalter auf, so kann der Schalter S₁ beispielsweise durch den Schalter S₁₂ implementiert sein, wie es für die leistungselektronische Schaltung 10 beschrieben ist. Alternativ kann der Schalter S₁ auch durch den Schalter S₂₁ implementiert werden. Gleichermaßen kann der Schalter S₂ durch den Schalter S₁₄ oder den Schalter S₂₃, der Schalter S₃ durch den Schalter S₃₁ oder den Schalter S₄₁ und der Schalter S₄ durch den Schalter S₃₄ oder den Schalter S₄₃ implementiert werden.

Der leistungselektronische Energieübertrager 50 wird mittels der Ansteuerung, wie sie in Fig. 14 dargestellt ist, so betrieben, dass durch entsprechendes exaktes gleichzeitiges Schalten der entsprechend zur DC-Potentiallinie symmetrisch liegenden Schalter, die Gleichtaktstörungen an den entsprechenden ersten (elektrischen) Toren anliegenden Spannungen und Ströme näherungsweise eliminiert sind und durch entsprechendes exaktes um 180° phasenversetztes Takten der Paralleläste die Gegentaktstörungen an den entsprechenden ersten (elektrischen) Toren anliegenden Spannungen und Ströme näherungsweise eliminiert sind. Zur Bereitstellung beliebiger Arbeitspunkte (d.h. unterschiedlicher Spannungen und Ströme an den jeweiligen ersten Toren) erfolgt zudem ein Phasenversatz zwischen den die Primärseite steuernden Pulsmustern und den die Sekundärseite steuernden Pulsmustern.

Eine Abszisse des Graphen zeigt die Zeitachse. Eine Ordinate des Graphen zeigt eine normierte Achse mit Spannungswerten, die einen Wert von 0 für einen "aus"-Zustand und einen Spannungswert von 1 für einen "ein"-Zustand aufweisen.

Eine Steuerung, beispielsweise die Steuerung 58 oder 58', ist ausgebildet, um vier Signalverläufe 84a, 84b, 84c und 84d an die Schalter anzulegen. Beispielsweise werden die Schalter S₁₁, S₂₂, S₁₄ und S₂₃ mittels des Signalverlaufs 84a angesteuert. Die Schalter S₁₂, S₂₁, S₁₃ und S₂₄ werden mittels des Signalverlaufs 84b angesteuert. Die Steuerung ist ferner ausgebildet, um die Schalter S₃₁, S₄₂, S₃₄ und S₄₃ mittels des Signalverlaufs 84c anzusteuern. Die Steuerung ist ferner ausgebildet, um die Schalter S₃₂, S₄₁, S₃₃ und S₄₄ mittels des Signalverlaufs 84d einzustellen.

Die Steuerung ist ferner ausgebildet, um die Signalverläufe so zueinander einzustellen, dass die primärseitige Ansteuerung mittels der Signalverläufe 84a und 84b zu einem Zeitpunkt entweder für den Signalverlauf 84a oder den Signalverlauf 84b einen Wert von 1 aufweist. Dies kann auch so verstanden werden, dass, wenn der Signalverlauf 84a von einem Wert von 0 auf einen Wert von 1 wechselt, der Signalverlauf 84b zum Zeitpunkt des positiven Flankenwechsels im Signalverlauf 84a den Wert von 0 aufweist. Die Steuerung ist ausgebildet, um Fehlfunktionen, wie beispielsweise Kurzschlüsse, zu verhindern, indem primärseitig und sekundärseitig jeweils nur ein Signalverlauf 84a oder 84b bzw. 84c oder 84d einen Wert von 1 aufweist. Vor einem positiven Flankenwechsel, beispielsweise ein Wechsel von dem Wert 0 zu dem Wert 1 im Signalverlauf 84a, etwa zu den Zeitpunkten t₁ oder t₁', weist der Signalverlauf 84b, etwa zu einem Zeitpunkt t₂ eine negative Signalflanke, einen Wechsel von einem Signalwert 1 auf einen Signalwert 0 auf. Eine zeitliche Differenz zwischen den Zeitpunkten t₂ und t₁' kann als Totzeit verstanden werden, da beide Signalverläufe 84a und 84b bzw. 84c und 84d den Wert 0 aufweisen.

Ein Phasenversatz ϕ bezeichnet einen zeitlichen Versatz zwischen dem Zeitpunkt t₁ und einem Zeitpunkt t₃, wobei der Zeitpunkt t₃ durch einen positiven Flankenwechsel mit einem Wechsel von dem Signalwert 0 auf den Signalwert 1 des Signalverlaufs 84c beeinflusst ist. Der Phasenversatz bestimmt ein Maß an Energie, das von der Primärseite zur Sekundärseite (bzw. umgekehrt) übertragen wird, das bedeutet zwischen den jeweiligen ersten Toren eines leistungselektronischen Energieübertragers übertragen werden kann. Der Phasenversatz ϕ kann alternativ oder zusätzlich einen Phasenversatz zwischen den Signalverläufen 84a und 84c bzw. den Signalverläufen 84b und 84d beschreiben.

Der Signalverlauf 84a weist einen Takt T₁, der Signalverlauf 84b einen Takt T₂, der Signalverlauf 84c einen Takt T₃ und der Signalverlauf 84d einen Takt T₄ auf. Die Takte T₁ bis T₄ können von einander verschieden sein und eine gemeinsame oder gleiche Zeitbasis aufweisen. Vorzugsweise sind die Takte T₁ bis T₄ exakt oder in einem geringen Takt-Toleranzberiech gleich. Der Takt-Toleranzbereich kann bspw. 1 %, 5 % oder 10 % der Taktdauer eines der Takte aufweisen. Ferner können die Signalverläufe 84a-d einen von einander verschiedenen Tastgrad (engl. duty cycle) aufweisen. Vorzugsweise ist der Tastgrad der Signalverläufe 84a-d gleich und beträgt bspw. abzüglich der Hälfte einer Zeitdauer der Totzeit tₜₒₜ oder einer gesamten Zeitdauer der Totzeit tₜₒₜ 50 %. Gleiche Tastgrade von 50 % und gleiche Takte, die zwischen den Signalverläufen 84a und 84b bzw. zwischen 84c und 84d einen Zeitversatz (Phasenversatz) einer halben Taktdauer (Phasenversatz = 180°) aufweisen ermöglichen eine theoretisch vollständige Eliminierung von Gegen- und Gleichtaktstörungen. Der Phasenversatz kann innerhalb eines Phasentoleranzbereichs 180° betragen, etwa zumindest teilweise basierend auf einer sequentiellen Abarbeitung von Steuerbefehlen einer Steuerung, die ausgebildet ist, um manche oder alle der Schalter (sequentiell) zu steuern. Der Phasentoleranzbereich kann bspw. 1 %, 5 % oder 10 % betragen. Abweichungen zwischen Taktdauern, Tastgraden und/oder Zeitversatz ermöglichen eine Funktionalität, bspw. unter Verwendung ungenauerer (ggf. günstigerer) Bauelemente bei dafür verringerter Störungsreduktion.

In anderen Worten zeigt Fig. 14, dass die Steuerung 58 oder 58' (Energieübertragersteuerung) mittels der vier Signalverläufe 84a sowie 84b für die Schaltelemente auf der Primärseite und 84c sowie 84d für die Sekundärseite realisierbar ist. Hierbei ist darauf geachtet, dass entsprechende Totzeiten tₜₒₜ, die in Fig. 14 lediglich schematisch dargestellt sind, zwischen den Signalen 84a und 84b als auch zwischen 84c und 84d eingehalten werden. Zudem zeigt Fig. 14 den Phasenversatz ϕ zwischen den Signalverläufen der Primärseite und der Sekundärseite zur Realisierung der Steuerbarkeit von Ausführungsbeispielen. Die Totzeiten tₜₒₜ können auch einen Wert von 0 aufweisen, d.h., die Steuerung kann ausgebildet sein, um einen positiven bzw. negativen Flankenwechsel des Steuersignals 84a oder 84c gleichzeitig mit einem negativen bzw. positiven Flankenwechsel der Signalverläufe 84b oder 84d zu bewirken. Totzeiten tₜₒₜ mit einem Wert von größer 0 ermöglichen eine Toleranz gegenüber Schaltverzögerungen der Schalter.

Es kann so ein getaktetes leistungselektronisches System erhalten werden, das als ein inhärent störungsarmer isolierender bidirektionaler DC/DC-Wandler mit geringen oder eliminierten Gegen- und Gleichtaktstörungen in allen Betriebspunkten betrieben werden kann).

Ferner kann eine einfache Steuerbarkeit bei unterschiedlichen Betriebspunkten mittels des Phasenversatzes von Primärseite zu Sekundärseite umgesetzt werden. Mit Verweis auf Fig. 5 sind alle Schaltungselemente des leistungselektronischen Energieübertragers 50 an der Prozessierung der Leistung beteiligt, das heißt keines der Schaltungselemente wirkt nur (ausschließlich) als Kompensationselement, was den Begriff der inhärenten störungsarmen Leistungselektronik begründet.

Dies kann auch so verstanden werden, dass eine Energieübertragersteuerung, etwa die Steuerung 58 oder 58', die mit der leistungselektronischen Schaltung verschaltet ist, ausgebildet ist, um einen Zustand der ersten Schalter S₁₁ und S₁₃, der zweiten Schalter S₁₂ und/oder S₂₁ (bzw. S₁) und S₁₄ und/oder S₂₃ (bzw. S₂) und der dritten Schalter S₂₂ und S₂₄ des ersten und des zweiten Parallelastes der primärseitigen und der sekundärseitigen leistungselektronischen Schaltung zu steuern. Die Energieübertragersteuerung ist ausgebildet, um den Zustand des ersten und des dritten Schalters S₁₁ und S₂₂ des ersten Parallelastes der primärseitigen leistungselektronischen Schaltung und den Zustand des zweiten Schalters S₁₄ und/oder S₂₃ bzw. S₂ zu einem ersten Zeitpunkt t₁ zu steuern. Die Energieübertragersteuerung ist ferner ausgebildet, um den Zustand des zweiten Schalters S₁ bzw. S₁₂ und/oder S₂₁ des ersten Parallelastes der primärseitigen leistüngselektronischen Schaltung und den Zustand des ersten und des dritten Schalters S₁₃ und S₂₄ des zweiten Parallelastes der primärseitigen leistungselektronischen Schaltung zu einem zweiten Zeitpunkt t₂ zu steuern. Die Energieübertragersteuerung ist ferner ausgebildet, um den Zustand des ersten und des dritten Schalters S₃₁ und S₄₂ des ersten Parallelastes der sekundärseitigen leistungselektronischen Schaltung und den Zustand des zweiten Schalter S₃₄ und/oder S₄₃ bzw. S₄ des zweiten Parallelastes der sekundärseitigen leistungselektronischen Schaltung zu einem dritten Zeitpunkt t₃ zu steuern. Zu einem vierten Zeitpunkt t₄ ist die Energieübertragersteuerung ausgebildet, um den Zustand des zweiten Schalters S₃ bzw. S₃₂ und/oder S₄₁ des zweiten Parallelastes der sekundärseitigen leistungselektronischen Schaltung zu steuern.

Ein zeitlicher Abstand ϕ z.B. zwischen dem ersten Zeitpunkt t₁ und dem dritten Zeitpunkt t₃ oder zwischen dem zweiten Zeitpunkt t₂ und dem vierten Zeitpunkt t₄ stellt ein Maß für einen Anteil der elektrischen Energie dar, der von dem ersten Tor der primärseitigen leistungselektronischen Schaltung zu dem ersten Tor der sekundärseitigen leistungselektronischen Schaltung (oder umgekehrt) übertragen wird, wenn eine elektrische Spannung an das erste Tor der primärseitigen und/oder sekundärseitigen leistungselektronischen Schaltung angelegt wird. Mittels einer Variation des Phasenversatzes ϕ kann ein veränderlicher Betriebspunkt der mittels der Steuerung angesteuerten Schaltung eingestellt werden.

In anderen Worten werden zur Steuerung der aus dem primären und sekundären Schaltungsteil bestehenden getakteten Schaltung die Schalter der Primärseite und der Sekundärseite so getaktet, dass ein Phasenversatz zwischen dem primären und sekundärseitigen Schaltungen auftritt.

Obwohl Fig. 14 beispielhaft im Zusammenspiel mit dem leistungselektronischen Energieübertrager 50 beschrieben wurde, versteht es sich, dass alternativ oder zusätzlich eine oder mehrere leistungselektronische Schaltungen 10, 20, 30 oder 40, einer oder mehrere leistungselektronische Energieübertrager 50, 60, 70, 90, 80, 110, 120 oder 130 und/oder ein oder mehrere leistungselektronische Energieübertragungssysteme 100 ansteuerbar sind. Die schematische Darstellung der Zeitpunkte t1 und t3 zu Zeiten einer steigenden Flanke der Signale 84a bzw. 84c bzw. der der Zeitpunkte t2 und t4 zu Zeiten einer fallenden Flanke der Signalverläufe 84b bzw. 84d ist lediglich exemplarisch zu verstehen. Es versteht sich, dass insbesondere bei Tastgraden von 50 % eine Beschreibung der Signalverläufe auch bezüglich der jeweils anderen Flanke (fallend bzw. steigend) möglich ist, bzw. dass eine entsprechende Steuervorrichtung ausgebildet ist, die jeweiligen Schalter auch zu Zeitpunkten der jeweils anderen Flanke zu steuern.

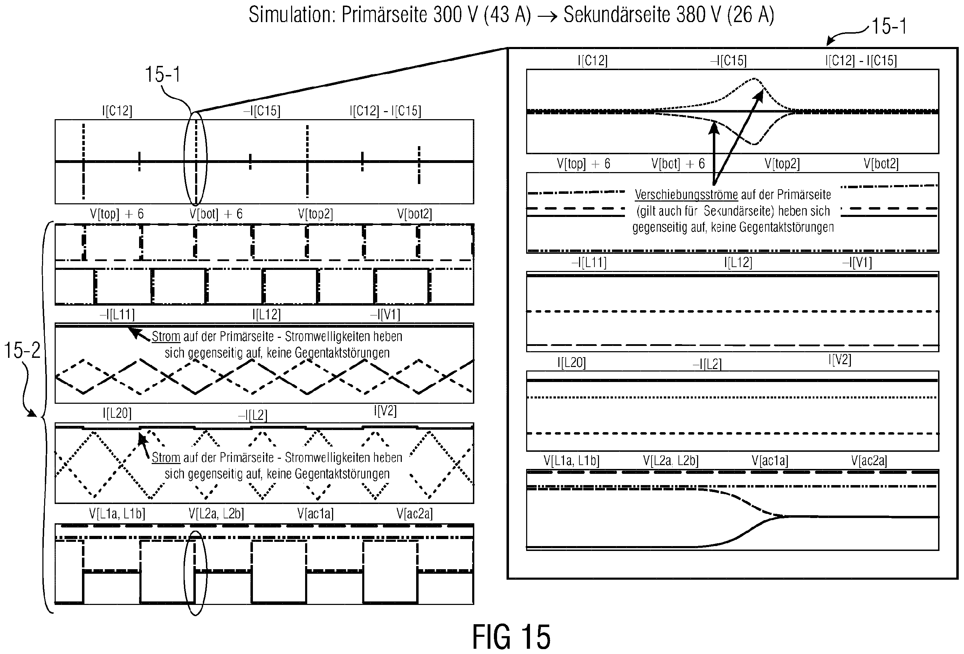

Fig. 15 zeigt ein schematisches Ergebnis einer exemplarischen Schaltungssimulation. In einem Simulationsergebnis 15-1 ist dargestellt, wie sich im Schaltmoment auf der Primärseite durch Überlagerung die entstehenden kapazitiven Verschiebungsströme kompensieren, welche für die Gleichtaktstörung verantwortlich sind. Das bedeutet, dass die am an einem ersten Tor auftretende Gleichtaktstörungen reduziert sind bzw. in erster Näherung eliminiert. Gleiches gilt auch für die Reduzierung bzw. in erste Näherung Eliminierung der Gleichtaktstörungen an einem ersten Tor der Sekundärseite.

In einem Simulationsergebnis 15-2 ist erkennbar, dass sich durch Überlagerung der phasenversetzten Ströme sowohl auf der Primärseite als auch auf der Sekundärseite die Stromwelligkeiten aufheben und daher lediglich geringe oder keine Gegentaktstörungen an den ersten (elektrischen) Toren auftreten.

In anderen Worten zeigt Fig. 15 ein exemplarisches Schaltungssimulationsergebnis zur Verdeutlichung des Prinzips der inhärenten störungsarmen leistungselektronischen Schaltung.

Die Simulation wurde durchgeführt für eine primärseitige Spannung von 300 V und einer Stromaufnahme von 43 A, die an der Sekundärseite auf eine Spannung von 83 V und eine abgreifbare Stromstärke mit einem Wert von 26 A übersetzt wurde. Es versteht sich, dass prinzipiell auch beliebige, in Abhängigkeit der Sperrfähigkeit und Stromtragfähigkeit der verwendeten Schalter, andere Spannungen und/oder Stromstärken an der Primärseite und/oder der Sekundärseite anlegbar bzw. einstellbar sind.
Vorangehend beschriebene inhärent störungsarme leistungselektronische Schaltungen, Energieübertrager oder Energieübertragungssysteme ermöglichen erstmalig für alle Arbeitspunkte eine Reduzierung bzw. in einer ersten Näherung eine Eliminierung der Gegentaktstörungen als auch der Gleichtaktstörungen sowohl an den Eingangsklemmen als auch an den Ausgangsklemmen. Damit ist es möglich, den Aufwand für zusätzlich notwendige EMV-Filter stark zu reduzieren, bzw. die Schaltung theoretisch sogar ohne EMV-Filter zu betreiben. Eine erfindungsgemäße Schaltung eröffnet damit insbesondere die Möglichkeit, die Leistungsfähigkeit neuer Leistungshalbleiter auf Basis von Siliziumcarbid (SiC) oder Galliumnitrid (GaN) vollständig auszunutzen, da sowohl eine Erhöhung der Betriebsspannung als auch der Schaltfrequenz keine Erhöhung der Störpegel mit sich bringt. Dies kann durch eine exakte phasenversetzte bzw. gleichzeitige Taktung der entsprechenden Schaltelemente erreicht werden.

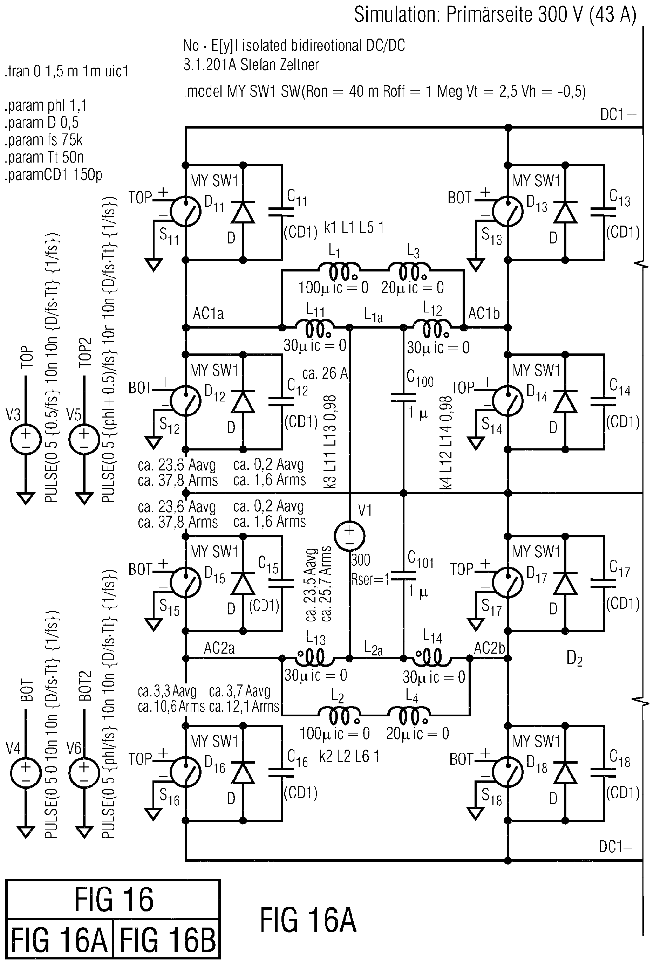

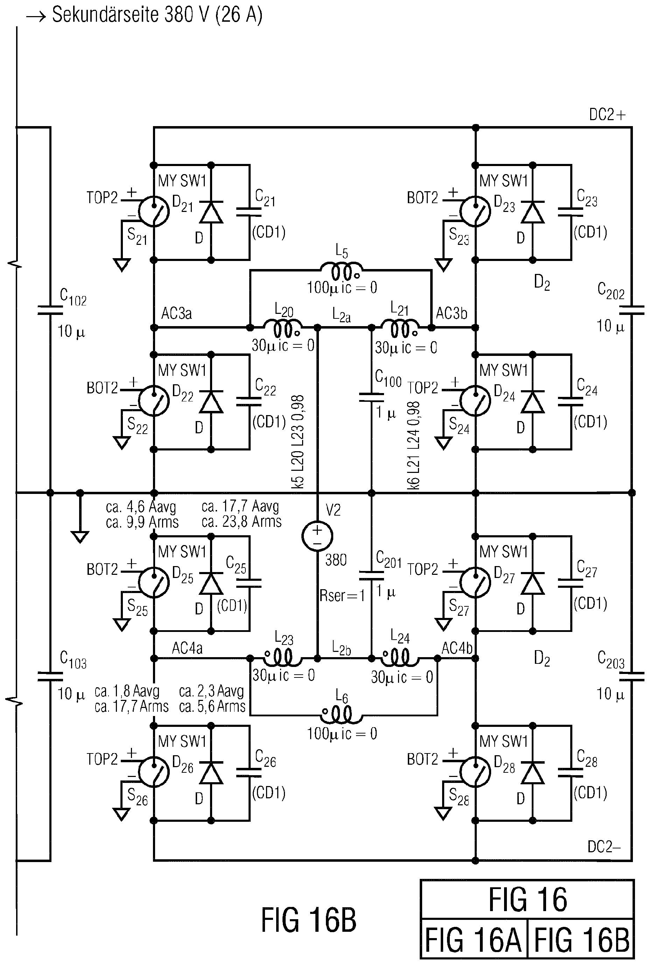

Fig. 16 zeigt ein schematische Schaltbild der leistungselektronischen Energieübertragerschaltung, wie sie nutzbar ist, um die in der Fig. 15 dargestellten Simulationsergebnisse zu erhalten. Aus simulationstechnischen Gründen wurde in der Schaltung gemäß Fig. 15 eine bereits beschriebene galvanische Verbindung zwischen der primärseitigen leistungselektronischen Schaltung und der sekundärseitigen leistungselektronischen Schaltung eingeführt. In diesem Fall erfolgte die Verbindung der beiden DC-Bezugspotentiallinien.

Fig. 17 zeigt ein schematisches Blockschaltbild einer Anwendung von externen EMV-Filtern zur Reduzierung von Gleich- und Gegentaktstörungen. Fig. 17 verdeutlicht auch, dass der EMV-Filter ein zusätzliches, nicht an der eigentlichen Leistungsprozessierung (d.h. Spannungs- und Stromformwandlung) beteiligtes Element ist.

Fig. 18 zeigt ein schematisches Schaltbild eines externen EMV-Filters nach dem Stand der Technik, wie er beispielsweise in [1] beschrieben ist.

Die Figuren 19a und 19b zeigen einen Vergleich zweier unterschiedlicher Methoden zur Reduzierung der Gegentaktstörungen mittels zusätzlicher Schaltungselemente.

Fig. 19a zeigt das Wirkprinzip des "smoothing transformers". Der AC-Anteil der Störspannung *U_{stör}* liegt bei ausreichender Dimensionierung des Kondensators komplett an der magnetisch gekoppelten Spule L₂ an und wird zur Spule L₁ transformiert. Durch die gleichsinnige Wicklungstechnik kann somit am Ausgang A nur noch der DC-Anteil von *U_{stör}* anliegen. D.h. beim idealen "smoothing transformer" nimmt die AC-Wicklung (hier L₂) den kompletten Anteil der Spannung *U_{stör}* auf.

Fig. 19b zeigt ein allgemeines Verfahren zur Kompensation der Stromwelligkeit am Anschluss A einer getakteten Schaltung mit drei Klemmen, wie sie aus der US 6,437,999 B1 bekannt ist. Die Kondensatorspannung *U_{c}*, welche getaktet mit den magnetisch gekoppelten Spulen L₁ und L₂ verbunden wird, teilt sich bspw. gleichmäßig über die beiden Wicklungen L₁ und L₂ auf (L₁=L₂). Aufgrund der gegensinnigen Wicklungstechnik kompensieren sich die Stromwelligkeiten in L₁ und L₂, womit am Anschluss A nur noch ein DC Strom fließt. Wendet man diese Technik auf alle 3 Klemmen einer allgemeinen Wechselschalter-Schaltzelle (eng.: single pole double throw - SPDT) an, kann die Stromwelligkeit an allen 3 Klemmen reduziert oder eliminiert werden.

In anderen Worten zeigen die Ausführungsbeispiele Möglichkeiten, den Nachteil zu beheben, dass Gleichtaktstörungen und gleichzeitig Gegentaktstörungen bislang nur in einem Arbeitspunkt behoben werden können. Dies wird bspw. erreicht, indem ein Steuerungsmechanismus und leistungselektronische Schaltungen, leistungselektronische Energieübertrager sowie leistungselektronische Energieübertragungssysteme geschaffen werden, welche aufgrund ihrer schaltungstopologischen Symmetriebedingungen ein entsprechendes exaktes gleichzeitiges bzw. um 180° phasenversetztes Takten der entsprechenden Schalter erlauben.

Obwohl manche Ausführungsbeispiele so beschrieben wurden, dass parallel zu den Parallelästen der bzw. einer oder mehrerer leistungselektronischer Schaltungen von leistungselektronischen Energieübertragern oder leistungselektronischen Energieübertagungssystemen der Kondensator C₁₀ verschaltet ist, kann der Kondensator C₁₀ parallel zu den Parallelästen einer oder mehrerer leistungselektronischer Schaltungen verschaltet sein. Alternativ können die, eine, mehrere oder alle leistungselektronischen Schaltungen ohne den Kondensator ausgeführt sein. Alternativ kann ein Kondensator auch in Form einer Ausgangskapazität eines oder mehrerer der Schalter eines oder mehrerer Paralleläste implementiert sein. Alternativ oder zusätzlich können ein oder mehrerer der Schalter der Paralleläste mit einem oder mehreren Kondensatoren verschaltet sein, d. h., Kondensatoren können in die Schalter integriert sein

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Literaturliste

[1] Epcos: EMC Filters - 2-line filters for converters and power electronics, Datenblatt Serie B84142/A/C/J*S081
[2] D. C. Hamill et al: A 'Zero' Ripple Technique Applicable To Any DC Converter, IEEE, 1999
[3] Cuk: dc-TO-dc Switching Converter With Zero Input And Output Current Ripple And Integrated Magnetics, US Patent 4257087 A, 1981
[4] E.H. Wittenbreder: Power Electronic Circuits with Ripple Current Cancellation, Patent US 6,437,999 B1, 2002
[5] DeDoncker et al.: Power Conversion Apparatus for DC/DC Conversion Using Dual Active Bridges, Patent US 5027264 A, 1991

## Patentansprüche

1. Leistungselektronische Schaltung (10; 20; 30; 40) mit:
einem elektrischen ersten Tor (12; 12a-b) mit einem ersten (14; 14a-d) und einem zweiten Anschluss (16; 16a-d);
einem magnetischen zweiten Tor (18) mit einem ersten (22; 22a-d) und einem zweiten Anschluss (24; 24a-d);
einem ersten Parallelast (26; 26'; 26'a-b), der eine erste Serienschaltung aus zumindest einem ersten Schalter (S₁₁; S₃₁), einem zweiten Schalter (S₁; S₁₂; S₃₂) und einem dritten Schalter (S₂₂; S₄₂) aufweist; und
einem zweiten Parallelast (34; 34'; 34'a-b), der parallel mit dem ersten Parallelast (26; 26; 26'a-b) verschaltet ist und der eine zweite Serienschaltung aus zumindest einem ersten Schalter (S₁₃; S₃₃), einem zweiten Schalter (S₂; S₁₄; S₃₄) und einem dritten Schalter (S₂₄; S₄₄) aufweist;
wobei der erste Anschluss (14; 14a-d) des elektrischen ersten Tores (12; 12a-b) über jeweils eine Spule (L₁ₐ, L_{1b}; L₃ₐ, L_{3b}) mit einem ersten Knoten (28, 36) zwischen dem ersten (S₁₁, S₁₃, S₃₁, S₃₃) und dem zweiten Schalter (S₁₂, S₁₄; S₁, S₂, S₃₂, S₃₄) in dem ersten (26; 26'; 26'a-b) und dem zweiten Parallelast (34; 34'; 34'a-b) verbunden ist;
wobei der zweite Anschluss (16; 16a-d) des elektrischen ersten Tores (12; 12a-b) über jeweils eine Spule (L₂ₐ, L_{2b}; L₄ₐ, L_{4b}) mit einem zweiten Knoten (32, 38) zwischen dem zweiten (S₁₂, S₁₄; S₁, S₂, S₃₂, S₃₄) und dem dritten Schalter (S₂₂, S₄₂, S₂₄; S₄₄) in dem ersten (26; 26'; 26'a-b) und dem zweiten Parallelast (34; 34'; 34'a-b) verbunden ist;
wobei die ersten Knoten (28, 36) mittels magnetisch gekoppelter Übertragerspulen (L₁; L_{1P}, L_{1S}) mit dem ersten Anschluss (22; 22a-d) des magnetischen zweiten Tores (18) magnetisch gekoppelt sind; und
wobei die zweiten Knoten (32, 38) mittels magnetisch gekoppelter Übertragerspulen (L₂; L_{2P}, L_{2S}) mit dem zweiten Anschluss (24; 24a-d) des magnetischen zweiten Tores (18) magnetisch gekoppelt sind.

2. Leistungselektronische Schaltung gemäß Anspruch 1, bei der parallel zu dem ersten Parallelast (26; 26'; 26'a-b) und dem zweiten Parallelast (34; 34'; 34'a-b) ein Kondensator (C₁₀) verschaltet ist.

3. Leistungselektronischer Schaltung gemäß Anspruch 1 oder 2, bei der der erste Parallelast (26; 26'; 26'a-b) und der zweite Parallelast (34; 34'; 34'a-b) elektrisch symmetrisch aufgebaut sind.

4. Leistungselektronische Schaltung gemäß einem der vorangehenden Ansprüche, bei der der erste Anschluss (14; 14a-d) des elektrischen ersten Tores (12; 12a-b) über eine erste Spule (L₁ₐ; L₃ₐ) mit dem ersten Knoten (28) des ersten Parallelastes (26; 26'; 26'a-b) und über eine zweite Spule (L_{1b}; L_{3b}) mit dem ersten Knoten (36) des zweiten Parallelastes (34; 34'; 34'a-b) verbunden ist, und bei der der zweite Anschluss (16; 16a-d) des elektrischen ersten Tores (12; 12a-b) über eine dritte Spule (L₂ₐ; L₄ₐ) mit dem zweiten Knoten (32) des ersten Parallelastes (26; 26'; 26'a-b) und über eine vierte Spule (L_{2b}; L_{4b}) mit dem zweiten Knoten (32) des zweiten Parallelastes (34; 34'; 34'a-b) verbunden ist, wobei die erste und die dritte Spule (L₁ₐ, L₂ₐ; L₃ₐ, L₄ₐ) einen gemeinsamen Spulenkern aufweisen und die zweite und die vierte Spule (L_{1b}, L_{2b}; L_{3b}, L_{4b}) einen gemeinsamen Spulenkern aufweisen.

5. Leistungselektronische Schaltung gemäß einem der vorangegangenen Ansprüche, bei der der die erste Serienschaltung und die zweite Serienschaltung jeweils einen weiteren Schalter (S₂₁, S₂₃; S₄₁, S₄₃) zwischen dem zweiten Schalter (S₁₂, S₁₄; S₃₂, S₃₄) und dem zweiten Knoten (32, 38) und einen weiteren Knoten (44, 46) zwischen dem weiteren Schalter (S₂₁, S₂₃; S₄₁, S₄₃) und dem dritten Schalter (S₂₂, S₂₄; S₄₂, S₄₄) aufweisen, und bei der die beiden weiteren Knoten (44, 46) mit einander verschaltet sind.

6. Leistungselektronische Schaltung gemäß einem der vorangehenden Ansprüche, bei der zwischen der Übertragerspule (L₁; L_{1P}, L_{1S}) und zwischen dem ersten Knoten (28, 36) des ersten Parallelastes (26; 26'; 26'a-b) oder des zweiten Parallelastes (34; 34'; 34'a-b) ein erster Kondensator (C₁; C₃) seriell verschaltet ist und bei der zwischen der Übertragerspule (L₂; L_{2P}, L_{2S}) und dem zweiten Knoten (32, 38) des ersten Parallelastes (26; 26'; 26'a-b) oder des zweiten Parallelastes (34; 34'; 34'a-b) ein zweiter Kondensator (C₂; C₄) seriell verschaltet ist.

7. Leistungselektronische Schaltung gemäß einem der vorangehenden Ansprüche, die ferner eine Steuerung (58) aufweist, die ausgebildet ist, um einen Zustand der ersten Schalter (S₁₁, S₁₃, S₃₁, S₃₃), der zweiten Schalter (S₁₂, S₁₄; S₁, S₂, S₃₂, S₃₄) und der dritten Schalter (S₂₄, S₂₄; S₄₂, S₄₄) des ersten Parallelastes (26; 26'; 26'a-b) und des zweiten Parallelastes (34; 34'; 34'a-b) zu steuern.

8. Leistungselektronischer Energieübertrager (50; 60; 70; 80; 90; 110; 120; 130), mit:
einer ersten leistungselektronischen Schaltung (20a; 40; 62a; 62'a; 82a; 82'a) gemäß einem der Ansprüche 1-7;
einer zweiten leistungselektronischen Schaltung (20; 20b; 62b-d; 82b; 82'b) gemäß einem der Ansprüche 1-7;
wobei der erste Anschluss (22; 22a-d) des magnetischen zweiten Tores (18) der ersten leistungselektronischen Schaltung (20a; 40; 62a; 62'a; 82a; 82'a) mit dem ersten Anschluss (22; 22a-d) des magnetischen zweiten Tores (18) der zweiten leistungselektronischen Schaltung (20; 20b; 62b-d; 82b; 82'b) verschaltet ist; und
wobei ein der zweite Anschluss (24; 24a-d) des magnetischen zweiten Tores (18) der ersten leistungselektronischen Schaltung (20a; 40; 62a; 62'a; 82a; 82'a) mit dem zweiten Anschluss (24; 24a-d) des magnetischen zweiten Tores (18) der zweiten leistungselektronischen Schaltung (20; 20b; 62b-d; 82b; 82'b) verschaltet ist.

9. Leistungselektronischer Energieübertrager gemäß Anspruch 8, bei dem eine an dem elektrischen ersten Tor (12; 12a-b) der ersten (20a; 40; 62a; 62'a; 82a; 82'a) oder zweiten leistungselektronischen Schaltung (20; 20b; 62b-d; 82b; 82'b) angelegte Spannung (U₁, U₂; U₂₁, U₂₂, U₂₃) eine an dem elektrischen ersten Tor (12; 12a-b) der zweiten (20; 20b; 62b-d; 82b; 82'b) oder ersten leistungselektronischen Schaltung (20a; 40; 62a; 62'a; 82a; 82'a) abgreifbare Spannung (U₁, U₂; U₂₁, U₂₂, U₂₃) bewirkt.

10. Leistungselektronischer Energieübertrager gemäß einem der Ansprüche 8 oder 9, bei dem die erste leistungselektronische Schaltung (20a; 40; 62a; 62'a; 82a; 82'a) und die zweite leistungselektronische Schaltung (20; 20b; 62b-d; 82b; 82'b) über eine elektrische Verbindung (66) galvanisch mit einander gekoppelt sind und ein gemeinsames Bezugspotential aufweisen.

11. Leistungselektronischer Energieübertrager gemäß einem der Ansprüche 8-10, mit zumindest einer dritten leistungselektronischen Schaltung (62c-d) gemäß einem der Ansprüche 1-7;
wobei die erste leistungselektronische Schaltung zumindest ein magnetisches weiteres Tor mit einem ersten Anschluss (68a, 68b) und einem zweiten Anschluss (72a, 72b) aufweist;
wobei die ersten Knoten (28, 36) der Paralleläste (26; 26'; 26'a-b; 34; 34'; 34'a-b) der ersten leistungselektronischen Schaltung (20a; 40; 62a; 62'a; 82a; 82'a) mit dem ersten Anschluss (68a, 68b) des magnetischen weiteren Tores magnetisch gekoppelt sind;
wobei die zweiten Knoten (32, 38) der Paralleläste (26; 26'; 26'a-b; 34; 34'; 34'a-b) der ersten leistungselektronischen Schaltung (20a; 40; 62a; 62'a; 82a; 82'a) mit dem zweiten Anschluss (72a, 72b) des magnetischen weiteren Tores magnetisch gekoppelt sind;
wobei der erste Anschluss (68a, 68b) des magnetischen weiteren Tores mit dem ersten Anschluss (22; 22a-d) des magnetischen zweiten Tores (18) der dritten leistungselektronischen Schaltung (62c-d) verschaltet ist; und
wobei der zweite Anschluss (72a, 72b) des magnetischen weiteren Tores mit dem zweiten Anschluss (24; 24a-d) des magnetischen zweiten Tores (18) der dritten leistungselektronischen Schaltung (62c-d) verschaltet ist.

12. Leistungselektronischer Energieübertrager gemäß einem der Ansprüche 8-11, der ferner eine Energieübertragersteuerung (58') aufweist, die ausgebildet ist, um einen Zustand der ersten Schalter (S₁₁, S₁₃, S₃₁, S₃₃), der zweiten Schalter (S₁₂, S₁₄; S₁, S₂, S₃₂, S₃₄) und der dritten Schalter (S₂₄, S₂₄; S₄₂, S₄₄) des ersten Parallelastes (26; 26'; 26'a-b) und des zweiten Parallelastes (34; 34'; 34'a-b) der ersten (20a; 40; 62a; 62'a; 82a; 82'a) und der zweiten leistungselektronischen Schaltung (20; 20b; 62b-d; 82b; 82'b) zu steuern, wobei die Übertragersteuerung (58') ausgebildet ist,
um den Zustand des ersten (S₁₁) und des dritten Schalters (S₂₂) des ersten Parallelastes (26; 26'; 26'a-b) der ersten leistungselektronischen Schaltung (20a; 40; 62a; 62'a; 82a; 82'a) und den Zustand des zweiten Schalters (S₁₄, S₂₃, S₂) des zweiten Parallelastes (34; 34'; 34'a-b) der ersten leistungselektronischen Schaltung (20a; 40; 62a; 62'a; 82a; 82'a) zu einem ersten Zeitpunkt (t₁', t₁) zu steuern;
um den Zustand des zweiten Schalters (S₁₂, S₂₁, S₁) des ersten Parallelastes (26; 26'; 26'a-b) der ersten leistungselektronischen Schaltung (20a; 40; 62a; 62'a; 82a; 82'a) und den Zustand des ersten (S₁₃) und des dritten Schalters (S₂₄) des zweiten Parallelastes (34; 34'; 34'a-b) der ersten leistungselektronischen Schaltung (20a; 40; 62a; 62'a; 82a; 82'a) zu einem zweiten Zeitpunkt (t₂) zu steuern;
um den Zustand des ersten (S₃₁) und des dritten Schalters (S₄₂) des ersten Parallelastes (26; 26'; 26'a-b) der zweiten leistungselektronischen Schaltung (20; 20b; 62b-d; 82b; 82'b) und den Zustand des zweiten Schalters (S₃₄, S₄₃, S₄) des zweiten Parallelastes (34; 34'; 34'a-b) der zweiten leistungselektronischen Schaltung (20; 20b; 62b-d; 82b; 82'b) zu einem dritten Zeitpunkt (t₃) zu steuern;
um den Zustand des zweiten Schalters (S₃₂, S₄₁, S₃) des ersten Parallelastes (26; 26'; 26'a-b) der zweiten leistungselektronischen Schaltung (20; 20b; 62b-d; 82b; 82'b) und den Zustand des ersten (S₃₃) und des dritten Schalters (S₄₄) des zweiten Parallelastes (34; 34'; 34'a-b) der zweiten leistungselektronischen Schaltung (20; 20b; 62b-d; 82b; 82'b) zu einem vierten Zeitpunkt (t₄) zu steuern;
wobei ein zeitlicher Abstand (ϕ) zwischen dem ersten Zeitpunkt (t₁) und dem dritten Zeitpunkt (t₃) oder dem zweiten Zeitpunkt (t₂) und dem vierten Zeitpunkt (t₄) ein Maß für einen Anteil der elektrischen Energie ist, die von dem elektrischen ersten Tor (12; 12a-b) der ersten leistungselektronischen Schaltung (20a; 40; 62a; 62'a; 82a; 82'a) zu dem elektrischen ersten Tor (12; 12a-b) der zweiten leistungselektronischen Schaltung (20; 20b; 62b-d; 82b; 82'b) übertragen wird, wenn eine elektrische Spannung (U₁) an das elektrische erste Tor (12; 12a-b) der ersten leistungselektronischen Schaltung (20a; 40; 62a; 62'a; 82a; 82'a) angelegt wird.

13. Leistungselektronisches Energieübertragungssystem (100) mit:
zumindest zwei leistungselektronischen Energieübertragern (60a-c) gemäß einem der Ansprüche 8-12 mit je zumindest einer ersten leistungselektronischen Schaltung (62a, 62c, 62e) und zumindest einer zweiten leistungselektronischen Schaltung (62b, 62d, 62f);
wobei die zweiten Anschlüsse (16; 16a-d) des elektrischen ersten Tores (12; 12a-b) der zumindest zwei ersten leistungselektronischen Schaltungen (62a, 62c, 62e) mit einander verschaltet sind; und
wobei die ersten Anschlüsse (14; 14a-d) des elektrischen ersten Tores (12; 12a-b) der zumindest zwei zweiten leistungselektronischen Schaltungen (62b, 62d, 62f) mit einander verschaltet sind; und
wobei die zweiten Anschlüsse (16; 16a-d) des elektrischen ersten Tores (12; 12a-b) der zumindest zwei zweiten leistungselektronischen Schaltungen (62b, 62d, 62f) mit einander verschaltet sind.

14. Leistungselektronisches Energieübertragungssystem gemäß Anspruch 13, bei dem die ersten oder zweiten Anschlüsse (14; 14a-d) der elektrischen ersten Tore (12; 12a-b) der zumindest zwei ersten leistungselektronischen Schaltungen (62a, 62c, 62e) mit einander verschaltet sind.

15. Leistungselektronisches Energieübertragungssystem gemäß Anspruch 13 oder 14, das ferner einen dritten leistungselektronischen Energieübertrager (62a-c) umfasst, wobei der erste Anschluss der elektrischen ersten Tore (12; 12a-b) einer jeden ersten leistungselektronischen Schaltung (62a, 62b, 62c) mit je einem Spannungsanschluss (L1, L2, L3) einer Drehspannungsquelle verbunden sind, wobei die zweiten Anschlüsse der elektrischen ersten Tore (12; 12a-b) mit einander verbunden sind.

## Claims

1. A power electronics circuit (10; 20; 30; 40) comprising:
an electrical first gate (12; 12a-b) comprising a first (14; 14a-d) and a second terminal (16; 16a-d);
a magnetic second gate (18) comprising a first (22; 22a-d) and a second terminal (24; 24a-d);
a first parallel branch (26; 26'; 26'a-b) comprising a first series connection of at least a first switch (S₁₁; S₃₁), a second switch (S₁; S₁₂; S₃₂) and a third switch (S₂₂; S₄₂); and
a second parallel branch (34; 34'; 34'a-b) connected in parallel to the first parallel branch (26; 26; 26'a-b) and comprising a second series connection of at least a first switch (S₁₃; S₃₃), a second switch (S₂; S₁₄; S₃₄) and a third switch (S₂₄; S₄₄);
wherein the first terminal (14; 14a-d) of the electrical first gate (12; 12a-b) is connected to a first node (28, 36) between the first (S₁₁, S₁₃, S₃₁) S₃₃) and the second switch (S₁₂, S₁₄; S₁, S₂, S₃₂, S₃₄) in the first (26; 26'; 26'a-b) and the second parallel branch (34; 34'; 34'a-b) via a respective coil (L₁ₐ, L_{1b}; L₃₁, L_{3b});
wherein the second terminal (16; 16a-d) of the electrical first gate (12; 12a-b) is connected to a second node (32, 38) between the second (S₁₂, S₁₄; S₁, S₂, S₃₂, S₃₄) and the third switch (S₂₂, S₄₂, S₂₄; S₄₄) in the first (26; 26'; 26'a-b) and the second parallel branch (34; 34'; 34'a-b) via a respective coil (L₂ₐ, L_{2b}; L₄ₐ, L_{4b});
wherein the first nodes (28, 36) are coupled magnetically to the first terminal (22; 22a-d) of the magnetic second gate (18) by means of magnetically coupled repeating coils (L₁; L_{1P}, L_{1S}); and
wherein the second nodes (32, 38) are coupled magnetically to the second terminal (24; 24a-d) of the magnetic second gate (18) by means of magnetically coupled repeating coils (L₂; L_{2P}, L_{2S}).

2. The power electronics circuit in accordance with claim 1, wherein a capacitor (C₁₀) is connected in parallel to the first parallel branch (26; 26'; 26'a-b) and the second parallel branch (34; 34'; 34'a-b).

3. The power electronics circuit in accordance with claim 1 or 2, wherein the first parallel branch (26; 26'; 26'a-b) and the second parallel branch (34; 34'; 34'a-b) are set up to be electrically symmetrical.

4. The power electronics circuit in accordance with any of the preceding claims, wherein the first terminal (14; 14a-d) of the electrical first gate (12; 12a-b) is connected to the first node (28) of the first parallel branch (26; 26'; 26'a-b) via a first coil (L₁ₐ; L₃ₐ) and to the first node (36) of the second parallel branch (34; 34'; 34'a-b) via a second coil (L_{1b}; L_{3b}), and wherein the second terminal (16; 16a-d) of the electrical first gate (12; 12a-b) is connected to the second node (32) of the first parallel branch (26; 26'; 26'a-b) via a third coil (L₂ₐ; L₄ₐ) and to the second node (32) of the second parallel branch (34; 34'; 34'a-b) via a fourth coil (L_{2b}; L_{4b}), the first and third coils (L₁ₐ, L₂ₐ; L₃ₐ, L₄ₐ) comprising a common coil core and the second and the fourth coils (L_{1b}, L_{2b}; L_{3b}, L_{4b}) comprising a common coil core.

5. The power electronics circuit in accordance with any of the preceding claims, wherein the first series connection and the second series connection each comprise a further switch (S₂₁, S₂₃; S₄₁, S₄₃) between the second switch (S₁₂, S₁₄; S₃₂, S₃₄) and the second node (32, 38) and a further node (44, 46) between the further switch (S₂₁, S₂₃; S₄₁, S₄₃) and the third switch (S₂₂, S₂₄; S₄₂, S₄₄), and wherein the two further nodes (44, 46) are connected to each other.

6. The power electronics circuit in accordance with any of the preceding claims, wherein a first capacitor (C₁; C₃) is connected in series between the repeating coil (L₁; L_{1P}, L_{1S}) and between the first node (28, 36) of the first parallel branch (26; 26'; 26'a-b) or the second parallel branch (34; 34'; 34'a-b), and wherein a second capacitor (C₂; C₄) is connected in series between the repeating coil (L₂; L_{2P}, L_{2S}) and the second node (32, 38) of the first parallel branch (26; 26'; 26'a-b) or the second parallel branch (34; 34'; 34'a-b).

7. The power electronics circuit in accordance with any of the preceding claims, further comprising a controller (58) configured to control a state of the first switch (S₁₁, S₁₃, S₃₁, S₃₃), the second switch (S₁₂, S₁₄; S₁, S₂, S₃₂, S₃₄) and the third switch (S₂₄, S₂₄; S₄₂, S₄₄) of the first parallel branch (26; 26'; 26'a-b) and the second parallel branch (34; 34'; 34'a-b).

8. A power electronics energy transmitter (50; 60; 70; 80; 90; 110; 120; 130) comprising:
a first power electronics circuit (20a; 40; 62a; 62'a; 82a; 82'a) in accordance with any of claims 1-7;
a second power electronics circuit (20; 20b; 62b-d; 82b; 82'b) in accordance with any of claims 1-7;
wherein the first terminal (22; 22a-d) of the magnetic second gate (18) of the first power electronics circuit (20a; 40; 62a; 62'a; 82a; 82'a) is connected to the first terminal (22; 22a-d) of the magnetic second gate (18) of the second power electronics circuit (20; 20b; 62b-d; 82b; 82'b); and
wherein the second terminal (24; 24a-d) of the magnetic second gate (18) of the first power electronics circuit (20a; 40; 62a; 62'a; 82a; 82'a) is connected to the second terminal (24; 24a-d) of the magnetic second gate (18) of the second power electronics circuit (20; 20b; 62b-d; 82b; 82'b).

9. The power electronics energy transmitter in accordance with claim 8, wherein a voltage (U₁, U₂; U₂₁, U₂₂, U₂₃) applied to the electrical first gate (12; 12a-b) of the first (20a; 40; 62a; 62'a; 82a; 82'a) or second power electronics circuit (20; 20b; 62b-d; 82b; 82'b) causes a voltage (U₁, U₂; U₂₁, U₂₂, U₂₃) tappable at the electrical first gate (12; 12a-b) of the second (20; 20b; 62b-d; 82b; 82'b) or first power electronics circuit (20a; 40; 62a; 62'a; 82a; 82'a).

10. The power electronics energy transmitter in accordance with any of claims 8 or 9, wherein the first power electronics circuit (20a; 40; 62a; 62'a; 82a; 82'a) and the second power electronics circuit (20; 20b; 62b-d; 82b; 82'b) are coupled to each other galvanically via an electrical connection (66) and comprise a common reference potential.

11. The power electronics energy transmitter in accordance with any of claims 8-10, comprising at least a third power electronics circuit (62c-d) in accordance with any of claims 1-7;
wherein the first power electronics circuit comprises at least a magnetic further gate having a first terminal (68a, 68b) and a second terminal (72a, 72b);
wherein the first nodes (28, 36) of the parallel branches (26; 26'; 26'a-b; 34; 34'; 34'a-b) of the first power electronics circuit (20a; 40; 62a; 62'a; 82a; 82'a) are coupled magnetically to the first terminal (68a, 68b) of the magnetic further gate;
wherein the second nodes (32, 38) of the parallel branches (26; 26'; 26'a-b; 34; 34'; 34'a-b) of the first power electronics circuit (20a; 40; 62a; 62'a; 82a; 82'a) are coupled magnetically to the second terminal (72a, 72b) of the magnetic further gate;
wherein the first terminal (68a, 68b) of the magnetic further gate is connected to the first terminal (22; 22a-d) of the magnetic second gate (18) of the third power electronics circuit (62c-d); and
wherein the second terminal (72a, 72b) of the magnetic further gate is connected to the second terminal (24; 24a-d) of the magnetic second gate (18) of the third power electronics circuit (62c-d).

12. The power electronics energy transmitter in accordance with any of claims 8-11, further comprising an energy transmission controller (58') configured to control a state of the first switches (S₁₁, S₁₃, S₃₁, S₃₃), the second switches (S₁₂, S₁₄; S₁, S₂, S₃₂, S₃₄) and the third switches (S₂₄, S₂₄; S₄₂, S₄₄) of the first parallel branch (26; 26'; 26'a-b) and the second parallel branch (34; 34'; 34'a-b) of the first (20a; 40; 62a; 62'a; 82a; 82'a) and the second power electronics circuit (20; 20b; 62b-d; 82b; 82'b), wherein the transmission controller (58') is configured to:
control the state of the first (S₁₁) and the third switch (S₂₂) of the first parallel branch (26; 26'; 26'a-b) of the first power electronics circuit (20a; 40; 62a; 62'a; 82a; 82'a) and the state of the second switch (S₁₄, S₂₃, S₂) of the second parallel branch (34; 34'; 34'a-b) of the first power electronics circuit (20a; 40; 62a; 62'a; 82a; 82'a) at a first point in time (t₁', t₁);
control the state of the second switch (S₁₂, S₂₁, S₁) of the first parallel branch (26; 26'; 26'a-b) of the first power electronics circuit (20a; 40; 62a; 62'a; 82a; 82'a) and the state of the first (S₁₃) and the third switch (S₂₄) of the second parallel branch (34; 34'; 34'a-b) of the first power electronics circuit (20a; 40; 62a; 62'a; 82a; 82'a) at a second point in time (t₂);
control the state of the first (S₃₁) and the third switch (S₄₂) of the first parallel branch (26; 26'; 26'a-b) of the second power electronics circuit (20; 20b; 62b-d; 82b; 82'b) and the state of the second switch (S₃₄, S₄₃, S₄) of the second parallel branch (34; 34'; 34'a-b) of the second power electronics circuit (20; 20b; 62b-d; 82b; 82'b) at a third point in time (t₃);
control the state of the second switch (S₃₂, S₄₁, S₃) of the first parallel branch (26; 26'; 26'a-b) of the second power electronics circuit (20; 20b; 62b-d; 82b; 82'b) and the state of the first (S₃₃) and the third switch (S₄₄) of the second parallel branch (34; 34'; 34'a-b) of the second power electronics circuit (20; 20b; 62b-d; 82b; 82'b) at a fourth point in time (t₄);
wherein a temporal distance (ϕ) between the first point in time (t₁) and the third point in time (t₃) or the second point in time (t₂) and the fourth point in time (t₄) is a measure of a portion of electrical energy transmitted from the electrical first gate (12; 12a-b) of the first power electronics circuit (20a; 40; 62a; 62'a; 82a; 82'a) to the electrical first gate (12; 12a-b) of the second power electronics circuit (20; 20b; 62b-d; 82b; 82'b) when an electrical voltage (U₁) is applied to the electrical first gate (12; 12a-b) of the first power electronics circuit (20a; 40; 62a; 62'a; 82a; 82'a).

13. A power electronics energy transmission system (100) comprising:
at least two power electronics energy transmitters (60a-c) in accordance with any of claims 8-12 each comprising at least one first power electronics circuit (62a, 62c, 62e) and at least one second power electronics circuit (62b, 62d, 62f);
wherein the second terminal (16; 16a-d) of the electrical first gate (12; 12a-b) of the at least two first power electronics circuits (62a, 62c, 62e) are connected to each other; and
wherein the first terminals (14; 14a-d) of the electrical first gate (12; 12a-b) of the at least two second power electronics circuits (62b, 62d, 62f) are connected to each other; and
wherein the second terminals (16; 16a-d) of the electrical first gate (12; 12a-b) of the at least two second power electronics circuits (62b, 62d, 62f) are connected to each other.

14. The power electronics energy transmission system in accordance with claim 13, wherein the first or second terminals (14; 14a-d) of the electrical first gates (12; 12a-b) of the at least two first power electronics circuits (62a, 62c, 62e) are connected to each another.

15. The power electronics energy transmission system in accordance with claim 13 or 14, further comprising a third power electronics energy transmitter (62a-c), wherein the first terminal of the electrical first gates (12; 12a-b) of each first power electronics circuit (62a, 62b, 62c) is connected to a respective voltage terminal (L1, L2, L3) of a three-phase voltage source, wherein the second terminals of the electrical first gates (12; 12a-b) are connected to each another.

## Revendications

1. Circuit électronique de puissance (10; 20; 30; 40) avec:
une première porte électrique (12; 12a à b) avec une première (14; 14a à d) et une deuxième borne (16; 16a à d);
une deuxième porte magnétique (18) avec une première (22; 22a à d) et une deuxième borne (24; 24a à d);
une première branche parallèle (26; 26'; 26'a à b) présentant un premier circuit série composé d'au moins un premier commutateur (S₁₁; S₃₁), un deuxième commutateur (S₁; S₁₂; S₃₂) et un troisième commutateur (S₂₂; S₄₂); et
une deuxième branche parallèle (34; 34'; 34'a à b) connectée en parallèle avec la première branche parallèle (26; 26; 26'a à b) et présentant un deuxième circuit série composé d'au moins un premier commutateur (S₁₃; S₃₃), un deuxième commutateur (S₂; S₁₄; S₃₄) et un troisième commutateur (S₂₄; S₄₄);
dans lequel la première borne (14; 14a à d) de la première porte électrique (12; 12a à b) est connectée respectivement par l'intermédiaire d'une bobine (L₁ₐ, L_{1b}; L₃ₐ, L_{3b}) à un premier noeud (28, 36) entre le premier (S₁₁, S₁₃, S₃₁, S₃₃) et le deuxième commutateur (S₁₂, S₁₄; S₁; S₂, S₃₂, S₃₄) dans la première (26; 26'; 26'a à b) et la deuxième branche parallèle (34; 34'; 34'a à b);
dans lequel la deuxième borne (16; 16a à d) de la première porte électrique (12; 12a à b) est connectée respectivement par l'intermédiaire d'une bobine (L₂ₐ, L_{2b}; L₄ₐ, L_{4b}) à un deuxième noeud (32, 38) entre le deuxième (S₁₂, S₁₄; S₁, S₂, S₃₂, S₃₄) et le troisième commutateur (S₂₂, S₄₂, S₂₄; S₄₄) dans la première (26; 26'; 26'a à b) et la deuxième branche parallèle (34; 34'; 34'a à b);
dans lequel les premiers noeuds (28, 36) sont couplés de manière magnétique au moyen de bobines de transmission à couplage magnétique (L₁; L_{1P}, L_{1S}) à la première borne (22; 22a à d) de la deuxième porte magnétique (18); et
dans lequel les deuxièmes noeuds (32, 38) sont couplés de manière magnétique au moyen de bobines de transmission à couplage magnétique (L₂; L_{2P}, L_{2S}) à la deuxième borne (24; 24a à d) de la deuxième porte magnétique (18).

2. Circuit électronique de puissance selon la revendication 1, dans lequel un condensateur (C₁₀) est connecté en parallèle avec la première branche parallèle (26; 26'; 26'a à b) et la deuxième branche parallèle (34; 34'; 34'a à b).

3. Circuit électronique de puissance selon la revendication 1 ou 2, dans lequel la première branche parallèle (26; 26'; 26'a à b) et la deuxième branche parallèle (34; 34'; 34'a à b) sont construites de manière électriquement symétriques.

4. Circuit électronique de puissance selon l'une des revendications précédentes, dans lequel la première borne (14; 14a à d) de la première porte électrique (12; 12a à b) est connectée, par l'intermédiaire d'une première bobine (L₁ₐ; L₃ₐ), au premier noeud (28) de la première branche parallèle (26; 26'; 26'a à b) et, par l'intermédiaire d'une deuxième bobine (L_{1b}; L_{3b}), au premier noeud (36) de la deuxième branche parallèle (34; 34'; 34'a à b), et dans lequel la deuxième borne (16; 16a à d) de la première porte électrique (12; 12a à b) est connectée, par l'intermédiaire d'une troisième bobine (L₂ₐ; L₄ₐ), au deuxième noeud (32) de la première branche parallèle (26; 26'; 26'a à b) et, par l'intermédiaire d'une quatrième bobine (L_{2b}; L_{4b}), au deuxième noeud (32) de la deuxième branche parallèle (34; 34'; 34'a à b), la première et la troisième bobine (L₁ₐ, L₂ₐ; L₃ₐ, L₄ₐ) présentant un noyau de bobine commun et la deuxième et la quatrième bobine (L_{1b}, L_{2b}; L_{3b}, L_{4b}) présentant un noyau de bobine commun.

5. Circuit électronique de puissance selon l'une des revendications précédentes, dans lequel le premier circuit série et le deuxième circuit série présentent, chacun, un autre commutateur (S₂₁, S₂₃; S₄₁, S₄₃) entre le deuxième commutateur (S₁₂, S₁₄; S₃₂, S₃₄) et le deuxième noeud (32, 38) et un autre noeud (44, 46) entre l'autre commutateur (S₂₁, S₂₃; S₄₁, S₄₃) et le troisième commutateur (S₂₂, S₂₄; S₄₂, S₄₄), et dans lequel les deux autres noeuds (44, 46) sont connectés l'un à l'autre.

6. Circuit électronique de puissance selon l'une des revendications précédentes, dans lequel un premier condensateur (C₁; C₃) est connecté en série entre la bobine de transmission (L₁; L_{1P}, L_{1S}) et le premier noeud (28, 36) de la première branche parallèle (26; 26'; 26'a à b) ou de la deuxième branche parallèle (34; 34'; 34'a à b) et dans lequel un deuxième condensateur (C₂; C₄) est connecté en série entre la bobine de transmission (L₂; L_{2P}, L_{2S}) et le deuxième noeud (32, 38) de la première branche parallèle (26; 26' 26'a à b) ou de la deuxième branche parallèle (34; 34'; 34'a à b).

7. Circuit électronique de puissance selon l'une des revendications précédentes, présentant par ailleurs un moyen de commande (58) configuré pour commander un état des premiers commutateurs (S₁₁, S₁₃, S₃₁, S₃₃), des deuxièmes commutateurs (S₁₂, S₁₄; S₁, S₂, S₃₂, S₃₄) et des troisièmes commutateurs (S₂₄, S₂₄; S₄₂, S₄₄) de la première branche parallèle (26; 26'; 26'a à b) et de la deuxième branche parallèle (34; 34'; 34'a à b).

8. Transmetteur d'énergie électronique de puissance (50; 60; 70; 80; 90; 110; 120; 130), avec:
un premier circuit électronique de puissance (20a; 40; 62a; 62'a; 82a; 82'a) selon l'une des revendications 1 à 7;
un deuxième circuit électronique de puissance (20; 20b; 62b à d; 82b; 82'b) selon l'une des revendications 1 à 7;
dans lequel la première borne (22; 22a à d) de la deuxième porte magnétique (18) du premier circuit électronique de puissance (20a; 40; 62a; 62'a; 82a; 82'a) est connectée à la première borne (22; 22a à d) de la deuxième porte magnétique (18) du deuxième circuit électronique de puissance (20; 20b; 62b à d; 82b; 82'b); et
dans lequel la deuxième borne (24; 24a à d) de la deuxième porte magnétique (18) du premier circuit électronique de puissance (20a; 40; 62a; 62'a; 82a; 82'a) est connectée à la deuxième borne (24; 24a à d) de la deuxième porte magnétique (18) du deuxième circuit électronique de puissance (20; 20b; 62b à d; 82b; 82'b).

9. Transmetteur d'énergie électronique de puissance selon la revendication 8, dans lequel une tension (U₁, U₂; U₂₁, U₂₂, U₂₃) appliquée à la première porte électrique (12; 12a à b) du premier (20a; 40; 62a; 62'a; 82a; 82'a) ou du deuxième circuit électronique de puissance (20; 20b; 62b à d; 82b; 82'b) génère une tension (U₁, U₂; U₂₁, U₂₂, U₂₃) pouvant être prélevée à la première porte électrique (12; 12a à b) du deuxième (20; 82b) ou du premier circuit électronique de puissance (20a; 40; 62a; 62'a; 82a; 82'a).

10. Transmetteur d'énergie électronique de puissance selon l'une des revendications 8 ou 9, dans lequel le premier circuit électronique de puissance (20a; 40; 62a; 62'a; 82a, 82'a) et le deuxième circuit électronique de puissance (20; 20b; 62b à d; 82b 82'b) sont couplés de manière galvanique l'un à l'autre par une connexion électrique (66) et présentent un potentiel de référence commun.

11. Transmetteur d'énergie électronique de puissance selon l'une des revendications 8 à 10, avec au moins un troisième circuit électronique de puissance (62c à d) selon l'une des revendications 1 à 7;
dans lequel le premier circuit électronique de puissance présente au moins une autre porte magnétique avec une première borne (68a, 68b) et une deuxième borne (72a, 72b);
dans lequel les premiers noeuds (28, 36) des branches parallèles (26; 26'; 26'a à b; 34; 34'; 34'a à b) du premier circuit électronique de puissance (20a; 40; 62a; 62'a; 82a; 82'a) sont couplés de manière magnétique à la première borne (68a, 68b) de l'autre porte magnétique;
dans lequel les deuxièmes noeuds (32, 38) des branches parallèles (26; 26'; 26'a à b; 34; 34'; 34'a à b) du premier circuit électronique de puissance (20a; 40; 62a; 82a; 82'a) sont couplés de manière magnétique à la deuxième borne (72a, 72b) de l'autre porte magnétique;
dans lequel la première borne (68a, 68b) de l'autre porte magnétique est connectée à la première borne (22; 22a à d) de la deuxième porte magnétique (18) du troisième circuit électronique de puissance (62c à d); et
dans lequel la deuxième borne (72a, 72b) de l'autre porte magnétique est connectée à la deuxième borne (24; 24a à d) de la deuxième porte magnétique (18) du troisième circuit électronique de puissance (62c à d).

12. Transmetteur d'énergie électronique de puissance selon l'une des revendications 8 à 11, présentant par ailleurs un moyen de commande de transmission d'énergie (58') qui est conçu pour commander un état des premiers commutateurs (S₁₁, S₁₃, S₃₁, S₃₃), des deuxièmes commutateurs (S₁₂, S₁₄; S₁, S₂, S₃₂, S₃₄) et des troisièmes commutateurs (S₂₄, S₂₄; S₄₂, S₄₄) de la première branche parallèle (26; 26'; 26'a à b) et de la deuxième branche parallèle (34; 34'; 34'a à b) du premier (20a; 40; 62a; 62'a; 82a; 82'a) et du deuxième circuit électronique de puissance (20; 20b; 62b à d; 82b; 82'b), dans lequel le moyen de commande de transmission (58') est conçu
pour commander l'état du premier (S₁₁) et du troisième commutateur (S₂₂) de la première branche parallèle (26; 26'; 26'a à b) du premier circuit électronique de puissance (20a; 40; 62a; 62a; 82a; 82'a) et l'état du deuxième commutateur (S₁₄, S₂₃, S₂) de la deuxième branche parallèle (34; 34'; 34'a à b) du premier circuit électronique de puissance (20a; 40; 62a; 62'a; 82a; 82'a) à un premier moment (t₁', t₁);
pour commander l'état du deuxième commutateur (S₁₂, S₂₁, S₁) de la première branche parallèle (26; 26'; 26'a à b) du premier circuit électronique de puissance (20a; 40; 62a; 62a; 82a; 82'a) et l'état du premier (S₁₃) et du troisième (S₂₄) commutateur de la deuxième branche parallèle (34; 34'; 34'a à b) du premier circuit électronique de puissance (20a; 40; 62a; 62a; 82a; 82'a) à un deuxième moment (t₂);
pour commander l'état du premier (S₃₁) et du troisième (S₄₂) commutateur de la première branche parallèle (26; 26'; 26'a à b) du deuxième circuit électronique de puissance (20; 20b; 62b à d; 82b; 82'b) et l'état du deuxième commutateur (S₃₄, S₄₃, S₄) de la deuxième branche parallèle (34; 34'; 34'a à b) du deuxième circuit électronique de puissance (20; 20b; 62b à d; 82b; 82'b) à un troisième moment (t₃);
pour commander l'état du deuxième commutateur (S₃₂, S₄₁, S₃) de la première branche parallèle (26; 26'; 26'a à b) du deuxième circuit électronique de puissance (20; 20b; 62b à d; 82b; 82'b) et l'état du premier (S₃₃) et du troisième (S₄₄) commutateur de la deuxième branche parallèle (34; 34'; 34'a à b) du deuxième circuit électronique de puissance (20; 20b; 62b à d; 82b; 82'b) à un quatrième moment (t₄);
dans lequel un intervalle de temps (ϕ) entre le premier moment (t₁) et le troisième moment (t₃) ou entre le deuxième moment (t₂) et le quatrième moment (t₄) est une mesure d'une part de l'énergie électrique qui est transmise de la première porte électrique (12; 12a à b) du premier circuit électronique de puissance (20a; 40; 62a; 62'a; 82a; 82'a) à la première porte électrique (12; 12a à b) du deuxième circuit électronique de puissance (20; 20b; 62b à d; 82b; 82'b) lorsqu'une tension électrique (U₁) est appliquée à la première porte électrique (12; 12a à b) du premier circuit électronique de puissance (20a; 40; 62a; 62'a; 82a; 82'a).

13. Système de transmission d'énergie électronique de puissance (100), avec:
au moins deux transmetteurs d'énergie électronique de puissance (60a à c) selon l'une des revendications 8 à 12, avec, chacun, au moins un premier circuit électronique de puissance (62a, 62c, 62e) et au moins un deuxième circuit électronique de puissance (62b, 62d, 62f);
dans lequel les deuxièmes bornes (16; 16a à d) de la première porte électrique (12; 12a à b) des au moins deux premiers circuits électroniques de puissance (62a, 62c, 62e) sont connectées l'une à l'autre; et
dans lequel les premières bornes (14; 14a à d) de la première porte électrique (12; 12a à b) des au moins deux deuxièmes circuits électroniques de puissance (62b, 62d, 62f) sont connectées l'une à l'autre; et
dans lequel les deuxièmes bornes (16; 16a à d) de la première porte électrique (12; 12a à b) des au moins deux deuxièmes circuits électroniques de puissance (62b, 62d, 62f) sont connectées l'une à l'autre.

14. Système de transmission d'énergie électronique de puissance selon la revendication 13, dans lequel les premières ou les deuxièmes bornes (14; 14a à d) des premières portes électriques (12; 12a à b) des au moins deux premiers circuits électroniques de puissance (62a, 62c, 62e) sont connectées l'une à l'autre.

15. Système de transmission d'énergie électronique de puissance selon la revendication 13 ou 14, comportant par ailleurs un troisième transmetteur d'énergie électronique de puissance (62a à c), dans lequel la première borne des premières portes électriques (12; 12a à b) de chaque premier circuit électronique de puissance (62a, 62b, 62c) est connectée à chaque fois une borne de tension (L1, L2, L3) d'une source de tension triphasée, dans lequel les deuxièmes bornes des premières portes électriques (12; 12a à b) sont connectées l'une à l'autre.
